(19) Europäisches Patentamt
European Patent Office
Office européen des brevets

(11) EP 2 159 641 A1

(12) **EUROPEAN PATENT APPLICATION**
published in accordance with Art. 153(4) EPC

(43) Date of publication:
**03.03.2010 Bulletin 2010/09**

(21) Application number: **08777219.0**

(22) Date of filing: **13.06.2008**

(51) Int Cl.:
***G03F 7/40*** $^{(2006.01)}$ ***G03F 7/26*** $^{(2006.01)}$
***H01L 21/027*** $^{(2006.01)}$

(86) International application number:
**PCT/JP2008/060908**

(87) International publication number:
**WO 2008/153155 (18.12.2008 Gazette 2008/51)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **15.06.2007 JP 2007158839**

(71) Applicant: **Fujifilm Corporation**
**Tokyo 106-0031 (JP)**

(72) Inventor: **YOSHIDOME, Masahiro**
**Haibara-gun, Shizuoka (JP)**

(74) Representative: **HOFFMANN EITLE**
**Patent- und Rechtsanwälte**
**Arabellastrasse 4**
**81925 München (DE)**

# (54) SURFACE TREATMENT AGENT FOR FORMING PATTERN AND PATTERN FORMING METHOD USING THE TREATMENT AGENT

(57) There are provided a surface-treating agent containing a specific compound having an amino group and an aromatic ring as a surface-treating agent for a freezing process for chemically treating a first resist pattern used in a freezing process of chemically treating and thereby qualitatively changing the first resist pattern so as not to dissolve in a second resist solution in order to form a second resist film on the first resist pattern and form a second resist pattern after the first resist pattern is formed on a first resist film, wherein the surface-treating agent performs a chemical treatment on the first resist pattern to satisfy the requirements that the first resist pattern does not dissolve in the second resist solution, the dimension of the first resist pattern is not changed, and the first resist pattern and the second resist pattern have the same dry etching resistance; and a pattern forming method using the surface-treating agent.

FIG. 1 (a)

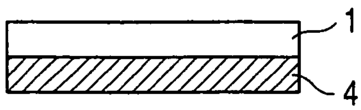


EP 2 159 641 A1

FIG. 1 (b)

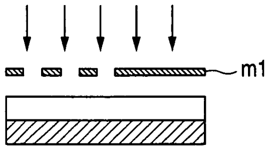


FIG. 1 (c)

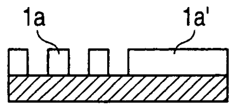


FIG. 1 (d)

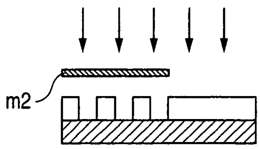


FIG. 1 (e)

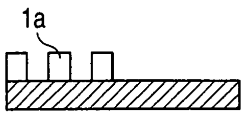


FIG. 1 ( f )

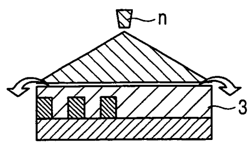


FIG. 1 (g)

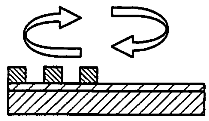

FIG. 1 (h)

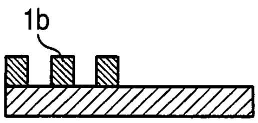


FIG. 1 ( i )

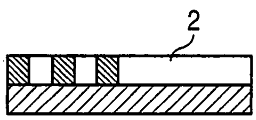




(Cont. next page)

FIG. 1 ( j )

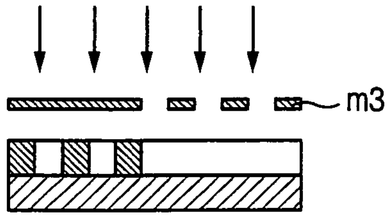


FIG. 1 (k)

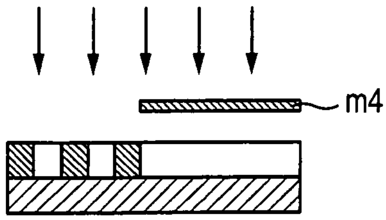


FIG. 1 ( l )

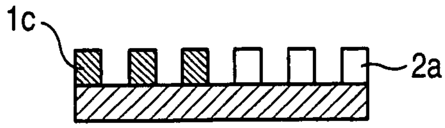

## Description

TECHNICAL FIELD

The present invention relates to a surface-treating agent for resist pattern formation used in the process of producing a semiconductor such as IC, in the production of a circuit board for liquid crystal, thermal head and the like, and in the lithography step of other photo-fabrication processes, and a pattern forming method using the same.

More specifically, the present invention relates to a surface-treating agent for resist pattern formation, that is suitably usable in performing exposure by an immersion-type projection exposure apparatus using a light source capable of emitting far ultraviolet light at a wavelength of 200 nm or less, and a pattern forming method using the same.

BACKGROUND ART

Since the advent of a resist for KrF excimer laser (248 nm), an image forming method called chemical amplification is used as an image forming method for a resist so as to compensate for sensitivity reduction caused by light absorption. For example, the image forming method by positive tone chemical amplification is an image forming method of decomposing an acid generator in the exposed area upon exposure to produce an acid, converting an alkali-insoluble group into an alkali-soluble group by using the generated acid as a reaction catalyst in the baking after exposure (PEB: Post Exposure Bake), and removing the exposed area by alkali development.

Along with miniaturization of a semiconductor device, the trend is moving into a shorter wavelength of the exposure light source and a higher numerical aperture (higher NA) of the projection lens, and an exposure machine using an ArF excimer laser with a wavelength of 193 nm as a light source has been so far developed. The achievement degree of miniaturization of a semiconductor device can be expressed by a resolution and as commonly well known, the resolution can be represented by the following formula:

$$(\text{Resolution}) = k_1 \bullet (\lambda/\text{NA})$$

wherein $\lambda$ is the wavelength of the exposure light source, NA is the numerical aperture of the projection lens, and $k_1$ is a coefficient related to the process.

A so-called immersion method of filling a high refractive-index liquid (hereinafter sometimes referred to as an "immersion liquid") between the projection lens and the sample has been conventionally advocated as a technique for raising the resolution.

As for the "effect of immersion", assuming that $NA_0=\sin\theta$, the above-described resolution and depth of focus in the immersion can be represented by the following formula:

$$(\text{Resolution}) = k_1 \bullet (\lambda_0/n)/NA_0$$

wherein $\lambda_0$ is the wavelength of exposure light in air, n is the refractive index of the immersion liquid based on air, and $\theta$ is the convergence half-angle of the beam.

That is, the effect of immersion is equal to use of an exposure wavelength of 1/n. In other words, in the case of a projection optical system with the same NA, the depth of focus can be made n times larger by the immersion. Also, a pattern forming method using a special process has been proposed as a technique for more raising the resolution, and this corresponds to reducing $k_1$ in the above-described formula of resolution. One of such processes is a freezing process (see, Patent Document 1 and Non-Patent Document 1).

The freezing process indicates a process where, as described, for example, in Patent Document 1, in the steps of forming a first resist pattern on a first resist film, forming a second resist film on the first resist pattern, and forming a second resist pattern, the property of the first resist pattern is changed by a chemical or physical treatment so that the first resist pattern cannot dissolve in a second resist solution or mix with the second resist film when forming the second resist film. By using this technique, a desired resist pattern can be formed in two parts, and twice the resolution can be realized as compared with an ordinary exposure process. Here, the terms "first" and "second" are the order of steps of forming the first layer and the second as shown in Fig. 1.

Patent Document 1 is a known example of the freezing process, and in this example, after forming a first resist pattern, a vacuum ultraviolet ray is irradiated on the first resist pattern, whereby the property of the first resist pattern is changed so that the first resist pattern cannot dissolve in a second resist solution. In this known example, it is clearly indicated that the method above causes the dimension of the first resist pattern to change between before and after

irradiation with a vacuum ultraviolet ray, and this problem is dealt with by compensating for the dimension of the first resist pattern in consideration of the dimensional fluctuation due to irradiation with a vacuum ultraviolet ray. However, the amount of dimensional fluctuation is estimated to differ according to the dimension of the resist pattern, and it is practically impossible to design a mask whose dimension is compensated for based on an actual semiconductor device pattern where patterns of various dimensions or shapes are present. For this reason, as the fundamental characteristics required of the freezing process, it is necessary to satisfy both the properties that (i) the first resist pattern does not dissolve in the second resist solution and that (ii) the dimension of the first resist pattern is not changed between before and after the qualitative change of the first resist pattern. Furthermore, in the production process of a semiconductor circuit, a resist pattern itself usually works as a mask and is used to transfer a pattern by etching onto a substrate. At this time, all resist patterns are required to have the same etching resistance in one arbitrary pattern. Accordingly, in the freezing process, it is further required that (iii) the first resist pattern and the second resist pattern have the same dry etching resistance. However, a material and a process, satisfying all of these three properties, have not been found yet.

Patent Document 1: JP-A-2005-197349 (the term "JP-A" as used herein refers to an "unexamined published Japanese patent application")
Non-Patent Document 1: J. Vac. Sci. Technol. B 4, 426 (1986)

DISCLOSURE OF THE INVENTION

PROBLEMS THAT THE INVENTION IS TO SOLVE

The present invention has been made under these circumstances and an object of the present invention is to provide a surface-treating agent for a freezing process of chemically treating and thereby qualitatively changing the first resist pattern so as not to dissolve in a second resist solution, in order to form a second resist film on a first resist pattern and form a second resist pattern after the first resist pattern is formed on a first resist film, wherein the surface-treating agent performs a chemical treatment on the first resist pattern to satisfy all of the requirements that (i) the first resist pattern does not dissolve in the second resist solution, (ii) the dimension of the first resist pattern is not changed, and (iii) the first resist pattern and the second resist pattern have the same dry etching resistance; and a pattern forming method using the same.

MEANS FOR SOLVING THE PROBLEMS

The above-described object can be attained by the following constructions.

[1] A surface-treating agent for resist pattern formation, which is used in a step before a second resist film is formed on a first resist pattern and a second resist pattern is formed and after the first resist pattern is formed on a first resist film, the surface-treating agent comprising a compound having at least one -O-C-N- bond.
[2] The surface-treating agent for resist pattern formation as described in [1] above,
wherein the compound having at least one -O-C-N- bond is a compound represented by the following formula (1):

Formula (1):

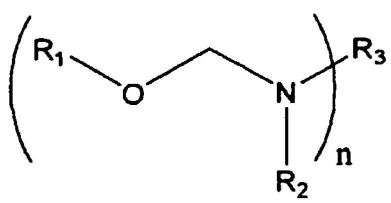

wherein $R_1$ represents a hydrogen atom or a monovalent organic group;
$R_2$ represents a hydrogen atom or a monovalent organic group;
$R_3$ represents a hydrogen atom, a single bond or an n-valent organic group, provided that $R_2$ and $R_3$ may combine with each other to form a ring; and

n represents an integer of 1 to 8, provided that when $R_3$ is a hydrogen atom, n is 1 and when $R_3$ is a single bond, n is 2.
[3] The surface-treating agent for resist pattern formation as described in [2] above,
wherein the compound represented by formula (1) is a compound where n represents an integer of 2 to 8.
[4] The surface-treating agent for resist pattern formation as described in any one of [1] to [3] above, which comprises:

a saturated hydrocarbon compound having a carbon number of 10 or more, a hydrocarbon compound containing at least one hydroxy group and having a carbon number of 6 or more, or an organic compound containing at least one fluorine atom and having a carbon number of 6 or more as a solvent.

[5] A method for forming a resist pattern, comprising:

a step of forming a first resist pattern by using a first resist composition;
a step of treating the resist pattern with the treating agent described in any one of [1] to [4] above; and
a step of forming a second resist pattern on the first resist pattern by using a second resist composition.

[6] The surface-treating agent for resist pattern formation as described in any one of [1] to [4] above,
wherein the compound represented by formula (1) is a compound having a molecular weight of 100 to 1,000.
[7] The surface-treating agent for resist pattern formation as described in any one of [2] to [4] and [6] above,
wherein the compound represented by formula (1) is a compound having an aromatic ring in the structure(s) of $R_2$ and/or $R_3$.
[8] The surface-treating agent for resist pattern formation as described in [7] above,
wherein the compound represented by formula (1) is a compound where the carbon number of $R_3$ is from 0 to 30 excluding the number of carbon atoms forming a ring.
[9] The surface-treating agent for resist pattern formation as described in [6] above,

wherein the compound represented by formula (1) is a compound represented by formula (2) or (3):

Formula (2):

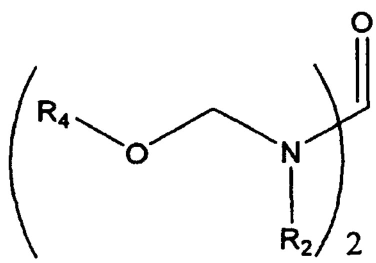

wherein $R_2$ represents a hydrogen atom or a monovalent organic group, provided that two $R_2$'s may be the same or different; and
$R_4$ represents a hydrogen atom or a monovalent organic group, provided that two $R_4$'s may be the same or different:

Formula (3):

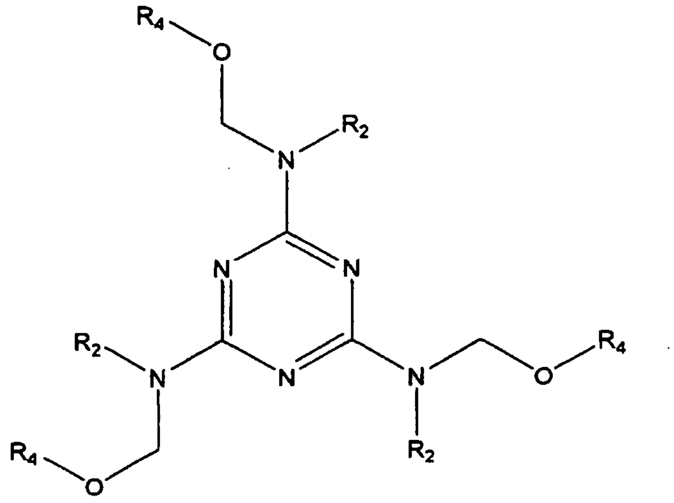

wherein $R_2$ represents a hydrogen atom or a monovalent organic group, provided that three $R_2$'s may be the same or different; and

$R_4$ represents a hydrogen atom or a monovalent organic group, provided that three $R_4$'s may be the same or different.

ADVANTAGE OF THE INVENTION

A surface-treating agent for resist pattern formation, and the like, ensuring that a first resist pattern does not compatibilize with a second resist solution, a first resist pattern and a second resist pattern have the same dry etching resistance, and the dimension of a first resist pattern is not changed between before and after a freezing treatment, can be provided.

BRIEF DESCRIPTION OF THE DRAWING

Fig. 1 is a schematic view of the pattern forming method using a freezing process.

DESCRIPTION OF REFERENCE NUMERALS AND SIGNS

1: Resist 1
1a: Pattern formed using resist 1
1b: Resist pattern 1a after treatment with a treating agent
1c: Resist pattern 1b after second exposure and development
2: Resist 2
2a: Pattern formed using resist 2
3: Treating agent
4: Semiconductor substrate (including an antireflection film layer)
m: Exposure mask
ml to m4 represent masks used in respective steps.
n: Ejection nozzle

BEST MODE FOR CARRYING OUT THE INVENTION

The treating agent of the present invention is described below.

Incidentally, in the present invention, when a group (atomic group) is denoted without specifying whether substituted or unsubstituted, the group includes both a group having no substituent and a group having a substituent. For example, an "alkyl group" includes not only an alkyl group having no substituent (unsubstituted alkyl group) but also an alkyl group having a substituent (substituted alkyl group).

<Surface-Treating Agent for Resist Pattern Formation>

The surface-treating agent for resist pattern formation of the present invention is a surface-treating agent used in a step before a second resist film is formed on a first resist pattern and a second resist pattern is formed and after the first resist pattern is formed on a first resist film, and comprises a compound having at least one -O-C-N- bond.

The molecular weight of the compound having at least one -O-C-N- bond is not particularly limited but is preferably from 100 to 1,000, more preferably from 100 to 700. That is, from the standpoint of suppressing dimension thickening of a first resist pattern, the molecular weight is preferably 1,000 or less, more preferably 700 or less.

In the surface-treating agent for resist pattern formation of the present invention, the number of -O-C-N- bonds contained in one molecule of the compound is preferably from 2 to 8, more preferably from 2 to 6, still more preferably from 2 to 4.

By virtue of using the compound having an -O-C-N- bond, the same or different resins can be crosslinked therebetween by the treating agent, as a result, dissolution of the first resist pattern in the second resist solution can be suppressed.

Also, the number of -O-C-N- bonds is preferably set to the above-described range, because the number of unreacted -O-C-N- bonds can be reduced.

The compound having an -O-C-N- bond may contain an arbitrary atom and an arbitrary group together with the -O-C-N- bond, and examples thereof include the following monovalent organic groups and their corresponding polyvalent groups.

The compound having an -O-C-N- bond is preferably a compound having an N-methylol group, and hydrogen of the N-methylol group may be replaced by a monovalent organic group.

Examples of the monovalent organic group include an alkyl group, a cycloalkyl group, an aryl group, an aralkyl group, an alkenyl group, an alkoxyl group and an alkoxycarbonylamino group.

Here, the alkyl group may have a substituent and may contain an oxygen atom, a sulfur atom or a nitrogen atom in the alkyl chain. Specific examples of the alkyl group include a linear alkyl group such as methyl group, ethyl group, n-propyl group, n-butyl group, n-pentyl group, n-hexyl group, n-octyl group, n-dodecyl group, n-tetradecyl group and n-octadecyl group, and a branched alkyl group such as isopropyl group, isobutyl group, tert-butyl group, neopentyl group and 2-ethylhexyl group.

The cycloalkyl group may have a substituent, may be polycyclic and may contain an oxygen atom in the ring. Specific examples of the cycloalkyl group include a cyclopropyl group, a cyclopentyl group, a cyclohexyl group, a norbornyl group and an adamantyl group.

The aryl group may have a substituent, and examples of the aryl group include a phenyl group and a naphthyl group.

The aralkyl group may have a substituent, and examples of the aralkyl group include a benzyl group, a phenethyl group, a naphthylmethyl group and a naphthylethyl group.

Examples of the alkenyl group include a group having a double bond at an arbitrary position of the above-described alkyl or cycloalkyl group.

Examples of the alkoxyl group and the alkoxyl group in the alkoxycarbonylamino group include a methoxy group, an ethoxy group, a propoxy group, an n-butoxy group, a pentyloxy group, a hexyloxy group and a heptyloxy group.

Examples of the substituent which each of these organic groups may have include a halogen atom, a hydroxyl group, a nitro group, a cyano group, a carboxyl group, a carbonyl group, a cycloalkyl group, an aryl group, an alkoxyl group, an acyl group, an acyloxy group, an alkoxycarbonyl group and an aminoacyl group. As for the cyclic structure in the aryl group and cycloalkyl group, examples of the further substituent include an alkyl group. As for the aminoacyl group, examples of the further substituent include an alkyl group having a carbon number of 1 or 2.

In the present invention, the compound having at least one -O-C-N- bond is preferably a compound represented by the following formula (1):

Formula (1):

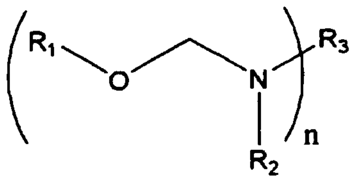

In formula (1), $R_1$ represents a hydrogen atom or a monovalent organic group,

$R_2$ represents a hydrogen atom or a monovalent organic group,

$R_3$ represents a hydrogen atom, a single bond or an n-valent organic group, provided that $R_2$ and $R_3$ may combine with each other to form a ring, and

n represents an integer of 1 to 8, provided that when $R_3$ is a hydrogen atom, n is 1 and when $R_3$ is a single bond, n is 2.

The molecular weight of the compound represented by formula (1) is not particularly limited but is preferably from 100 to 1,000, more preferably from 100 to 700.

That is, from the standpoint of suppressing dimension thickening of a first resist pattern, the molecular weight is preferably 1,000 or less, more preferably 700 or less.

In formula (1), n represents an integer of 1 to 8 and is preferably an integer of 2 to 4, more preferably 2 or 3.

Examples of the monovalent organic groups ($R_1$) and ($R_2$) in $R_1$ and $R_2$ include those described above.

$R_1$ is preferably a linear or branched alkyl group having a carbon number of 1 to 10, more preferably a linear or branched alkyl group having a carbon number of 1 to 4, still more preferably a methyl group or a hydrogen atom.

$R_2$ is preferably a linear or branched alkyl group having a carbon number of 1 to 10, which may have a substituent, more preferably a linear or branched alkyl group having a carbon number of 1 to 4, which may have a substituent, still more preferably a hydrogen atom, a methyl group, a methylol group or an alkylmethylol group.

The n-valent organic group ($R_3$) is not particularly limited, but examples thereof include an n-valent organic group after removing arbitrary n-1 hydrogen atoms from the above-described monovalent organic group, particularly, a group corresponding to R3 in the later-described specific examples of the compound having an -O-C-N- bond, and an n-valent group corresponding to a group formed by the combination of such groups.

The n-valent organic group ($R_3$) is preferably an organic group where the carbon number of $R_3$ is from 0 to 30, more preferably from 4 to 20, excluding the number of carbon atoms forming a ring.

Furthermore, an organic group having a methylol group, an alkylmethylol group or an aromatic ring in the structure of $R_3$ is also preferred. Examples of the aromatic ring include a monocyclic aromatic benzene derivative, a compound where a plurality of aromatic rings are linked (e.g., naphthalene, anthracene, tetracene), and a non-benzene aromatic derivative, and examples of the non-benzene aromatic derivative include a pyrrole residue, a furan residue, a thiophene residue, an indole residue, a benzofuran residue and a benzothiophene residue.

In the case where $R_2$ and/or $R_3$ have a methylol group and/or an alkylmethylol group in their structure or where n represents an integer of 2 to 8, the same or different resins may be crosslinked therebetween by the treating agent, as a result, dissolution of the first resist pattern in the second resist solution can be suppressed.

Also, the number of methylol groups and/or alkylmethylol groups is 4 or less, whereby the number of unreacted methylol groups and/or alkylmethylol groups can be reduced, and when the number of methylol groups and/or alkylmethylol groups is 3 or less, the number of unreacted methylol groups and/or alkylmethylol groups can be more reduced.

$R_2$ and $R_3$ may combine with each other to form a ring.

One other preferred embodiment in formula (1) is a compound represented by formula (2) or (3). The compound represented by formula (2) or (3) is excellent in the storage stability.

Formula (2):

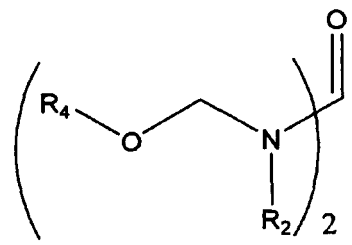

In formula (2), $R_2$ represents a hydrogen atom or a monovalent organic group, provided that two $R_2$'s may be the same or different, and
$R_4$ represents a hydrogen atom or a monovalent organic group, provided that two $R_4$'s may be the same or different;

Formula (3):

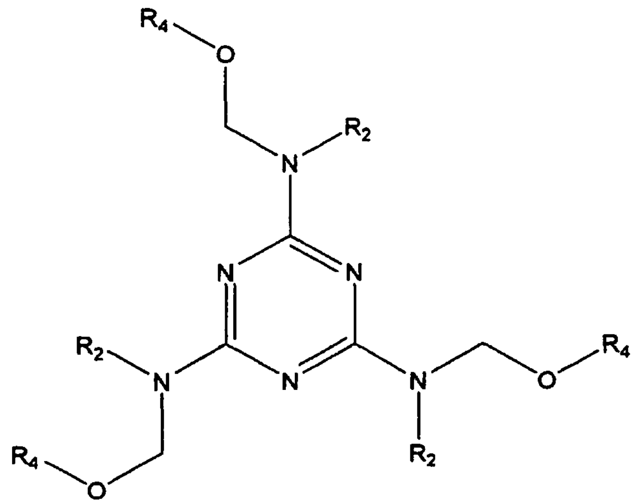

In formula (3), $R_2$ represents a hydrogen atom or a monovalent organic group, provided that three $R_2$'s may be the same or different, and
$R_4$ represents a hydrogen atom or a monovalent organic group, provided that three $R_4$'s may be the same or different. $R_2$ in formula (3) has the same meaning as $R_2$ in formula (1) and is preferably a hydrogen atom, an alkyl group or an alkyl fluoride group.

The monovalent organic group ($R_4$) has the same meaning as $R_1$ and $R_2$ in formula (1).

The monovalent organic group ($R_4$) is preferably an organic group where the carbon number of $R_4$ is from 0 to 15, more preferably from 2 to 10, excluding the number of carbon atoms forming a ring. An organic group having a methylol group, an alkylmethylol group, an N-methylol group, an alkyl N-methylol group and/or or an aromatic ring in the structure of $R_4$ is also preferred. Furthermore, an organic group where in $R_4$, a part or all of hydrogen atoms of the hydrocarbon group are replaced by a halogen atom is also preferred. Examples of the aromatic ring include a monocyclic aromatic benzene derivative, a compound where a plurality of aromatic rings are linked (e.g., naphthalene, anthracene, tetracene) and a non-benzene aromatic derivative, and examples of the non-benzene aromatic derivative include a pyrrole residue, a furan residue, a thiophene residue, an indole residue, a benzofuran residue and a benzothiophene residue.

$R_4$ is more preferably a hydrogen atom or a methyl group.

The amount of each of the compound having at least one -O-C-N- bond and the compounds represented by formulae (1) to (3) contained in the surface-treating agent for resist pattern formation of the present invention is preferably from 0.1 to 100 mass%, more preferably from 2 to 95 mass%, still more preferably from 5 to 90 mass%, based on the entire amount of the treating agent.

Compounds (A-01) to (A-59), Compounds (B-01) to (B-27) and Compounds (C-01) to (C-25) are set forth below

as examples of the compound having at least one -O-C-N- bond and the compounds represented by formulae (1) to (3), but the present invention is not limited thereto.

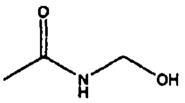

(A-01)

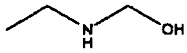

(A-02)

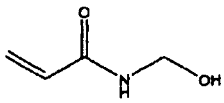

(A-03)

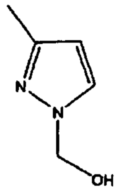

(A-04)

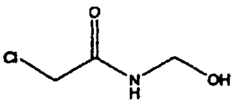

(A-05)

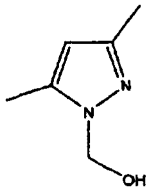

(A-06)

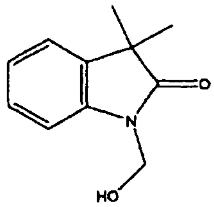

(A-07)

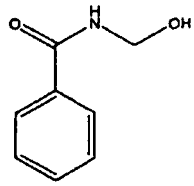

(A-08)

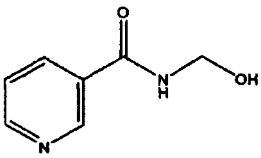

(A-09)

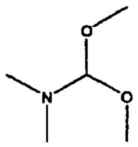

(A-10)

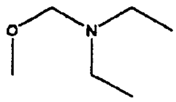

(A-11)

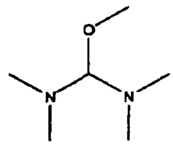

(A-12)

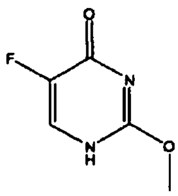

(A-13)

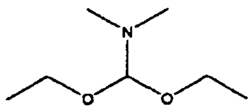

(A-14)

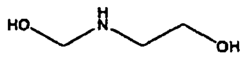

(A-15)

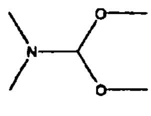

(A-16)

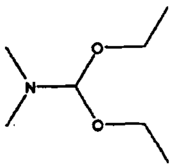

(A-17)

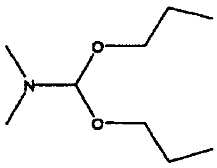

(A-18)

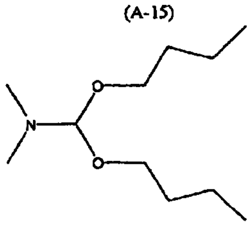

(A-19)

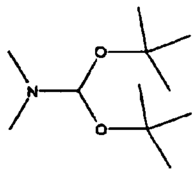

(A-20)

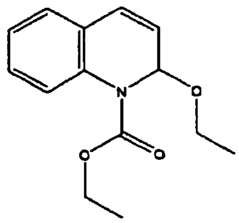
(A-21)

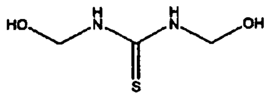
(A-22)

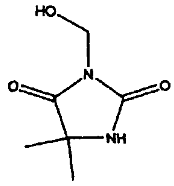
(A-23)

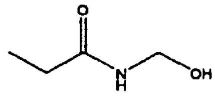
(A-24)

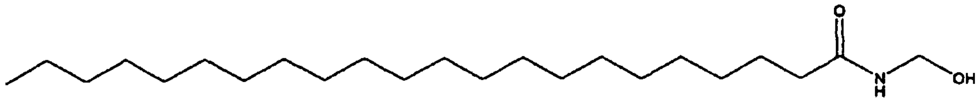
(A-25)

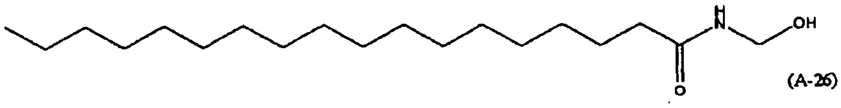
(A-26)

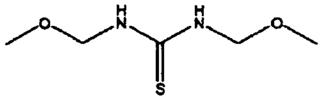
(A-27)

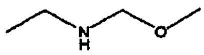
(A-28)

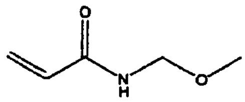
(A-29)

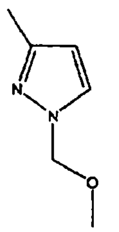
(A-30)

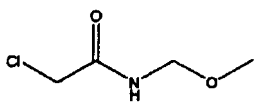
(A-31)

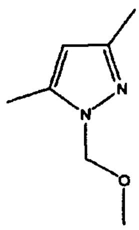
(A-32)

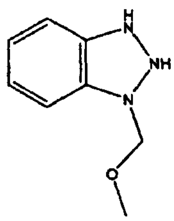
(A-33)

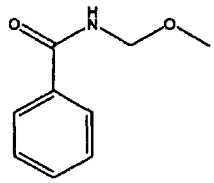
(A-34)

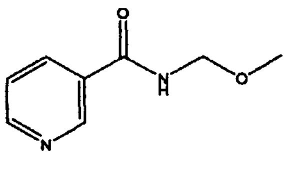
(A-35)

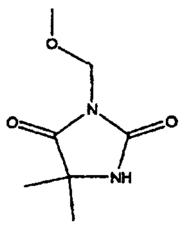
(A-36)

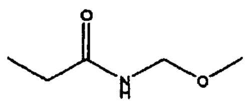
(A-37)

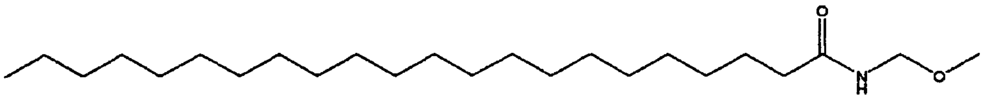

(A-38)

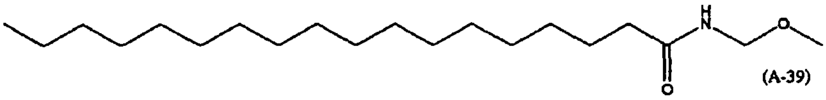

(A-39)

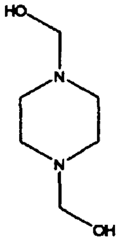

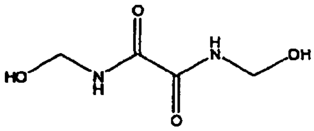

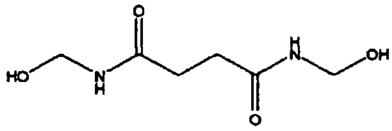

(A-40) (A-41) (A-42)

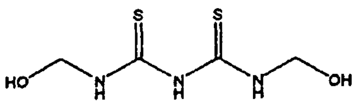

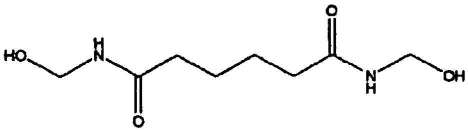

(A-43) (A-44)

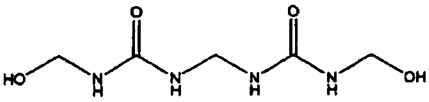

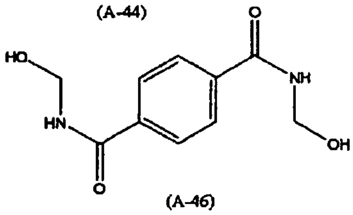

(A-45) (A-46)

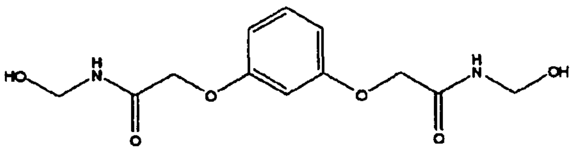

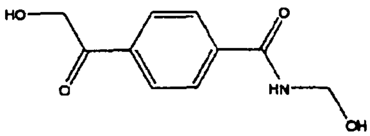

(A-47) (A-48)

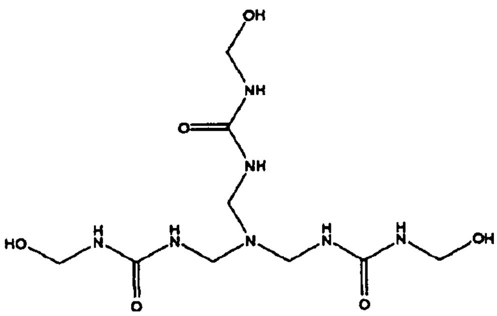

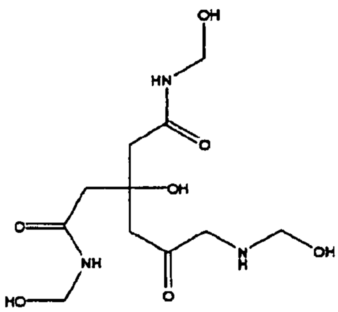

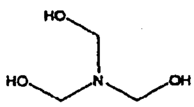

(A-49) (A-50) (A-51)

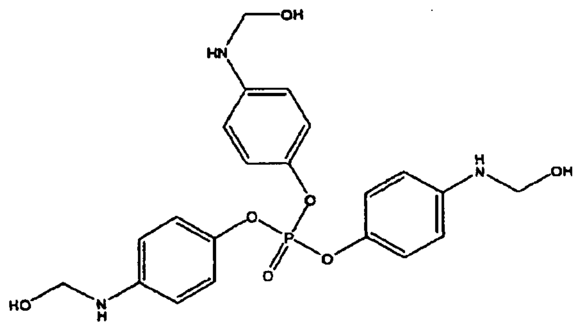

(A-52)

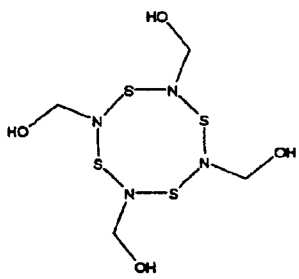

(A-53)

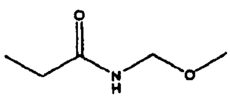

(A-54)

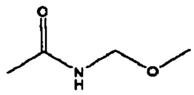

(A-55)

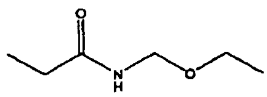

(A-56)

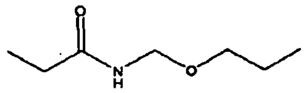

(A-57)

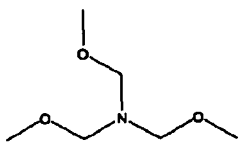

(A-58)

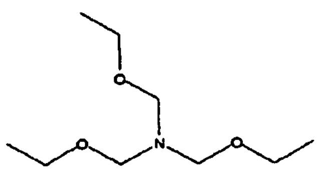

(A-59)

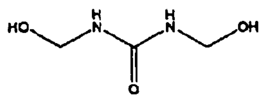

(B-01)

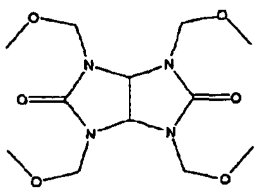

(B-02)

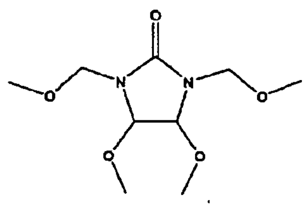

(B-03)

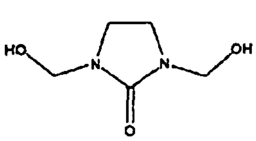

(B-04)

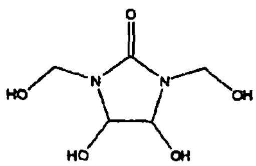

(B-05)

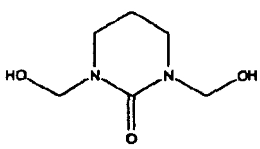

(B-06)

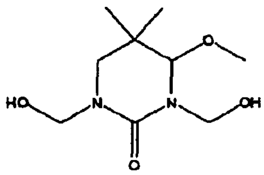

(B-07)

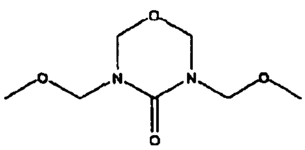

(B-08)

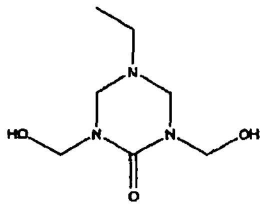

(B-09)

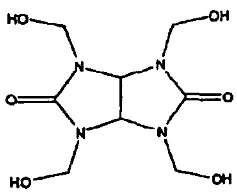

(B-10)

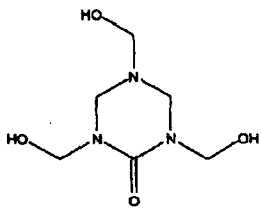

(B-11)

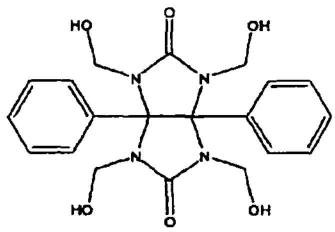

(B-12)

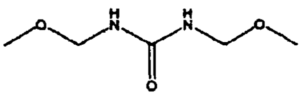

(B-13)

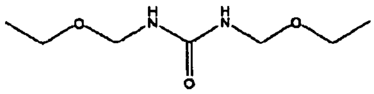

(B-14)

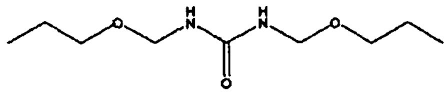

(B-15)

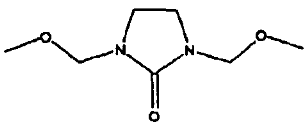

(B-16)

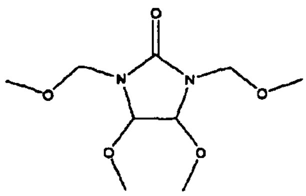

(B-17)

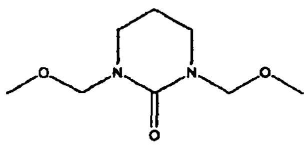

(B-18)

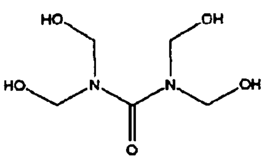

(B-19)

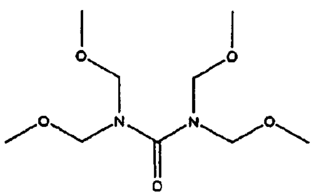

(B-20)

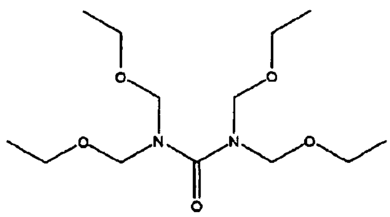

(B-21)

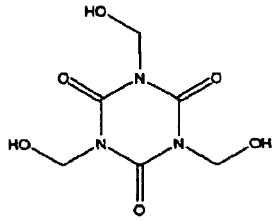

(B-22)

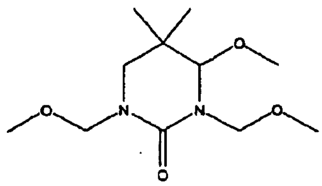

(B-23)

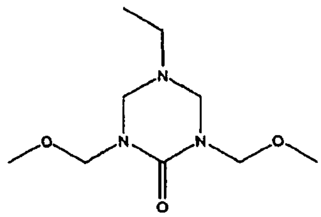

(B-24)

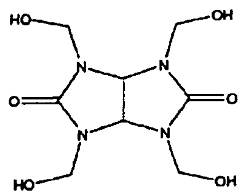

(B-25)

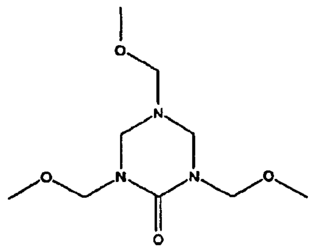

(B-26)

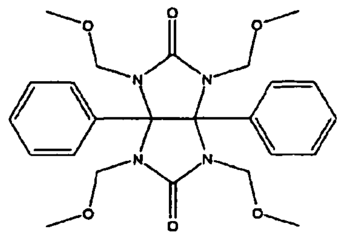

(B-27)

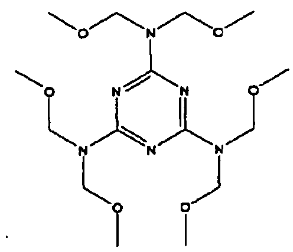

(C-01)

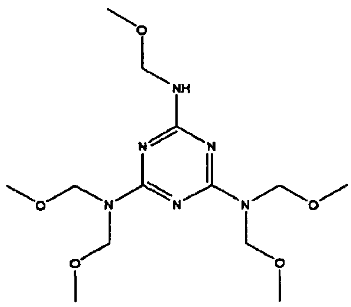

(C-02)

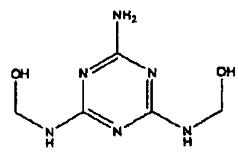

(C-03)

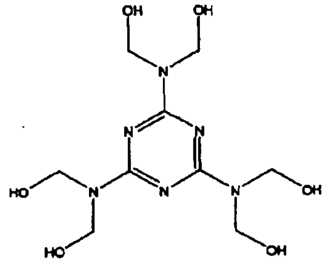

(C-04)

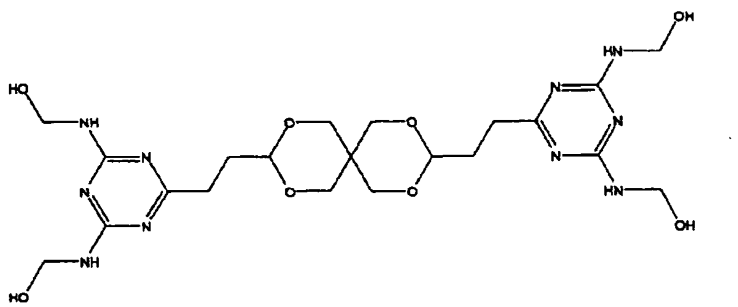

(C-05)

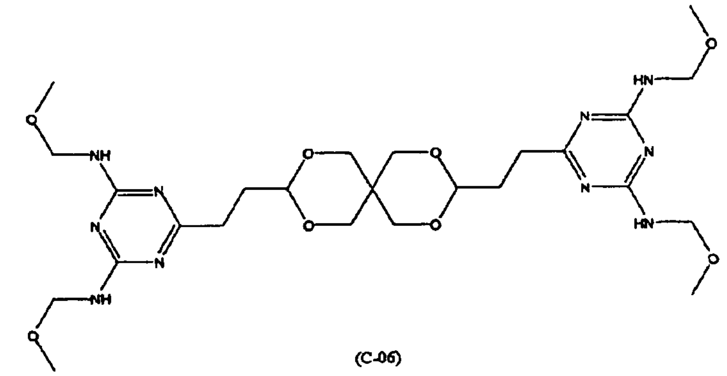

(C-06)

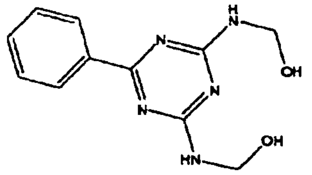

(C-07)

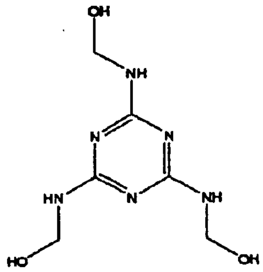

(C-08)

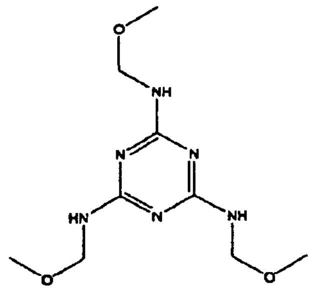

(C-09)

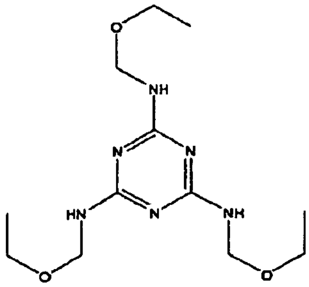

(C-10)

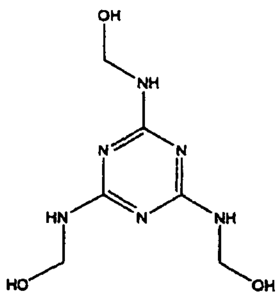

(C-11)

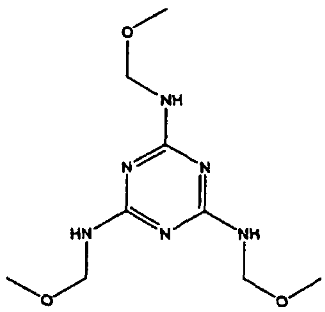

(C-12)

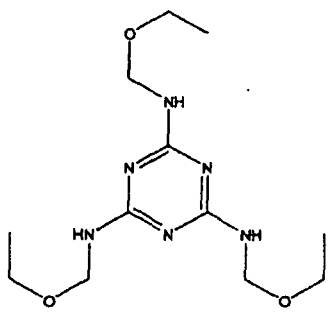

(C-13)

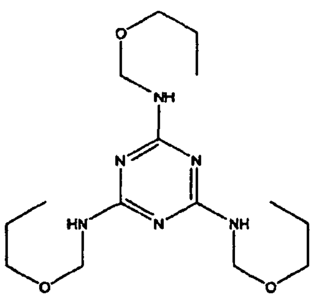

(C-14)

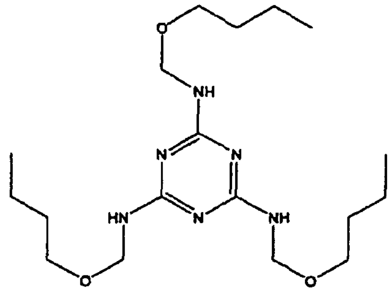

(C-15)

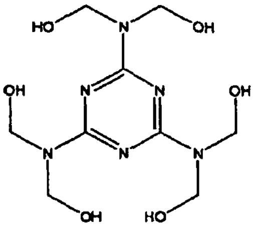

(C-16)

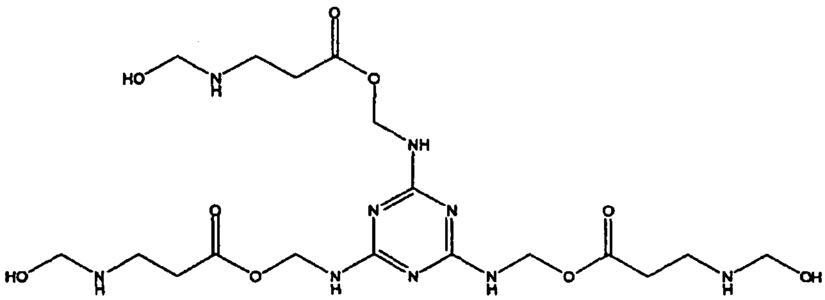

(C-17)

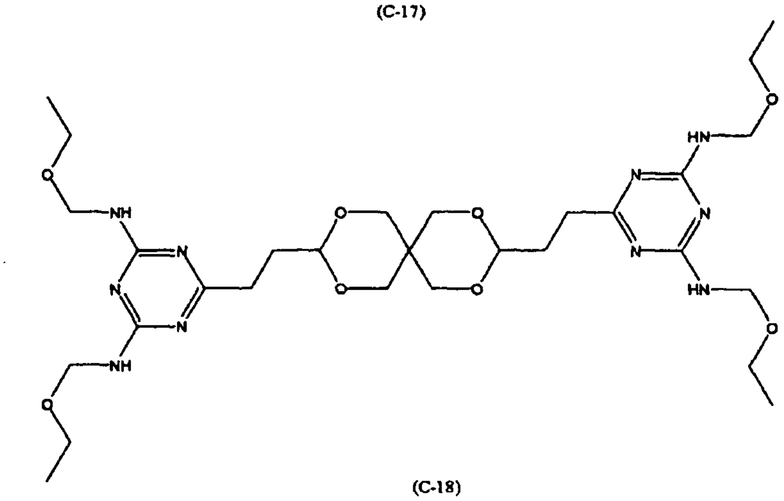

(C-18)

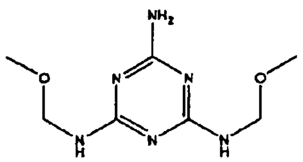

(C-19)

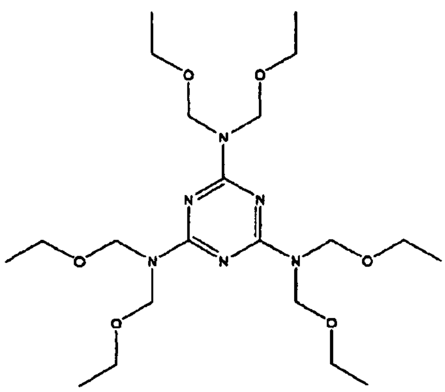

(C-20)

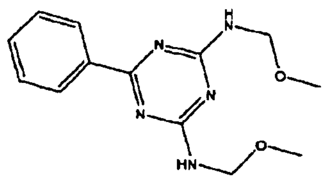

(C-21)

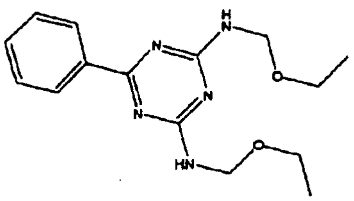

(C-22)

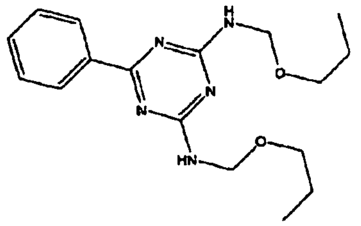

(C-23)

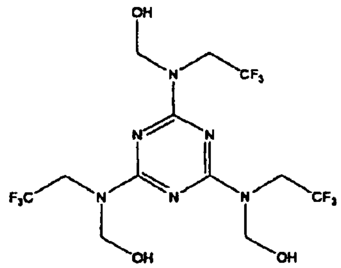

(C-24)

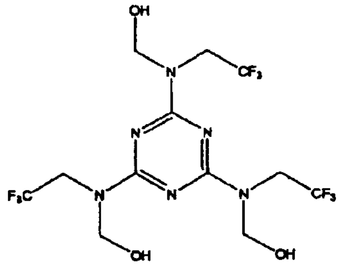

(C-25)

The compound having at least one -O-C-N- bond and the compounds represented by formulae (1) to (3) may be a commercially available product or may be synthesized by a known method described, for example, in Chem. Ber., 112, 1979, 3950 and 3954, J. Heterocycl. Chem., EN, 8, 1971, 327-328, Chem. Abstr., 1948, 6335, Justus Liebigs Ann. Chem., 361, 1908, 149, Bull. Cl. Sci. Acad. R. Belg., 1902, 721, Monatsh. Chem., 1955, 57, 66, J. Am. Chem. Soc., 69, 1947, 599, 600, and J. Med. Chem., EN, 36, 26, 1933, 4195-4200.

Furthermore, the treating agent of the present invention preferably contains an organic solvent for controlling the solubility of the first resist pattern. As for the organic solvent, any solvent may be used as long as it does not dissolve the first resist pattern and dissolves the compound having at least one -O-C-N- bond. The expression "does not dissolve the first resist pattern" as used herein means that when a 200-nm line-and-space pattern with a film thickness of 0.2 μm is formed under the condition of 23°C and dipped in an organic solvent for 10 minutes, both the fluctuation of pattern dimension and the fluctuation of pattern height are within ±5%.

Examples of such a solvent include a saturated hydrocarbon compound having a carbon number of 10 or more, a hydrocarbon compound containing at least one hydroxy group or at least one fluorine atom and having a carbon number of 6 or more, and an organic compound containing at least one fluorine atom and having a carbon number of 6 or more. Among these, in view of solubility of the treating agent, a hydrocarbon compound containing at least one hydroxy group and having a carbon number of 6 or more is preferred.

The water content of the solvent is preferably 40 mol% or less, more preferably 10 mol% or less, still more preferably 5 mol% or less.

The hydrocarbon compound containing at least one hydroxy group and having a carbon number of 6 or more is preferably a monohydric alcohol in terms of environmental safety, storage stability and safety to human body. One of these compounds may be used, or two or more thereof may be mixed and used.

Specific examples of the monohydric alcohol include n-hexyl alcohol, n-heptyl alcohol, 2-heptyl alcohol, n-octyl alcohol, n-decanol, 3-methyl-3-pentanol, 2,3-dimethyl-2-pentanol, 4-phenyl-2-methyl-2-hexanol, 1-phenyl-2-methyl-2-propanol, s-amyl alcohol, tert-amyl alcohol, isoamyl alcohol, 2-ethyl-1-butanol and n-undecanol.

Above all, from the standpoint of suppressing volatilization of the solvent, the carbon number of the alcohol is preferably 6 or more, more preferably 7 or more, still more preferably from 6 to 11, yet still more preferably from 7 to 9.

In the present invention, n-octyl alcohol and 2,3-dimethyl-2-pentanol are more preferred.

Examples of the usable organic compound containing at least one fluorine atom and having a carbon number of 6 or more include perfluoro-2-butyltetrahydrofuran, perfluorotetrahydrofuran, perfluorohexane, perfluoroheptane, perfluorotributylamine, perfluorotetrapentylamine and perfluorotetrahexylamine. One of these solvents may be used, or two or more thereof may be mixed and used. The fluorine content in the molecule is preferably from 40 to 80 mass%, more

preferably from 50 to 80 mass%.

Above all, the carbon number of the organic compound containing at least one fluorine atom and having a carbon number of 6 or more is preferably from 7 to 12, more preferably from 9 to 12. From the standpoint of suppressing volatilization of the solvent, the carbon number is preferably 7 or more, more preferably 9 or more.

As for the organic compound containing at least one fluorine atom and having a carbon number of 6 or more, specific examples of the fluorine-based solvent having a carbon number of 7 to 12 include perfluoro-2-butyltetrahydrofuran, perfluoroheptane and perfluorotributylamine, and specific examples of the fluorine-based solvent having a carbon number of 9 to 11 include perfluorotributylamine.

In the present invention, perfluoro-2-butyltetrahydrofuran is preferred.

Examples of the usable saturated hydrocarbon compound having a carbon number of 10 or more include decane, undecane, dodecane, 2,2,4,6,6-pentamethylheptane, tridecane, pentadecane, tetradecane and hexadecane. One of these organic solvents may be used, or two or more thereof may be mixed and used. In the present invention, decane and undecane are preferred.

An organic solvent other than the alcohol-based solvent, fluorine-based solvent and saturated hydrocarbon-based solvent may be used as long as it does not dissolve the first resist pattern and dissolves the compound having at least one -O-C-N- bond, but these organic solvents are preferably used in a proportion of 80 mass% or more, more preferably 100 mass%.

As for the other organic solvent that can be used, one arbitrary member or two or more arbitrary members may be appropriately selected from ester-based, ether-based, ketone-based, amide-based, aromatic hydrocarbon-based and cyclic ketone-based solvents. Examples thereof include esters such as ethyl lactate, ethyl acetate, butyl acetate and methyl methoxypropionate, ethers such as monomethyl ether (e.g., ethylene glycol monoacetate, diethylene glycol monoacetate, propylene glycol monoacetate, dipropylene glycol monoacetate), monoethyl ether and monophenyl ether, their derivatives, cyclic ethers such as dioxane, and ketones such as acetone, methyl ethyl ketone, cyclohexanone and 2-heptanone.

The amount of the organic solvent used is not particularly limited as long as the compound having at least one -O-C-N- bond can be dissolved, but the amount used is usually from 0 to 99 mass%, preferably from 5 to 95 mass%, more preferably from 10 to 90 mass%, based on the compound having at least one -O-C-N- bond.

Furthermore, for accelerating the reaction with the first resist pattern, the treating agent of the present invention may contain, if desired, an acid, a compound capable of generating an acid by heating, or a base.

As for the acid added, an acid having a low molecular weight, such as carboxylic acid and sulfonic acid, may be used, and a low molecular weight acid such as partially fluorinated carboxylic acid and partially fluorinated sulfonic acid is preferred. Specific examples thereof include trifluorobutanesulfonic acid, heptafluoropropanesulfonic acid and perfluorobenzenesulfonic acid.

As for the compound capable of generating an acid by heating, various compounds known in this field may be used. Examples thereof include known compounds such as sulfonium salt-type compound, anilinium salt-type compound, pyridinium salt-type compound, phosphonium salt-type compound and iodonium salt-type compound. Examples of the counter anion of these onium salt-type compounds include $SbF_6^-$, $BF_4^-$, $AsF_6^-$, $PF_6^-$, toluenesulfonate and triflate. The temperature when generating an acid is usually 200°C or less, preferably 160°C or less.

The amount added of the acid or compound capable of generating an acid by heating is generally from 0.01 to 20 mass%, preferably from 0.1 to 10 mass%, based on the entire amount of the treating agent.

As for the base added, a base having a low molecular weight, such as organic amines, may be used, and a tertiary amine is preferred. Specific examples thereof include trimethylamine, triethylamine, tripropylamine, tributylamine, triethanolamine, triisopropylamine, triisobutylamine, diisopropylethylamine, 2,3'-(p-tolylamino)diethanol, diazabicycloundecene and diazabicyclononene.

The amount added of the base or compound capable of generating a base by heating is generally from 0.01 to 20 mass%, preferably from 0.1 to 10 mass%, based on the entire amount of the treating agent.

The treating agent of the present invention preferably contains various surfactants. As for the surfactant, various surfactants known in this field can be used and, for example, ionic or nonionic fluorine-containing and/or silicone-containing surfactants may be used. Examples of the fluorine-containing and/or silicon-containing surfactant include surfactants described in JP-A-62-36663, JP-A-61-226746, JP-A-61-226745, JP-A-62-170950, JP-A-63-34540, JP-A-7-230165, JP-A-8-62834, JP-A-9-54432, JP-A-9-5988, and U.S. Patents 5,405,720, 5,360,692, 5,529,881, 5,296,330, 5,436,098, 5,576,143, 5,294,511 and 5,824,451. The following commercially available surfactants each may also be used as it is.

Examples of the commercially available surfactant which can be used include EFtop EF301 and EF303 (produced by Shin-Akita Kasei K.K.), Florad FC 430, 431 and 4430 (produced by Sumitomo 3M Inc.), Megaface F171, F176, F189 and R08 (produced by Dainippon Ink & Chemicals Inc.), Surflon S-382, SC101, 102 and 103 (produced by Asahi Glass Co., Ltd.), Troysol S-366 (produced by Troy Chemical), and PF6320 and PF6520 (produced by OMNOVA).

Other than these known surfactants, a surfactant using a polymer having a fluoro-aliphatic group derived from

a fluoro-aliphatic compound that is produced by a telomerization process (also called a telomer process) or an oligomerization process (also called an oligomer process), may be used. The fluoro-aliphatic compound can be synthesized by the method described in JP-A-2002-90991.

In the present invention, a surfactant other than the fluorine-containing and/or silicon-containing surfactants may also be used.

One of these surfactants may be used alone, or some of them may be used in combination.

The amount used of the surfactant is preferably from 0.0001 to 2 mass%, more preferably from 0.001 to 1 mass%, based on the entire amount of the treating agent.

By the addition of a surfactant to the treating agent, coatability when applying the treating agent is enhanced.

The treating agent may further contain a photo-acid generator, a photo-sensitizer, a freezing reaction accelerator other than the acid above, a resin and the like, if desired.

<First Resist>

In the present invention, it is important that, after forming a first resist pattern on a first resist film, the first resist pattern is changed by a treating agent containing chemical species of the present invention so as not to dissolve in a second resist solution. This control can be achieved not only by changing the property with the treating agent but also by qualitatively changing the first resist pattern and/or changing the processing conditions when causing the treating agent to act on the resist.

The first resist may be either a positive tone resist or a negative tone resist, but a positive tone resist is preferred for the purpose of enhancing the reactivity with the treating agent. Here, "a positive tone resist" indicates a resist where the exposed portion is dissolved in a developer, and "a negative tone resist" indicates a resist where the unexposed portion is dissolved in a developer. The positive tone resist generally utilizes a chemical reaction such as desorption of an atomic group protecting an alkali-soluble group, for raising the solubility of the exposed portion in a developer, whereas the negative tone resist utilizes production of an intermolecular bond, such as crosslinking reaction and polymerization reaction.

The positive tone resist is preferably formed of a positive tone resist composition containing a resin capable of decomposing by the action of an acid to increase the solubility in an alkali developer, and a compound capable of generating an acid upon irradiation with an actinic ray or radiation.

[1] Resin capable of decomposing by the action of an acid to increase the solubility in an alkali developer (resin (A))

The resin (A) is preferably a resin capable of causing an esterification reaction with the treating agent containing chemical species of the present invention and generating a carboxyl group through a chemical reaction in the process of forming a first resist pattern, so that the first resist pattern can be qualitatively changed not to dissolve in a second resist solution. The resin containing a carboxyl group may be previously contained in the first resist before pattern formation.

The resin (A) is a resin capable of decomposing by the action of an acid to increase the solubility in an alkali developer, and this is a resin having a group capable of decomposing by the action of an acid to produce an alkali-soluble group (hereinafter sometimes referred to as "an acid-decomposable group"), on either one or both of the main chain and the side chain of the resin.

Examples of the alkali-soluble group include a phenolic hydroxyl group, a carboxyl group, a fluorinated alcohol group, a sulfonic acid group, a sulfonamide group, a sulfonylimide group, an (alkylsulfonyl)(alkylcarbonyl)methylene group, an (alkylsulfonyl)(alkylcarbonyl)imide group, a bis(alkylcarbonyl)methylene group, a bis(alkylcarbonyl)imide group, a bis(alkylsulfonyl)methylene group, a bis(alkylsulfonyl)imide group, a tris(alkylcarbonyl)methylene group and a tris(alkylsulfonyl)methylene group.

The alkali-soluble group is preferably a carboxyl group, a fluorinated alcohol group (preferably hexafluoroisopropanol) or a sulfonic acid group.

The acid-decomposable group is preferably a group obtained by substituting the hydrogen atom of the alkali-soluble group above with a group capable of leaving by the action of an acid.

Examples of the group capable of leaving by the action of an acid include $-C(R_{36})(R_{37})(R_{38})$, $-C(R_{36})(R_{37})(OR_{39})$ and $-C(R_{01})(R_{02})(OR_{39})$.

In the formulae, each of $R_{36}$ to $R_{39}$ independently represents an alkyl group, a cycloalkyl group, an aryl group, an aralkyl group or an alkenyl group. $R_{36}$ and $R_{37}$ may combine with each other to form a ring.

Each of $R_{01}$ and $R_{02}$ independently represents a hydrogen atom, an alkyl group, a cycloalkyl group, an aryl group, an aralkyl group or an alkenyl group.

The acid-decomposable group is preferably a cumyl ester group, an enol ester group, an acetal ester group, a tertiary alkyl ester group or the like, more preferably a tertiary alkyl ester group.

In the resin (A), the repeating unit containing an acid-decomposable group is preferably a repeating unit represented by the following formula (AI):

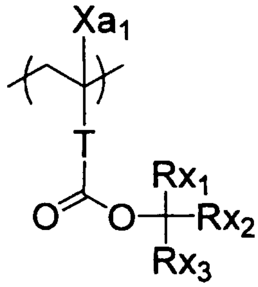

(A I)

In formula (AI), $Xa_1$ represents a hydrogen atom, a methyl group, a trifluoromethyl group or a hydroxymethyl group.

T represents a single bond or a divalent linking group.

Each of $Rx_1$ to $Rx_3$ independently represents an alkyl group (linear or branched) or a cycloalkyl group (monocyclic or polycyclic).

At least two members out of $Rx_1$ to $Rx_3$ may combine to form a cycloalkyl group (monocyclic or polycyclic).

Examples of the divalent linking group of T include an alkylene group, a -COO-Rt-group and a -O-Rt- group, wherein Rt represents an alkylene group or a cycloalkylene group. T is preferably a single bond or a -COO-Rt- group. Rt is preferably an alkylene group having a carbon number of 1 to 5, more preferably a $-CH_2-$ group or a $-(CH_2)_3-$ group.

The alkyl group of $Rx_1$ to $Rx_3$ is preferably an alkyl group having a carbon number of 1 to 4, such as methyl group, ethyl group, n-propyl group, isopropyl group, n-butyl group, isobutyl group and tert-butyl group.

The cycloalkyl group of $Rx_1$ to $Rx_3$ is preferably a monocyclic cycloalkyl group such as cyclopentyl group and cyclohexyl group, or a polycyclic cycloalkyl group such as norbornyl group, tetracyclodecanyl group, tetracyclododecanyl group and adamantyl group.

The cycloalkyl group formed by combining at least two members out of $Rx_1$ to $Rx_3$ is preferably a monocyclic cycloalkyl group such as cyclopentyl group and cyclohexyl group, or a polycyclic cycloalkyl group such as norbornyl group, tetracyclodecanyl group, tetracyclododecanyl group and adamantyl group.

An embodiment where $Rx_1$ is a methyl group or an ethyl group and $Rx_2$ and $Rx_3$ are combined to form the above-described cycloalkyl group is preferred.

The atomic group above may have a substituent, and examples of the substituent include an alkyl group, a cycloalkyl group, an alkoxy group, a hydroxyl group and a cyano group.

The content of the repeating unit containing an acid-decomposable group is preferably from 20 to 50 mol%, more preferably from 25 to 45 mol%, based on all repeating units in the resin (A).

Specific preferred examples of the repeating unit having an acid-decomposable group are set forth below, but the present invention is not limited thereto.

(In formulae, Rx represents H, $CH_3$, $CF_3$ or $CH_2OH$, and each of Rxa and Rxb represents an alkyl group having a carbon number of 1 to 4.)

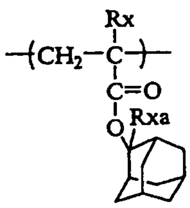

1

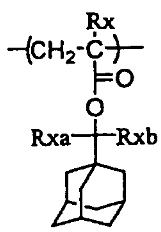

2

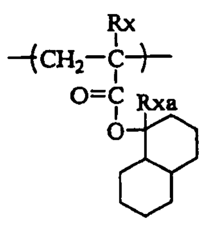

3

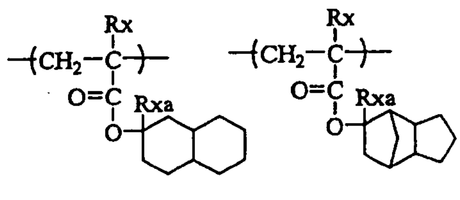

4

5

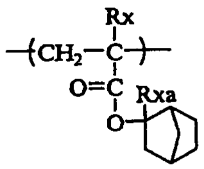
6

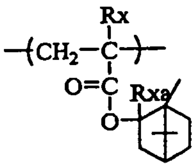
7

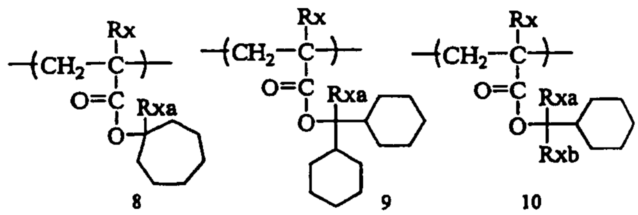
8 9 10

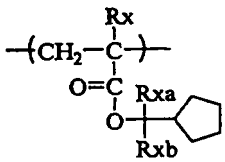
11

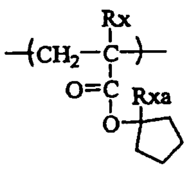
12

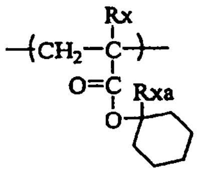
13

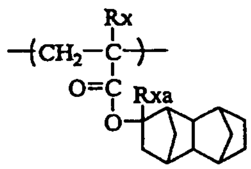
14

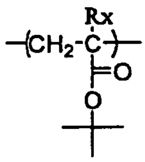
15

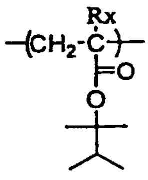
16

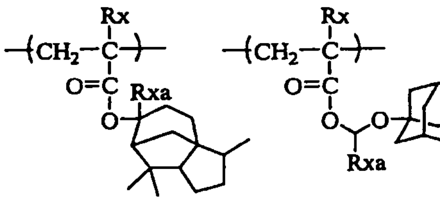
17 18

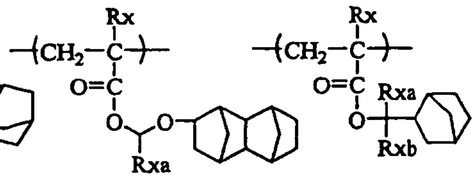
19 20

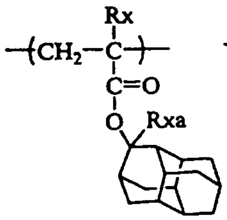
21

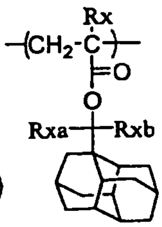
22

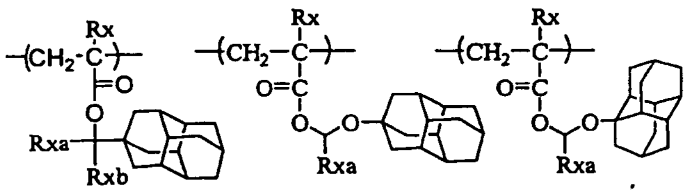
23 24 25

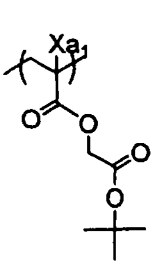

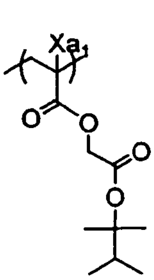

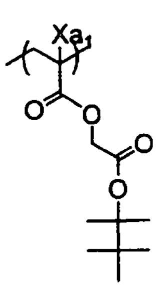

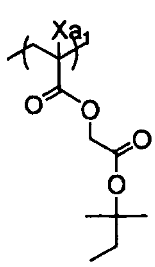

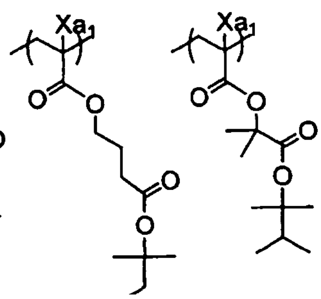

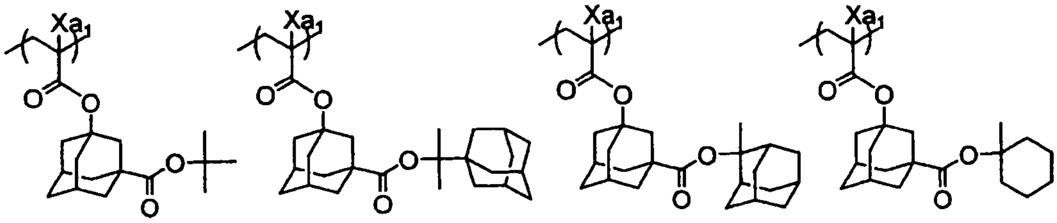

(In the formulae above, $X_{a1}$ has the same meaning as $X_{a1}$ in formula (AI)).

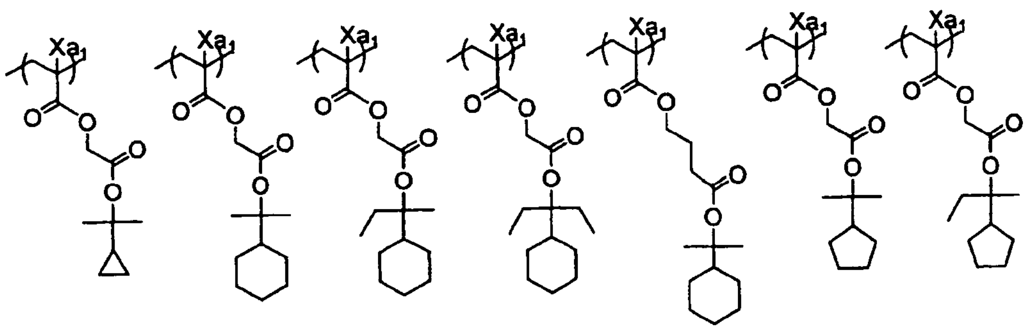

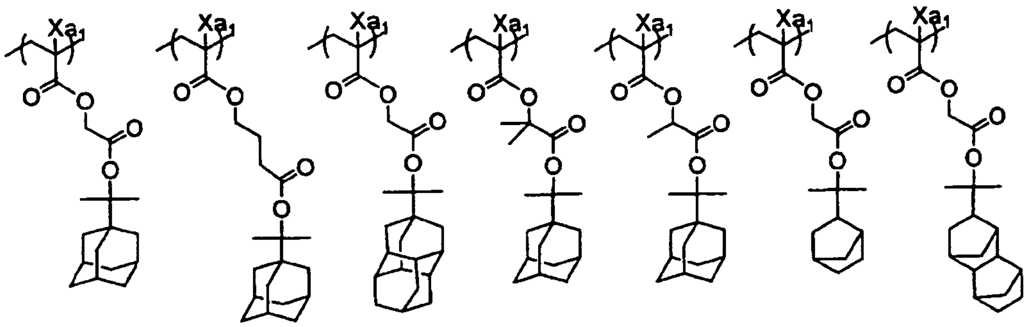

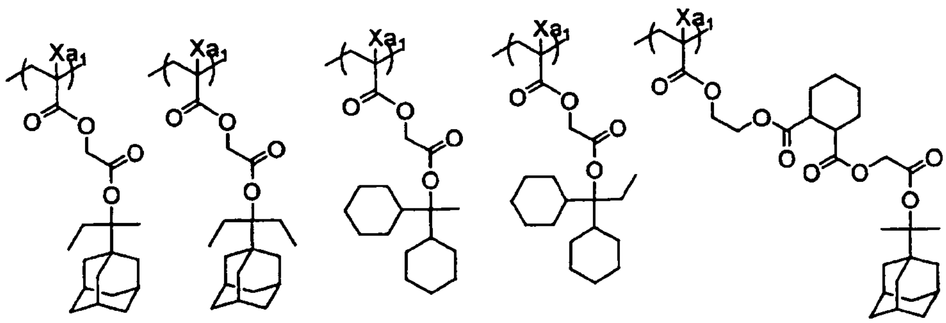

(In the formulae above, $X_{a1}$ has the same meaning as $X_{a1}$ in formula (AI)).

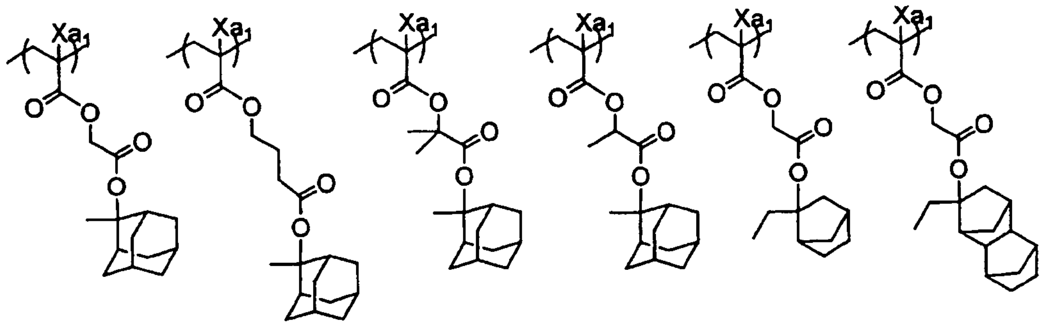

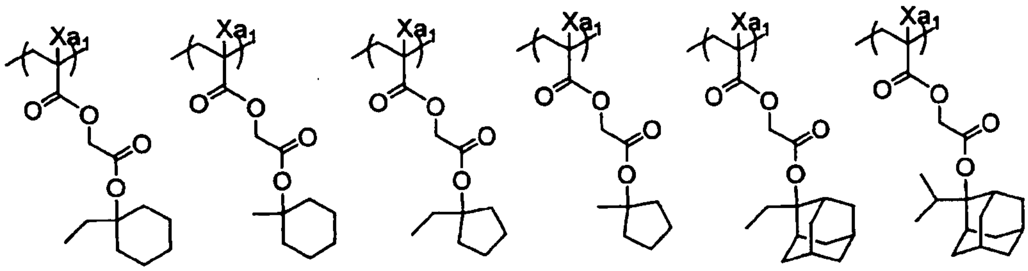

(In the formulae above, $X_{a1}$ has the same meaning as $X_{a1}$ in formula (AI)).

The resin (A) preferably contains a repeating unit having at least one kind of a group selected from a lactone group, a hydroxyl group, a cyano group and an alkali-soluble group.

The lactone group-containing repeating unit that is preferably contained in the resin (A) is described bellow.

As for the lactone group, any group may be used as long as it has a lactone structure, but the lactone structure is preferably a 5- to 7-membered ring lactone structure, and a structure where another ring structure is condensed to the 5- to 7-membered ring lactone structure in the form of forming a bicyclo or spiro structure is preferred. The resin more preferably contains a repeating unit having a lactone structure represented by any one of the following formulae (LC1-1) to (LC1-16). The lactone structure may be bonded directly to the main chain. Among these lactone structures, preferred are (LC1-1), (LC1-4), (LC1-5), (LC1-6), (LC1-13) and (LC1-14). By virtue of using a specific lactone structure, the line edge roughness and development defect are improved.

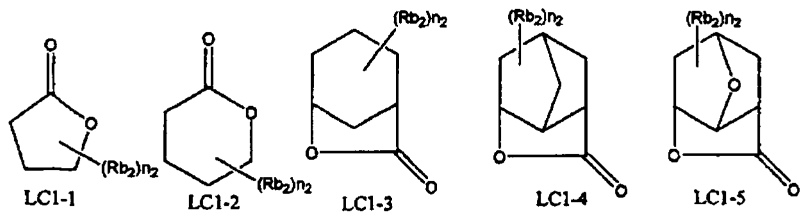

LC1-1 LC1-2 LC1-3 LC1-4 LC1-5

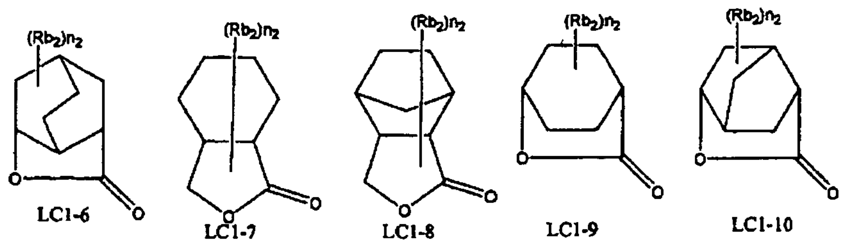

LC1-6 LC1-7 LC1-8 LC1-9 LC1-10

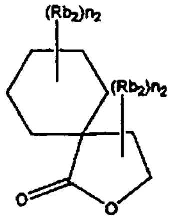
LC1-11

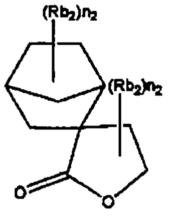
LC1-12

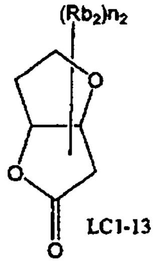
LC1-13

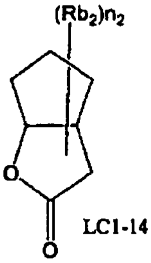
LC1-14

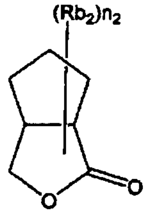
LC1-15

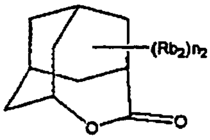
LC1-16

The lactone structure moiety may or may not have a substituent ($Rb_2$). Preferred examples of the substituent ($Rb_2$) include an alkyl group having a carbon number of 1 to 8, a cycloalkyl group having a carbon number of 4 to 7, an alkoxy group having a carbon number of 1 to 8, an alkoxycarbonyl group having a carbon number of 1 to 8, a carboxyl group, a halogen atom, a hydroxyl group, a cyano group and an acid-decomposable group. Among these, an alkyl group having a carbon number of 1 to 4, a cyano group and an acid-decomposable group are more preferred. $n_2$ represents an integer of 0 to 4. When $n_2$ is an integer of 2 or more, each substituent ($Rb_2$) may be the same as or different from every other substituent ($Rb_2$) and also, each substituent ($Rb_2$) may combine with every other substituent ($Rb_2$) to form a ring.

The repeating unit having a lactone structure represented by any one of formulae (LC1-1) to (L1-16) includes a repeating unit represented by the following formula (AI'):

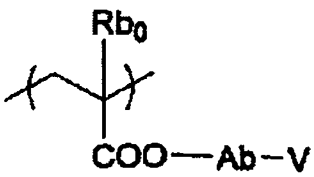
(AI')

In formula (AI'), $Rb_0$ represents a hydrogen atom, a halogen atom or an alkyl group having a carbon number of 1 to 4. Preferred examples of the substituent which the alkyl group of $Rb_0$ may have include a hydroxyl group and a halogen atom. The halogen atom of $Rb_0$ includes a fluorine atom, a chlorine atom, a bromine atom and an iodine atom. $Rb_0$ is preferably a hydrogen atom or a methyl group.

Ab represents a single bond, an alkylene group, a divalent linking group having a monocyclic or polycyclic alicyclic hydrocarbon structure, an ether group, an ester group, a carbonyl group, or a divalent group comprising a combination thereof, and is preferably a single bond or a divalent linking group represented by $-Ab_1-CO_2-$. $Ab_1$ represents a linear or branched alkylene group or a monocyclic or polycyclic cycloalkylene group and is preferably a methylene group, an ethylene group, a cyclohexylene group, an adamantylene group or a norbornylene group.

V represents a group having a structure represented by any one of formulae (LC1-1)to(LC1-16).

The repeating unit having a lactone structure usually has an optical isomer, but any optical isomer may be used. One optical isomer may be used alone or a mixture of a plurality of optical isomers may be used. In the case of mainly using one optical isomer, the optical purity (ee) thereof is preferably 90 or more, more preferably 95 or more.

The content of the repeating unit having a lactone group is preferably from 15 to 60 mol%, more preferably from 20 to 50 mol%, still more preferably from 30 to 50 mol%, based on all repeating units in the resin (A).

Specific examples of the lactone group-containing repeating unit are set forth below, but the present invention is not limited thereto.

(In the formulae, Rx is H, $CH_3$, $CH_2OH$ or $CF_3$.)

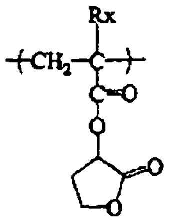
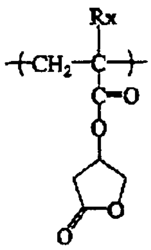
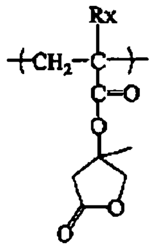
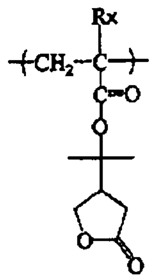
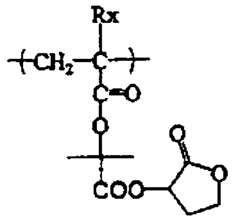
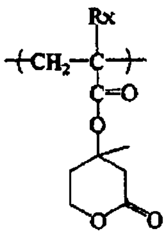
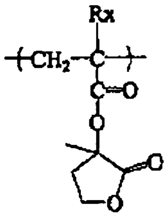
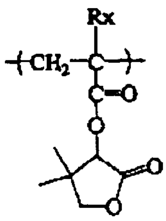
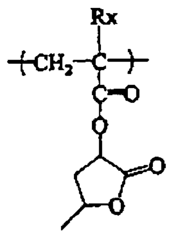
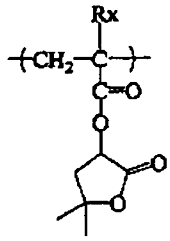
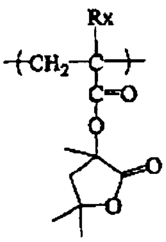
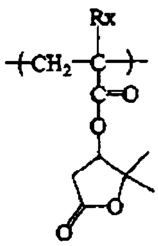
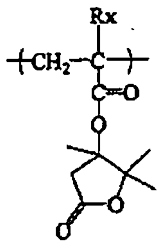
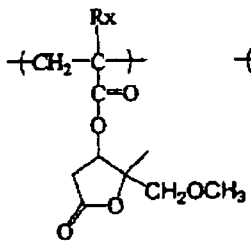
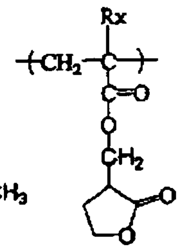
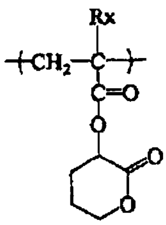
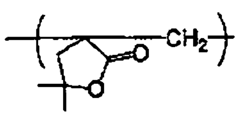
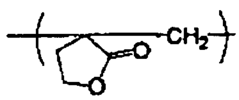
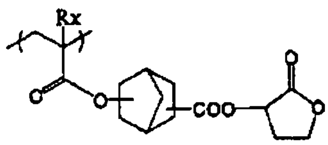
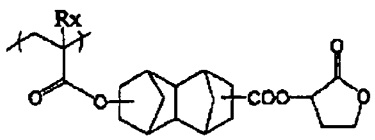
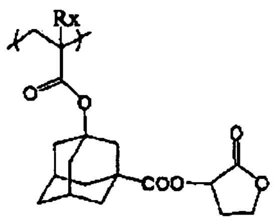

(In the formulae, Rx is H, $CH_3$, $CH_2OH$ or $CF_3$.)

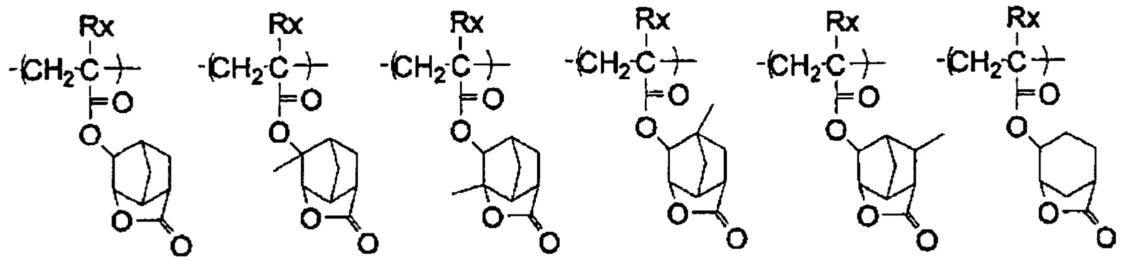

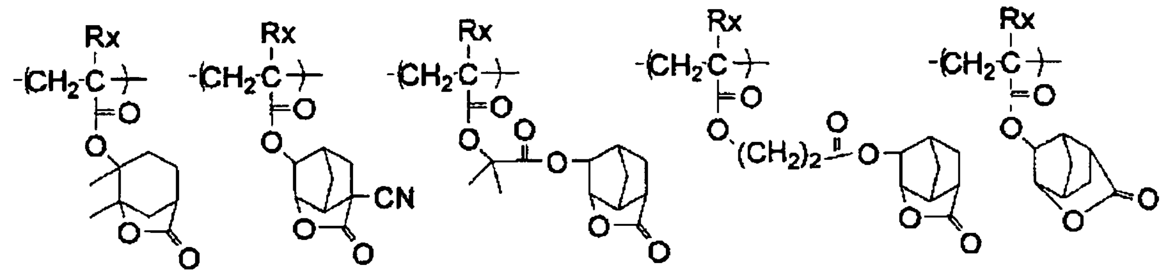

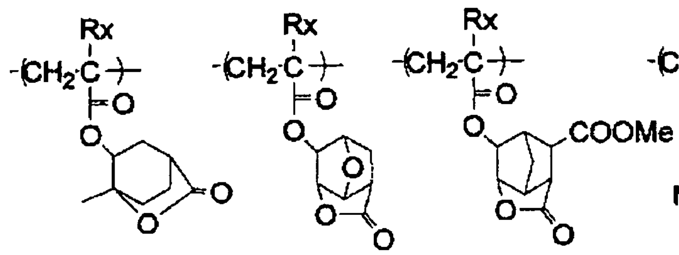

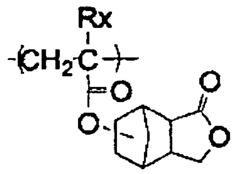

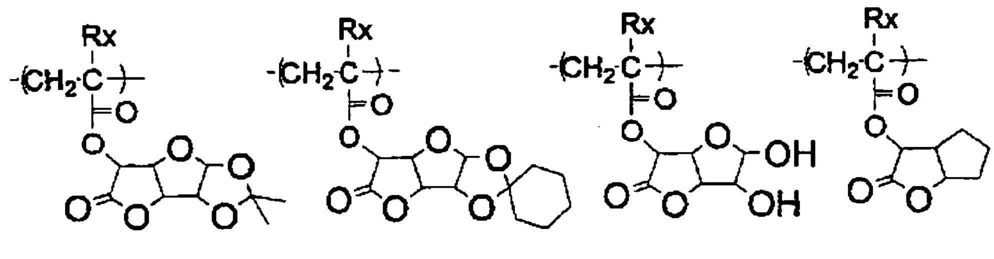

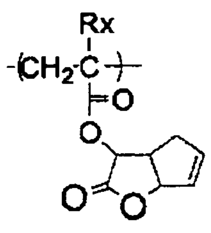

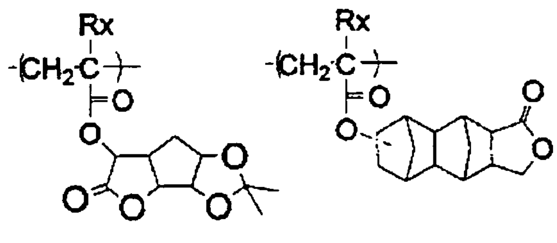

(In the formulae, Rx is H, $CH_3$, $CH_2OH$ or $CF_3$.)

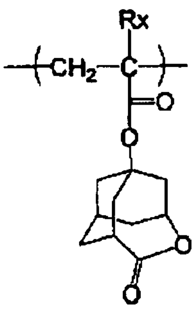 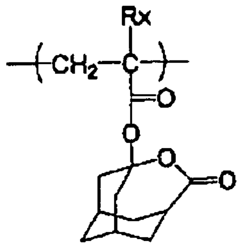 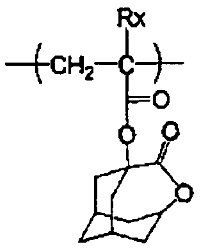 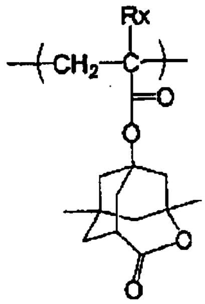

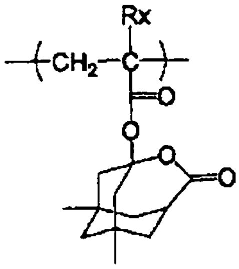 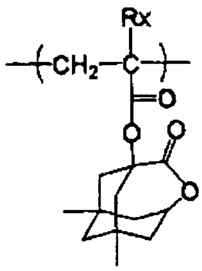 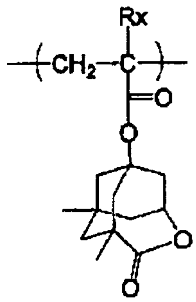 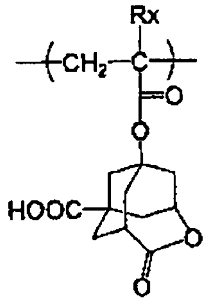

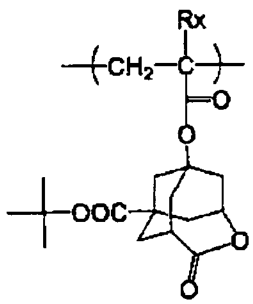 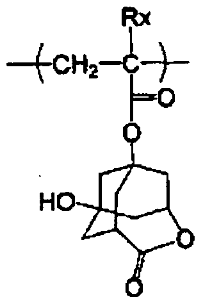 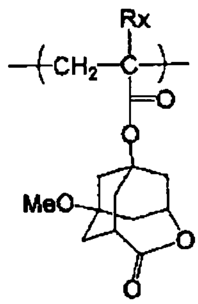 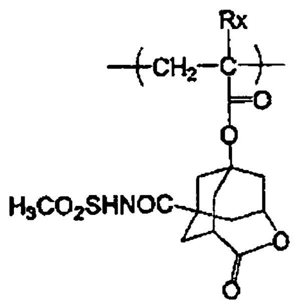

The repeating unit having a particularly preferred lactone group includes the repeating units shown below. By selecting an optimal lactone group, the pattern profile and the iso/dense bias are improved.

(In the formulae, Rx is H, $CH_3$, $CH_2OH$ or $CF_3$.)

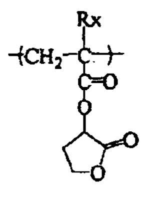 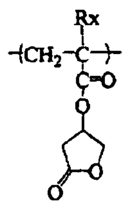 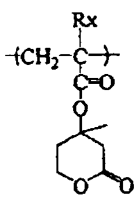 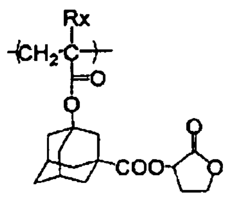

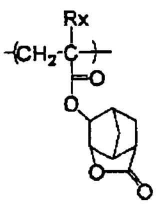 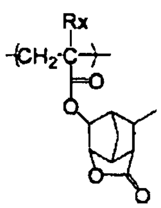 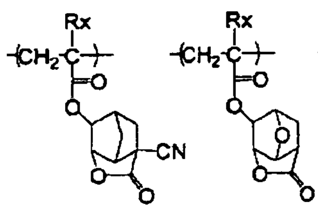 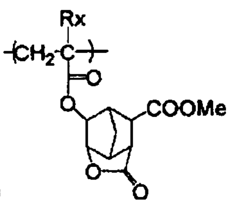

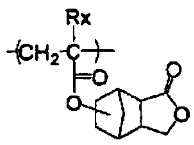 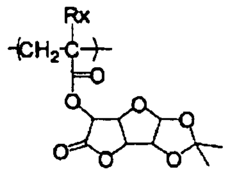 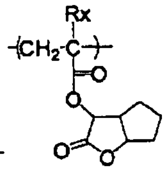

A repeating unit having a hydroxyl group or a cyano group, which is preferably contained in the resin (A), is described below. By virtue of the resin (A) containing this repeating unit, the adherence to substrate and the affinity for developer are enhanced. The repeating unit having a hydroxyl group or a cyano group is preferably a repeating unit having an alicyclic hydrocarbon structure substituted by a hydroxyl group or a cyano group. The alicyclic hydrocarbon structure in the alicyclic hydrocarbon structure substituted by a hydroxyl group or a cyano group is preferably an adamantyl group, a diamantyl group or a norbornane group. The alicyclic hydrocarbon structure substituted by a hydroxyl group or a cyano group is preferably a partial structure represented by any one of the following formulae (VIIa) to (VIId):

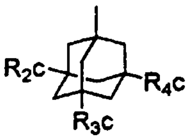
(VIIa)

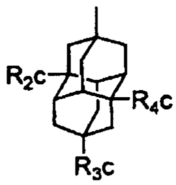
(VIIb)

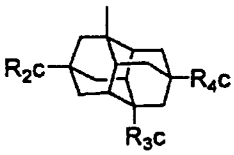
(VIIc)

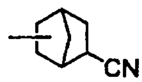
(VIId)

In formulae (VIIa) to (VIIc), each of $R_2c$ to $R_4c$ independently represents a hydrogen atom, a hydroxyl group or a cyano group, provided that at least one of $R_2c$ to $R_4c$ represents a hydroxyl group or a cyano group. A structure where one or two members out of $R_2c$ to $R_4c$ are a hydroxyl group with the remaining being a hydrogen atom is preferred. In formula (VIIa), it is more preferred that two members out of $R_2c$ to $R_4c$ are a hydroxyl group and the remaining is a hydrogen atom.

The repeating unit having a partial structure represented by any one of formulae (VIIa) to (VIId) includes repeating units represented by the following formulae (AIIa) to (AIId):

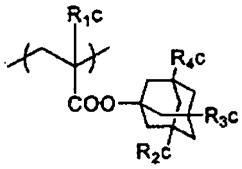
(AIIa)

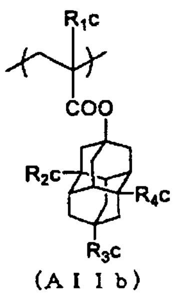
(AIIb)

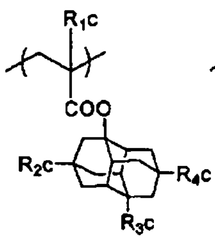
(AIIc)

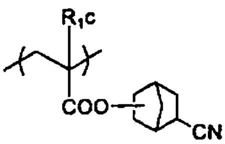
(AIId)

In formulae (AIIa) to (AIId), $R_1c$ represents a hydrogen atom, a methyl group, a trifluoromethyl group or a hydroxymethyl group.

$R_2c$ to $R_4c$ have the same meanings as $R_2c$ to $R_4c$ in formulae (VIIa) to (VIIc).

The content of the repeating unit having an alicyclic hydrocarbon structure substituted by a hydroxyl group or a cyano group is preferably from 5 to 40 mol%, more preferably from 5 to 30 mol%, still more preferably from 10 to 25 mol%, based on all repeating units in the resin (A).

Specific examples of the repeating unit having a hydroxyl group or a cyano group are set forth below, but the present invention is not limited thereto.

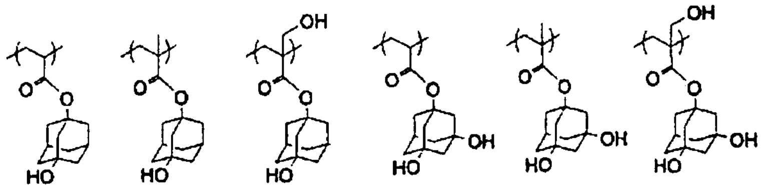

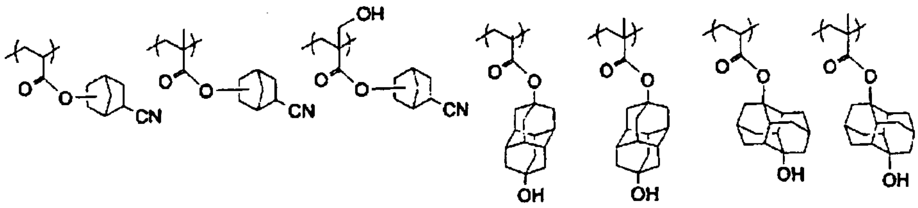

The repeating unit having an alkali-soluble group, which is preferably contained in the resin (A), is described below. The alkali-soluble group includes a carboxyl group, a sulfonamide group, a sulfonylimide group, a bisulfonylimide group, and an aliphatic alcohol with the α-position being substituted by an electron-withdrawing group, such as hexafluoroisopropanol group. A repeating unit having a carboxyl group is more preferred. By virtue of containing the repeating unit having an alkali-soluble group, the resolution increases in the usage of forming contact holes. As for the repeating unit having an alkali-soluble group, all of a repeating unit where an alkali-soluble group is directly bonded to the resin main chain, such as repeating unit by an acrylic acid or a methacrylic acid, a repeating unit where an alkali-soluble group is bonded to the resin main chain through a linking group, and a repeating unit where an alkali-soluble group is introduced into the polymer chain terminal by using an alkali-soluble group-containing polymerization initiator or chain transfer agent at the polymerization, are preferred. The linking group may have a monocyclic or polycyclic cyclohydrocarbon structure. In particular, a repeating unit by an acrylic acid or a methacrylic acid is preferred.

The content of the repeating unit having an alkali-soluble group is preferably from 0 to 25 mol%, more preferably from 3 to 20 mol%, still more preferably from 5 to 15 mol%, based on all repeating units in the resin (A).

Specific examples of the repeating unit having an alkali-soluble group are set forth below, but the present invention is not limited thereto.

(In the formulae, Rx is H, $CH_3$, $CF_3$ or $CH_2OH$.)

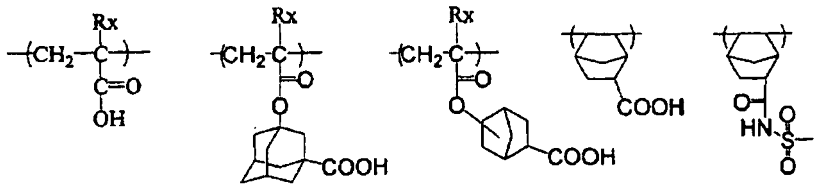

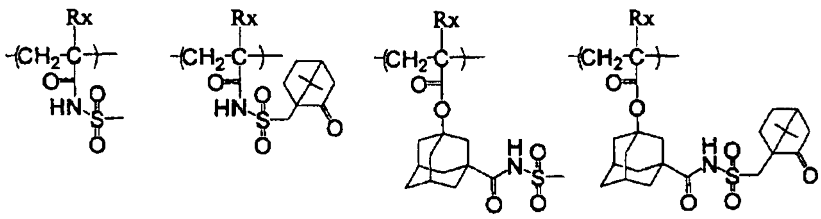

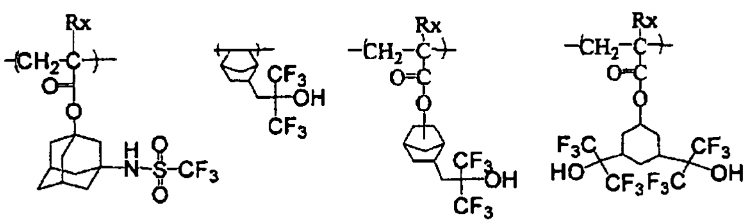

The resin (A) may further contain a repeating unit having an alicyclic hydrocarbon structure and not exhibiting acid decomposability. Thanks to this repeating unit, the dissolving out of low molecular components from the resist film to the immersion liquid at the immersion exposure can be reduced, which is advantageous also in view of dry etching resistance. Specific examples of this repeating unit include a repeating unit represented by the following formula (III):

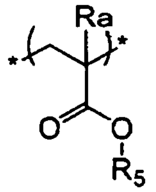
(III)

In formula (III), $R_5$ represents a hydrocarbon group having at least one cyclic structure and having neither a hydroxyl group nor a cyano group.

Ra represents a hydrogen atom, an alkyl group or a $-CH_2-O-Ra_2$ group, wherein $Ra_2$ represents a hydrogen atom, an alkyl group or an acyl group.

The cyclic structure possessed by $R_5$ includes a monocyclic hydrocarbon group and a polycyclic hydrocarbon group. Examples of the monocyclic hydrocarbon group include a cycloalkyl group having a carbon number of 3 to 12, such as cyclopentyl group, cyclohexyl group, cycloheptyl group and cyclooctyl group, and a cycloalkenyl group having a carbon number of 3 to 12, such as cyclohexenyl group. The monocyclic hydrocarbon group is preferably a monocyclic hydrocarbon group having a carbon number of 3 to 7, more preferably a cyclopentyl group or a cyclohexyl group.

The polycyclic hydrocarbon group includes a ring gathered hydrocarbon group and a crosslinked cyclic hydrocarbon group. Examples of the ring gathered hydrocarbon group include a bicyclohexyl group and a perhydronaphthalenyl group. Examples of the crosslinked hydrocarbon ring include a bicyclic hydrocarbon ring such as pinane ring, bornane ring, norpinane ring, norbornane ring and bicyclooctane ring (e.g., bicyclo[2.2.2]octane ring, bicyclo[3.2.1]octane ring), a tricyclic hydrocarbon ring such as homobledane ring, adamantane ring, tricyclo[$5.2.1.0^{2,6}$]decane ring and tricyclo [$4.3.1.1^{2.5}$]undecane ring, and a tetracyclic hydrocarbon ring such as tetracyclo[$4.4.0.1^{2,5}.1^{7.10}$]dodecane ring and perhydro-1,4-methano-5,8-methanonaphthalene ring. The crosslinked cyclic hydrocarbon ring also includes a condensed cyclic hydrocarbon ring, for example, a condensed ring formed by condensing a plurality of 5- to 8-membered cycloalkane rings, such as perhydronaphthalene (decalin) ring, perhydroanthracene ring, perhydrophenathrene ring, perhydroacenaphthene ring, perhydrofluorene ring, perhydroindene ring and perhydrophenalene ring.

Preferred examples of the crosslinked cyclic hydrocarbon ring include a norbornyl group, an adamantyl group, a bicyclooctanyl group and a tricyclo[$5,2,1,0^{2,6}$]decanyl group. Of these crosslinked cyclic hydrocarbon rings, a norbornyl group and an adamantyl group are more preferred.

Such an alicyclic hydrocarbon group may have a substituent, and preferred examples of the substituent include a halogen atom, an alkyl group, a hydroxyl group protected by a protective group, and an amino group protected by a protective group. The halogen atom is preferably bromine atom, chlorine atom or fluorine atom, and the alkyl group is preferably a methyl group, an ethyl group, a butyl group or a tert-butyl group. This alkyl group may further have a substituent, and the substituent which the alkyl group may further have includes a halogen atom, an alkyl group, a hydroxyl group protected by a protective group, and an amino group protected by a protective group.

Examples of the protective group include an alkyl group, a cycloalkyl group, an aralkyl group, a substituted methyl group, a substituted ethyl group, an acyl group, an alkoxycarbonyl group and an aralkyloxycarbonyl group. The alkyl group is preferably an alkyl group having a carbon number of 1 to 4, the substituted methyl group is preferably a methoxymethyl group, a methoxythiomethyl group, a benzyloxymethyl group, a tert-butoxymethyl group or a 2-methoxyethoxymethyl group, the substituted ethyl group is preferably a 1-ethoxyethyl group or a 1-methyl-1-methoxyethyl group, the acyl group is preferably an aliphatic acyl group having a carbon number of 1 to 6, such as formyl group, acetyl group, propionyl group, butyryl group, isobutyryl group, valeryl group and pivaloyl group, and the alkoxycarbonyl group is preferably an alkoxycarbonyl group having a carbon number of 1 to 4.

The content of the repeating unit having a repeating unit represented by formula (III) having neither a hydroxyl group nor a cyano group is preferably from 0 to 40 mol%, more preferably from 0 to 20 mol%, based on all repeating units in the resin (A).

Specific examples of the repeating unit represented by formula (III) are set forth below, but the present invention is not limited thereto.

In the formulae, Ra represents H, $CH_3$, $CH_2OH$ or $CF_3$.

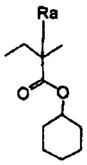 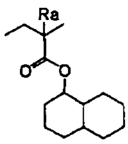 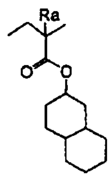 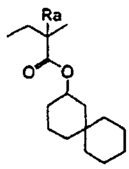

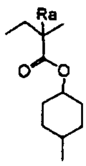 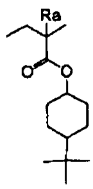 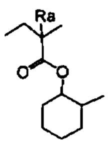 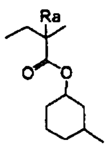

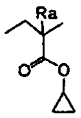 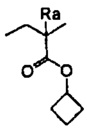 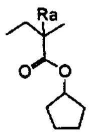 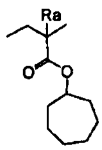

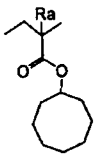 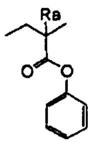 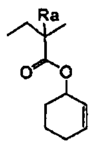 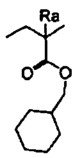

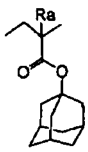 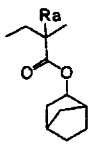 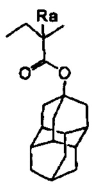 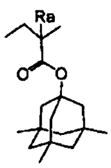

The resin (A) may contain, in addition to the above-described repeating structural units, various repeating structural units for the purpose of controlling the dry etching resistance, suitability for standard developer, adherence to substrate, resist profile and properties generally required of the resist, such as resolution, heat resistance and sensitivity.
Examples of such a repeating structural unit include, but are not limited to, repeating structural units corresponding to the monomers described below.
Thanks to such a repeating structural unit, the performance required of the resin (A), particularly,

(1) solubility in coating solvent,
(2) film-forming property (glass transition point),
(3) alkali developability,
(4) film loss (selection of hydrophilic, hydrophobic or alkali-soluble group),
(5) adherence of unexposed area to substrate,
(6) dry etching resistance

and the like, can be subtly controlled.

Examples of the monomer include a compound having one addition-polymerizable unsaturated bond selected from acrylic acid esters, methacrylic acid esters, acrylamides, methacrylamides, allyl compounds, vinyl ethers and vinyl esters.

Other than these, an addition-polymerizable unsaturated compound copolymerizable with the monomers corresponding to the above-described various repeating structural units may be copolymerized.

In the resin (A), the molar ratio of respective repeating structural units contained is appropriately determined to control the dry etching resistance of resist, suitability for standard developer, adherence to substrate, resist profile and performances generally required of the resist, such as resolution, heat resistance and sensitivity.

In the case where the positive tone resist composition of the present invention is used for ArF exposure, the resin (A) preferably has no aromatic group in view of transparency to ArF light.

The resin (A) is preferably a resin where all repeating units are composed of a (meth)acrylate-based repeating unit. In this case, all repeating units may be a methacrylate-based repeating unit, all repeating units may be an acrylate-based repeating unit, or all repeating unit may comprise a methacrylate-based repeating unit and an acrylate-based repeating unit, but the content of the acrylate-based repeating unit is preferably 50 mol% or less based on all repeating units. The resin is more preferably a copolymerized polymer containing from 20 to 50 mol% of an acid decomposable group-containing (meth)acrylate-based repeating unit represented by formula (AI), from 20 to 50 mol% of a lactone group-containing (meth)acrylate-based repeating unit, from 5 to 30 mol% of a (meth)acrylate-based repeating unit having an alicyclic hydrocarbon structure substituted by a hydroxyl group or a cyano group, and from 0 to 20 mol% of other (meth)acrylate-based repeating units.

In the case where the positive tone resist composition of the present invention is irradiated with KrF excimer laser light, electron beam, X-ray or high-energy beam at a wavelength of 50 nm or less (e.g., EUV), the resin (A) preferably further contains a hydroxystyrene-based repeating unit, more preferably a hydroxystyrene-based repeating unit, a hydroxystyrene-based repeating unit protected by an acid-decomposable group, and an acid-decomposable repeating unit such as tertiary alkyl (meth)acrylate, in addition to the repeating unit represented by formula (AI).

Preferred examples of the repeating unit having an acid-decomposable group include a repeating unit composed of a tert-butoxycarbonyloxystyrene, a 1-alkoxyethoxystyrene or a tertiary alkyl (meth)acrylate. A repeating unit composed of a 2-alkyl-2-adamantyl (meth)acrylate or a dialkyl(1-adamantyl)methyl (meth)acrylate is more preferred.

The resin (A) can be synthesized by an ordinary method (for example, radical polymerization). Examples of the synthesis method in general include a batch polymerization method of dissolving monomer species and an initiator in a solvent and heating the solution, thereby effecting the polymerization, and a dropping polymerization method of adding dropwise a solution containing monomer species and an initiator to a heated solvent over 1 to 10 hours. A dropping polymerization method is preferred. Examples of the reaction solvent include ethers such as tetrahydrofuran, 1,4-dioxane, diisopropyl ether, ketones such as methyl ethyl ketone and methyl isobutyl ketone, an ester solvent such as ethyl acetate, an amide solvent such as dimethylformamide and dimethylacetamide, and a solvent capable of dissolving the composition of the present invention, which is described later, such as propylene glycol monomethyl ether acetate, propylene glycol monomethyl ether and cyclohexanone. The polymerization is more preferably performed using the same solvent as the solvent used in the positive tone resist composition of the present invention. By the use of this solvent, production of particles during storage can be suppressed.

The polymerization reaction is preferably performed in an inert gas atmosphere such as nitrogen or argon. As for the polymerization initiator, the polymerization is initiated using a commercially available radical initiator (e.g., azo-based initiator, peroxide). The radical initiator is preferably an azo-based initiator, and an azo-based initiator having an ester group, a cyano group or a carboxyl group is preferred. Preferred examples of the initiator include azobisisobutyronitrile, azobisdimethylvaleronitrile and dimethyl 2,2'-azobis(2-methylpropionate). The initiator is added additionally or in parts, if desired. After the completion of reaction, the reaction product is charged into a solvent, and the desired polymer is recovered by a method such as powder or solid recovery. The reaction concentration is from 5 to 50 mass%, preferably from 10 to 30 mass%, and the reaction temperature is usually from 10 to 150°C, preferably from 30 to 120°C, more preferably from 60 to 100°C.

After the completion of reaction, the reaction solution is allowed to cool to room temperature and purified. The purification may be performed by a normal method, for example, a liquid-liquid extraction method of applying water washing or combining an appropriate solvent to remove residual monomers or oligomer components; a purification method in a solution sate, such as ultrafiltration of removing by extraction only those having a molecular weight not more than a specific value; a reprecipitation method of adding dropwise the resin solution in a poor solvent to solidify the resin in the poor solvent and thereby remove residual monomers and the like; and a purification method in a solid state, such as a method of subjecting a resin slurry separated by filtration to washing with a poor solvent. For example, the resin is precipitated as a solid by contacting the reaction solution with a solvent in which the resin is sparingly soluble or insoluble (poor solvent) and which is in a volumetric amount of 10 times or less, preferably from 10 to 5 times, the reaction solution.

The solvent used at the operation of precipitation or reprecipitation from the polymer solution (precipitation or reprecipitation solvent) may be sufficient if it is a poor solvent to the polymer, and the solvent may be appropriately

selected, for example, from a hydrocarbon, a halogenated hydrocarbon, a nitro compound, an ether, a ketone, an ester, a carbonate, an alcohol, a carboxylic acid, water, and a mixed solvent containing such a solvent, according to the kind of the polymer. Among these solvents, a solvent containing at least an alcohol (particularly, methanol or the like) or water is preferred as the precipitation or reprecipitation solvent.

The amount used of the precipitation or reprecipitation solvent may be appropriately selected by taking into consideration the efficiency, yield and the like, but in general, the amount used is from 100 to 10,000 parts by mass, preferably from 200 to 2,000 parts by mass, more preferably from 300 to 1,000 parts by mass, per 100 parts by mass of the polymer solution.

The temperature at the precipitation or reprecipitation may be appropriately selected by taking into consideration the efficiency or operability but is usually on the order of 0 to 50°C, preferably in the vicinity of room temperature (for example, approximately from 20 to 35°C). The precipitation or reprecipitation operation may be performed using a commonly employed mixing vessel such as stirring tank, by a known method such as batch system and continuous system.

The precipitated or reprecipitated polymer is usually subjected to commonly employed solid-liquid separation such as filtration and centrifugation, then dried and used. The filtration is performed using a solvent-resistant filter element preferably under pressure. The drying is performed under atmospheric pressure or reduced pressure (preferably under reduced pressure) at a temperature of approximately from 30 to 100°C, preferably on the order of 30 to 50°C.

Incidentally, after the resin is once precipitated and separated, the resin may be again dissolved in a solvent and then put into contact with a solvent in which the resin is sparingly soluble or insoluble. That is, there may be used a method comprising, after the completion of polymerization reaction above, bringing the polymer into contact with a solvent in which the polymer is sparingly soluble or insoluble, to precipitate a resin (step a), separating the resin from the solution (step b), anew dissolving the resin in a solvent to prepare a resin solution A (step c), bringing the resin solution A into contact with a solvent in which the resin is sparingly soluble or insoluble and which is in a volumetric amount of less than 10 times (preferably 5 times or less) the resin solution A, to precipitate a resin solid (step d), and separating the precipitated resin (step e).

The weight average molecular weight of the resin (A) is preferably from 1,000 to 200,000, more preferably from 2,000 to 20,000, still more preferably from 3,000 to 15,000, yet still more preferably from 3,000 to 10,000, in terms of polystyrene by the GPC method. When the weight average molecular weight is from 1,000 to 200,000, this is preferred from the standpoint of preventing deterioration of the heat resistance, dry etching resistance and developability and preventing the film-forming property from deteriorating due to increase in the viscosity.

The polydispersity (molecular weight distribution) is usually from 1 to 3, preferably from 1 to 2.6, more preferably from 1 to 2, still more preferably from 1.4 to 1.7. As the molecular weight distribution is smaller, the resolution and resist profile are more excellent, the side wall of the resist pattern is smoother, and the roughness is more improved.

In the positive tone resist composition of the present invention, the amount of the resin (A) blended in the entire composition is preferably from 50 to 99.9 mass%, more preferably from 60 to 99.0 mass%, based on the entire solid content.

As regards the resin (A) for use in the present invention, one kind may be used or a plurality of kinds may be used in combination.

Specific examples of the polymer which can be used in the present invention are set forth below, but the present invention is not limited thereto.

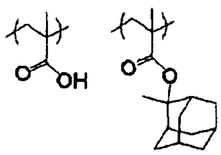

(RP-1)

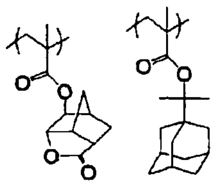

(RP-2)

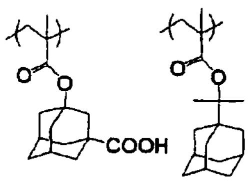

(RP-3)

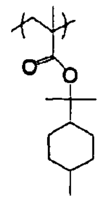

(RP-4)

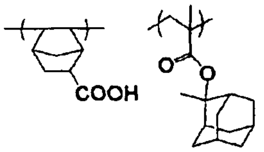

(RP-5)

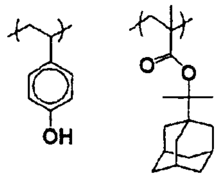

(RP-6)

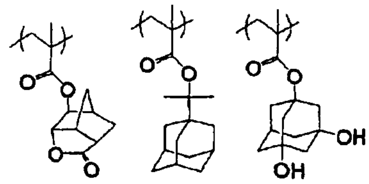

(RP-7)

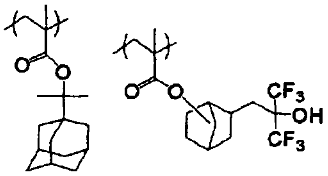

(RP-8)

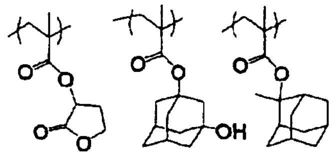

(RP-9)

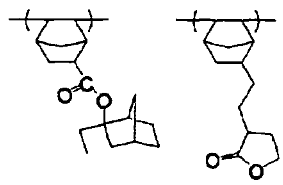

(RP-10)

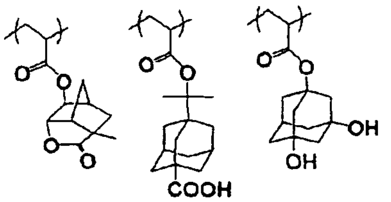

(RP-11)

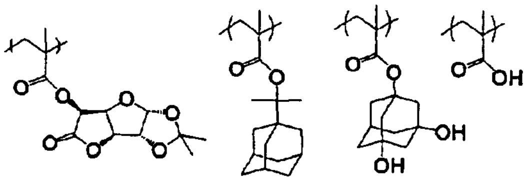

(RP-12)

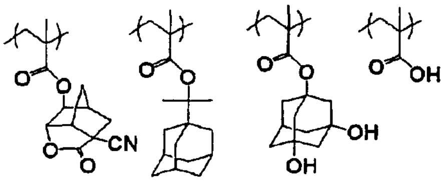

(RP-13)

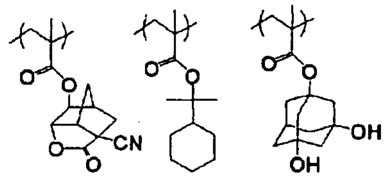

(RP-14)

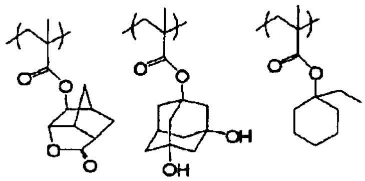

(RP-15)

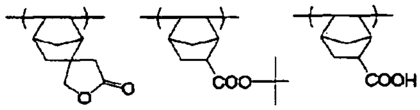

(RP-16)

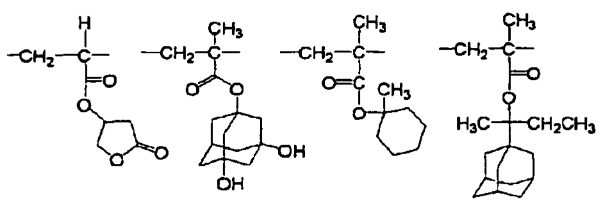

(RP-17)

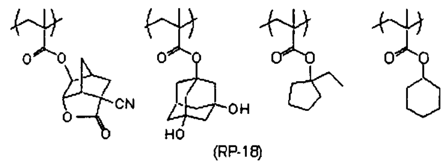

(RP-18)

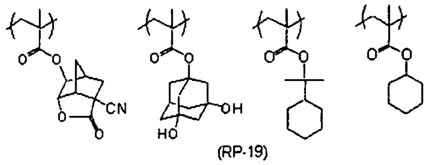

(RP-19)

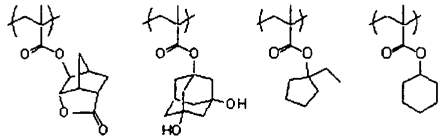

(RP-20)

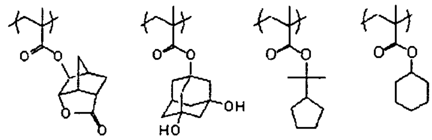

(RP-21)

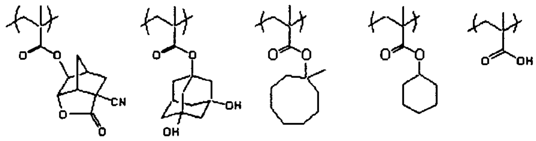

(RP-22)

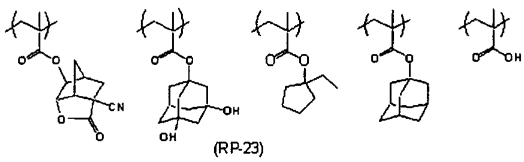

(RP-23)

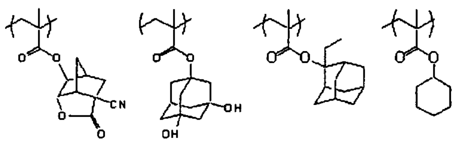

(RP-24)

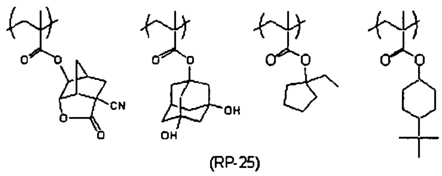

(RP-25)

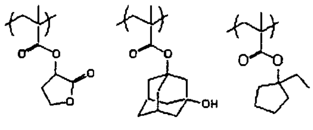

(RP-26)

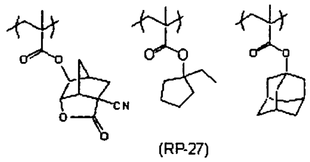

(RP-27)

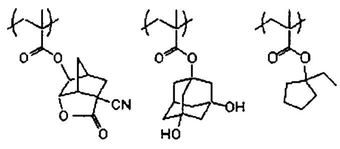

(RP-28)

The positive tone resist composition of the present invention preferably contains (B) a resin having at least either a fluorine atom or a silicon atom.

Particularly, in the case of immersion exposure, the resin (B) is preferably contained, and a resin (HR) described later in regard to the immersion exposure may also be preferably used.

In the resin (B), the fluorine atom or silicon atom may be present in the main chain of the resin or may be substituted on the side chain.

The resin (B) is preferably a resin having a fluorine atom-containing alkyl group, a fluorine atom-containing cycloalkyl group or a fluorine atom-containing aryl group, as a fluorine atom-containing partial structure.

In the case where the resin (B) contains a fluorine atom, the fluorine atom content is preferably from 5 to 80 mass%, more preferably from 10 to 80 mass%, based on the molecular weight of the resin (B). Also, the fluorine atom-containing repeating unit preferably occupies from 10 to 100 mass%, more preferably from 30 to 100 mass%, in the resin (B).

The resin (B) is preferably a resin having an alkylsilyl structure (preferably a trialkylsilyl group) or a cyclic siloxane structure, as a silicon atom-containing partial structure.

In the case where the resin (B) contains a silicon atom, the silicon atom content is preferably from 2 to 50 mass%, more preferably from 2 to 30 mass%, based on the molecular weight of the resin (B). Also, the silicon atom-containing repeating unit preferably occupies from 10 to 100 mass%, more preferably from 20 to 100 mass%, in the resin (B).

Specific examples of the resin (B) are set forth below, but the present invention is not limited thereto.

In (T-01) and (T-04) below, X represents a hydrogen atom, a methyl group, a fluorine atom or a trifluoromethyl group.

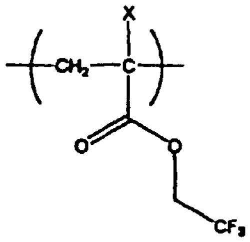

(T-01)

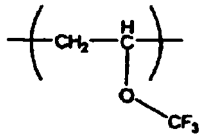

(T-02)

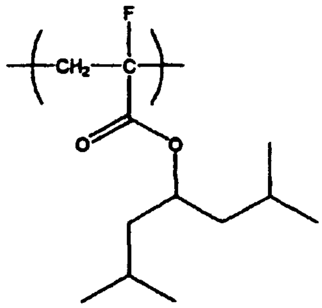

(T-03)

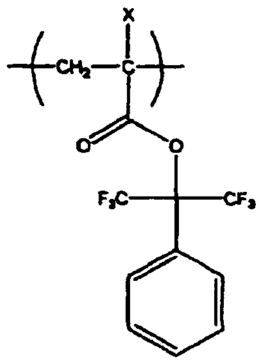

(T-04)

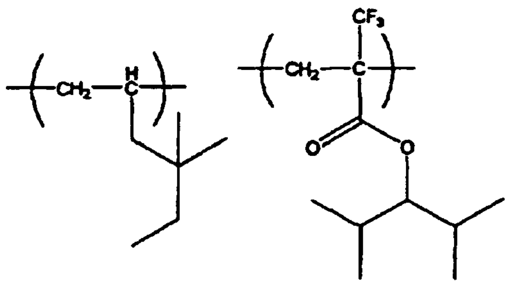

(T-05)

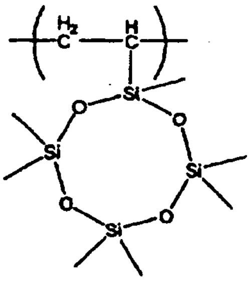

(T-06)

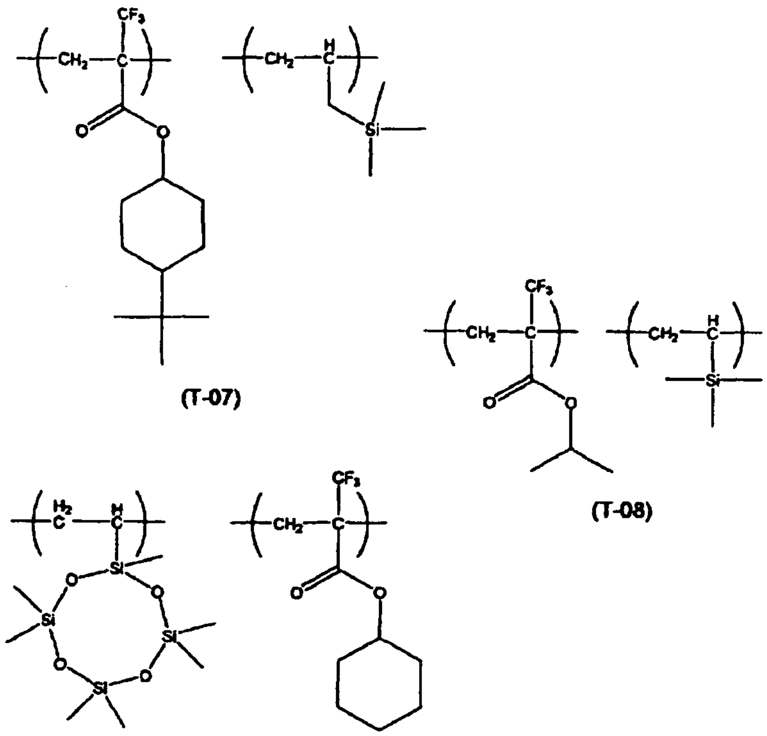

(T-07)

(T-08)

(T-09)

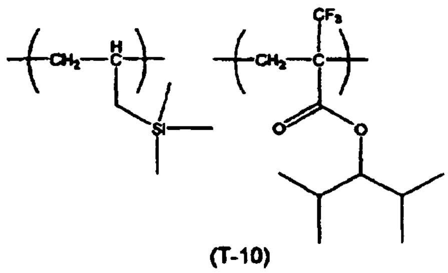

(T-10)

The resin (B) is preferably stable to an acid and insoluble in an alkali developer.

In view of followability of immersion liquid, the resin (B) preferably contains none of (x) an alkali-soluble group, (y) a group capable of decomposing by the action of an alkali (alkali developer) to increase the solubility in an alkali developer, and (z) a group capable of decomposing by the action of an acid to increase the solubility in a developer.

In the resin (B), the total amount of repeating units having an alkali-soluble group or a group whose solubility in a developer increases by the action of an acid or alkali is preferably 20 mol% or less, more preferably from 0 to 10 mol%, still more preferably from 0 to 5 mol%, based on all repeating units constituting the resin (B).

Also, unlike a surfactant generally used for resists, the resin (B) does not have an ionic bond or a hydrophilic group such as (poly(oxyalkylene)) group. If the resin (B) contains a hydrophilic polar group, the followability of immersion water tends to decrease. Therefore, it is more preferred not to contain a polar group selected from a hydroxyl group, alkylene glycols and a sulfone group. Furthermore, an ether group bonded to the carbon atom of the main chain through a linking group is preferably not contained because the hydrophilicity increases and the followability of immersion liquid deteriorates. On the other hand, an ether group bonded directly to the carbon atom of the main chain can sometimes express activity as a hydrophobic group and is preferred.

The standard polystyrene-reduced weight average molecular of the resin (B) is preferably from 1,000 to 100,000, more preferably from 1,000 to 50,000, still more preferably from 2,000 to 15,000, yet still more preferably from 3,000 to 15,000.

The residual monomer amount in the resin (B) is preferably from 0 to 10 mass%, more preferably from 0 to 5 mass%, still more preferably from 0 to 1 mass%. Also, in view of resolution, resist profile, and side wall, roughness or the like of the resist pattern, the molecular weight distribution (Mw/Mn, also called polydispersity) is preferably from 1 to 5, more preferably from 1 to 3, still more preferably from 1 to 1.5.

The amount added of the resin (B) in the positive tone resist composition is preferably from 0.1 to 20 mass%, more preferably from 0.1 to 10 mass%, still more preferably from 0.1 to 5 mass%, even still more preferably from 0.2 to

3.0 mass%, yet even still more preferably from 0.3 to 2.0 mass%, based on the entire solid content of the resist composition.

As for the resin (B), various commercially available products may be used or the resin may be synthesized by an ordinary method (for example, radical polymerization).

[2] Compound capable of generating an acid upon irradiation with an actinic ray or radiation

The positive tone resist composition of the present invention contains a compound capable of generating an acid upon irradiation with an actinic ray or radiation (hereinafter sometimes referred to as an "acid generator").

The acid generator which can be used may be appropriately selected from a photo-initiator for cationic photopolymerization, a photo-initiator for radical photopolymerization, a photo-decoloring agent for dyes, a photo-discoloring agent, a compound known to generate an acid upon irradiation with an actinic ray or radiation and used for microresist or the like, and a mixture thereof.

Examples thereof include a diazonium salt, a phosphonium salt, a sulfonium salt, an iodonium salt, an imidosulfonate, an oxime sulfonate, a diazodisulfone, a disulfone and an o-nitrobenzyl sulfonate.

Also, a compound where such a group or compound capable of generating an acid upon irradiation with an actinic ray or radiation is introduced into the main or side chain of the polymer, for example, compounds described in U.S. Patent 3,849,137, German Patent 3,914,407, JP-A-63-26653, JP-A-55-164824, JP-A-62-69263, JP-A-63-146038, JP-A-63-163452, JP-A-62-153853 and JP-A-63-146029, may be used.

Furthermore, compounds capable of generating an acid by the effect of light described, for example, in U.S. Patent 3,779,778 and European Patent 126,712 may also be used.

Out of the acid generators, compounds represented by the following formulae (ZI), (ZII) and (ZIII) are preferred.

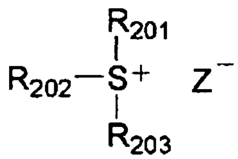

ZI

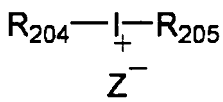

ZII

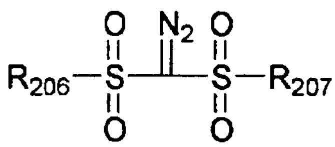

ZIII

In formula (ZI), each of $R_{201}$, $R_{202}$ and $R_{203}$ independently represents an organic group.

The number of carbons in the organic group as $R_{201}$, $R_{202}$ and $R_{203}$ is generally from 1 to 30, preferably from 1 to 20.

Two members out of $R_{201}$ to $R_{203}$ may combine to form a ring structure, and the ring may contain an oxygen atom, a sulfur atom, an ester bond, an amide bond or a carbonyl group. Examples of the group formed by combining two members out of $R_{201}$ to $R_{203}$ include an alkylene group (e.g., butylene, pentylene).

$Z^-$ represents a non-nucleophilic anion.

Examples of the non-nucleophilic anion as $Z^-$ include sulfonate anion, carboxylate anion, sulfonylimide anion, bis(alkylsulfonyl)imide anion and tris(alkylsulfonyl)methide anion.

The non-nucleophilic anion is an anion having an extremely low ability of causing a nucleophilic reaction and this anion can suppress the decomposition with aging due to intramolecular nucleophilic reaction. Thanks to this anion, the aging stability of the resist is enhanced.

Examples of the sulfonate anion include an aliphatic sulfonate anion, an aromatic sulfonate anion and a camphorsulfonate anion.

Examples of the carboxylate anion include an aliphatic carboxylate anion, an aromatic carboxylate anion and an aralkylcarboxylate anion.

The aliphatic moiety in the aliphatic sulfonate anion may be an alkyl group or a cycloalkyl group but is preferably an alkyl group having a carbon number of 1 to 30 or a cycloalkyl group having a carbon number of 3 to 30, and examples thereof include a methyl group, an ethyl group, a propyl group, an isopropyl group, an n-butyl group, an isobutyl group, a sec-butyl group, a pentyl group, a neopentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group, an eicosyl group, a cyclopropyl group, a cyclopentyl group, a cyclohexyl group, an adamantyl group, a norbornyl group and a boronyl group.

The aromatic group in the aromatic sulfonate anion is preferably an aryl group having a carbon number of 6 to 14, and examples thereof include a phenyl group, a tolyl group and a naphthyl group.

The alkyl group, cycloalkyl group and aryl group in the aliphatic sulfonate anion and aromatic sulfonate anion may have a substituent. Examples of the substituent of the alkyl group, cycloalkyl group and aryl group in the aliphatic sulfonate anion and aromatic sulfonate anion include a nitro group, a halogen atom (e.g., fluorine, chlorine, bromine, iodine), a carboxyl group, a hydroxyl group, an amino group, a cyano group, an alkoxy group (preferably having a carbon number of 1 to 15), a cycloalkyl group (preferably having a carbon number of 3 to 15), an aryl group (preferably having a carbon number of 6 to 14), an alkoxycarbonyl group (preferably having a carbon number of 2 to 7), an acyl group (preferably having a carbon number of 2 to 12), an alkoxycarbonyloxy group (preferably having a carbon number of 2 to 7), an alkylthio group (preferably having a carbon number of 1 to 15), an alkylsulfonyl group (preferably having a carbon number of 1 to 15), an alkyliminosulfonyl group (preferably having a carbon number of 2 to 15), an aryloxysulfonyl group (preferably having a carbon number of 6 to 20), an alkylaryloxysulfonyl group (preferably having a carbon number of 7 to 20), a cycloalkylaryloxysulfonyl group (preferably having a carbon number of 10 to 20), an alkyloxyalkyloxy group (preferably having a carbon number of 5 to 20), and a cycloalkylalkyloxyalkyloxy group (preferably having a carbon number of 8 to 20). As for the aryl group or ring structure in each group, examples of the substituent further include an alkyl group (preferably having a carbon number of 1 to 15).

Examples of the aliphatic moiety in the aliphatic carboxylate anion include the same alkyl group and cycloalkyl group as those in the aliphatic sulfonate anion.

Examples of the aromatic group in the aromatic carboxylate anion include the same aryl group as those in the aromatic sulfonate anion.

The aralkyl group in the aralkylcarboxylate anion is preferably an aralkyl group having a carbon number of 6 to 12, and examples thereof include a benzyl group, a phenethyl group, a naphthylmethyl group, a naphthylethyl group and a naphthylmethyl group.

The alkyl group, cycloalkyl group, aryl group and aralkyl group in the aliphatic carboxylate anion, aromatic carboxylate anion and aralkylcarboxylate anion may have a substituent. Examples of the substituent of the alkyl group, cycloalkyl group, aryl group and aralkyl group in the aliphatic carboxylate anion, aromatic carboxylate anion and aralkylcarboxylate anion include the same halogen atom, alkyl group, cycloalkyl group, alkoxy group and alkylthio group as those in the aromatic sulfonate anion.

Examples of the sulfonylimide anion include saccharin anion.

The alkyl group in the bis(alkylsulfonyl)imide anion and tris(alkylsulfonyl)methide anion is preferably an alkyl group having a carbon number of 1 to 5, and examples thereof include a methyl group, an ethyl group, a propyl group, an isopropyl group, an n-butyl group, an isobutyl group, a sec-butyl group, a pentyl group and a neopentyl group. Examples of the substituent of such an alkyl group include a halogen atom, a halogen atom-substituted alkyl group, an alkoxy group, an alkylthio group, an alkyloxysulfonyl group, an aryloxysulfonyl group, and a cycloalkylaryloxysulfonyl group, with a fluorine atom-substituted alkyl group being preferred.

Other examples of the non-nucleophilic anion include fluorinated phosphorus, fluorinated boron and fluorinated antimony.

The non-nucleophilic anion of $Z^-$ is preferably an aliphatic sulfonate anion substituted by a fluorine atom at the $\alpha$-position of the sulfonic acid, an aromatic sulfonate anion substituted by a fluorine atom or a fluorine atom-containing group, a bis(alkylsulfonyl)imide anion with the alkyl group being substituted by a fluorine atom, or a tris(alkylsulfonyl)methide anion with the alkyl group being substituted by a fluorine atom. The non-nucleophilic anion is more preferably a perfluoroaliphatic sulfonate anion having a carbon number of 4 to 8, a benzenesulfonate anion having a fluorine atom, a bis(alkylsulfonyl)imide anion with the alkyl group being substituted by a fluorine atom, or a tris(alkylsulfonyl)methide anion with the alkyl group being substituted by a fluorine atom.

Examples of the organic group as $R_{201}$, $R_{202}$ and $R_{203}$ include the corresponding groups in the compounds (ZI-1), (ZI-2) and (ZI-3) described later.

The compound may be a compound having a plurality of structures represented by formula (ZI), for example, may be a compound having a structure where at least one of $R_{201}$ to $R_{203}$ in the compound represented by formula (ZI) is bonded to at least one of $R_{201}$ to $R_{203}$ in another compound represented by formula (ZI).

The component (ZI) is more preferably a compound (ZI-1), (ZI-2) or (ZI-3) described below.

The compound (ZI-1) is an arylsulfonium compound where at least one of $R_{201}$ to $R_{203}$ in formula (ZI) is an aryl group, that is, a compound having arylsulfonium as the cation.

In the arylsulfonium compound, all of $R_{201}$ to $R_{203}$ may be an aryl group or a part of $R_{201}$ to $R_{203}$ may be an aryl group with the remaining being an alkyl group or a cycloalkyl group.

Examples of the arylsulfonium compound include a triarylsulfonium compound, a diarylalkylsulfonium compound, an aryldialkylsulfonium compound, a diarylcycloalkylsulfonium compound and an aryldicycloalkylsulfonium compound.

The aryl group in the arylsulfonium compound is preferably a phenyl group or a naphthyl group, more preferably a phenyl group. The aryl group may be an aryl group having a heterocyclic structure containing an oxygen atom, a nitrogen atom, a sulfur atom or the like. Examples of the aryl group having a heterocyclic structure include a pyrrole

residue (a group formed by removing one hydrogen atom from a pyrrole), a furan residue (a group formed by removing one hydrogen atom from a furan), a thiophene residue (a group formed by removing one hydrogen atom from a thiophene), an indole residue (a group formed by removing one hydrogen atom from an indole), a benzofuran residue (a group formed by removing one hydrogen atom from a benzofuran) and a benzothiophene residue (a group formed by removing one hydrogen atom from a benzothiophene). In the case where the arylsulfonium compound has two or more aryl groups, these two or more aryl groups may be the same or different.

The alkyl or cycloalkyl group which is present, if desired, in the arylsulfonium compound is preferably a linear or branched alkyl group having a carbon number of 1 to 15 or a cycloalkyl group having a carbon number of 3 to 15, and examples thereof include a methyl group, an ethyl group, a propyl group, an n-butyl group, a sec-butyl group, a tert-butyl group, a cyclopropyl group, a cyclobutyl group and a cyclohexyl group.

The aryl group, alkyl group and cycloalkyl group of $R_{201}$ to $R_{203}$ may have, as the substituent, an alkyl group (for example, an alkyl group having a carbon number of 1 to 15), a cycloalkyl group (for example, a cycloalkyl group having a carbon number of 3 to 15), an aryl group (for example, an aryl group having a carbon number of 6 to 14), an alkoxy group (for example, an alkoxy group having a carbon number of 1 to 15), a halogen atom, a hydroxyl group or a phenylthio group. The substituent is preferably a linear or branched alkyl group having a carbon number of 1 to 12, a cycloalkyl group having a carbon number of 3 to 12, or a linear, branched or cyclic alkoxy group having a carbon number of 1 to 12, more preferably an alkyl group having a carbon number of 1 to 4, or an alkoxy group having a carbon number of 1 to 4. The substituent may be substituted to any one of three members $R_{201}$ to $R_{203}$ or may be substituted to all of these three members. In the case where $R_{201}$ to $R_{203}$ are an aryl group, the substituent is preferably substituted at the p-position of the aryl group.

The compound (ZI-2) is described below.

The compound (ZI-2) is a compound where each of $R_{201}$ to $R_{203}$ in formula (ZI) independently represents an aromatic ring-free organic group. The aromatic ring as used herein includes an aromatic ring containing a heteroatom.

The aromatic ring-free organic group as $R_{201}$ to $R_{203}$ has a carbon number of generally from 1 to 30, preferably from 1 to 20.

Each of $R_{201}$ to $R_{203}$ independently represents preferably an alkyl group, a cycloalkyl group, an allyl group or a vinyl group, more preferably a linear or branched 2-oxoalkyl group, a 2-oxocycloalkyl group or an alkoxycarbonylmethyl group, still more preferably a linear or branched 2-oxoalkyl group.

The alkyl group and cycloalkyl group of $R_{201}$ to $R_{203}$ are preferably a linear or branched alkyl group having a carbon number of 1 to 10 (e.g., methyl, ethyl, propyl, butyl, pentyl) and a cycloalkyl group having a carbon number of 3 to 10 (e.g., cyclopentyl, cyclohexyl, norbornyl). The alkyl group is more preferably a 2-oxoalkyl group or an alkoxycarbonylmethyl group. The cycloalkyl group is more preferably a 2-oxocycloalkyl group.

The 2-oxoalkyl group may be either linear or branched and is preferably a group having >C=O at the 2-position of the above-described alkyl group.

The 2-oxocycloalkyl group is preferably a group having >C=O at the 2-position of the above-described cycloalkyl group.

The alkoxy group in the alkoxycarbonylmethyl group is preferably an alkoxy group having a carbon number of 1 to 5 (e.g., methoxy, ethoxy, propoxy, butoxy, pentoxy).

Each of $R_{201}$ to $R_{203}$ may be further substituted by a halogen atom, an alkoxy group (for example, an alkoxy group having a carbon number of 1 to 5), a hydroxyl group, a cyano group or a nitro group.

The compound (ZI-3) is described below.

The compound (ZI-3) is a compound represented by the following formula (ZI-3), and this is a compound having a phenacylsulfonium salt structure.

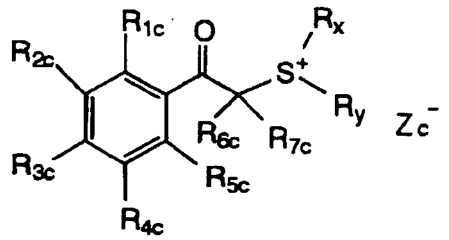
(ZI-3)

In formula (ZI-3), each of $R_{1c}$ to $R_{5c}$ independently represents a hydrogen atom, an alkyl group, a cycloalkyl group, an alkoxy group or a halogen atom.

Each of $R_{6c}$ and $R_{7c}$ independently represents a hydrogen atom, an alkyl group or a cycloalkyl group.

Each of $R_x$ and Ry independently represents an alkyl group, a cycloalkyl group, an allyl group or a vinyl group.

Any two or more members out of $R_{1c}$ to $R_{5c}$, a pair of $R_{6c}$ and $R_{7c}$, and a pair of $R_x$ and Ry may combine together to form a ring structure respectively. This ring structure may contain an oxygen atom, a sulfur atom, an ester bond or an amido bond. Examples of the group formed by combining any two or more members out of $R_{1c}$ to $R_{5c}$, a pair of $R_{6c}$ and $R_{7c}$, or a pair of $R_x$ and Ry include a butylene group and a pentylene group.

$Z_c^-$ represents a non-nucleophilic anion, and examples thereof are the same as those of the non-nucleophilic anion of $Z^-$ in formula (ZI).

The alkyl group as $R_{1c}$ to $R_{7c}$ may be either linear or branched and is, for example, an alkyl group having a carbon number of 1 to 20, preferably a linear or branched alkyl group having a carbon number of 1 to 12 (e.g., methyl, ethyl, linear or branched propyl, linear or branched butyl, linear or branched pentyl). The cycloalkyl group is, for example, a cycloalkyl group having a carbon number of 3 to 8 (e.g., cyclopentyl, cyclohexyl).

The alkoxy group as $R_{1c}$ to $R_{5c}$ may be linear, branched or cyclic and is, for example, an alkoxy group having a carbon number of 1 to 10, preferably a linear or branched alkoxy group having a carbon number of 1 to 5 (e.g., methoxy, ethoxy, linear or branched propoxy, linear or branched butoxy, linear or branched pentoxy) or a cyclic alkoxy group having a carbon number of 3 to 8 (e.g., cyclopentyloxy, cyclohexyloxy).

A compound where any one of $R_{1c}$ to $R_{5c}$ is a linear or branched alkyl group, a cycloalkyl group or a linear, branched or cyclic alkoxy group is preferred, and a compound where the sum of carbon numbers of $R_{1c}$ to $R_{5c}$ is from 2 to 15 is more preferred. Thanks to such a compound, the solvent solubility is more enhanced and production of particles during storage can be suppressed.

Examples of the alkyl group and cycloalkyl group as $R_x$ and Ry are the same as those of the alkyl group and cycloalkyl group in $R_{1c}$ to $R_{7c}$. Among these, a 2-oxoalkyl group, a 2-oxocycloalkyl group and an alkoxycarbonylmethyl group are preferred.

Examples of the 2-oxoalkyl group and 2-oxocycloalkyl group include a group having >C=O at the 2-position of the alkyl group or cycloalkyl group as $R_{1c}$ to $R_{7c}$.

Examples of the alkoxy group in the alkoxycarbonylmethyl group are the same as those of the alkoxy group in $R_{1c}$ to $R_{5c}$.

Each of $R_x$ and Ry is preferably an alkyl or cycloalkyl group having a carbon number of 4 or more, more preferably 6 or more, still more preferably 8 or more.

Formulae (ZII) and (ZIII) are described below.

In formulae (ZII) and (ZIII), each of $R_{204}$ to $R_{207}$ independently represents an aryl group, an alkyl group or a cycloalkyl group.

The aryl group of $R_{204}$ to $R_{207}$ is preferably a phenyl group or a naphthyl group, more preferably a phenyl group. The aryl group of $R_{204}$ to $R_{207}$ may be an aryl group having a heterocyclic structure containing an oxygen atom, a nitrogen atom, a sulfur atom or the like. Examples of the aryl group having a heterocyclic structure include a pyrrole residue (a group formed by removing one hydrogen atom from a pyrrole), a furan residue (a group formed by removing one hydrogen atom from a furan), a thiophene residue (a group formed by removing one hydrogen atom from a thiophene), an indole residue (a group formed by removing one hydrogen atom from an indole), a benzofuran residue (a group formed by removing one hydrogen atom from a benzofuran) and a benzothiophene residue (a group formed by removing one hydrogen atom from a benzothiophene).

The alkyl group and cycloalkyl group in $R_{204}$ to $R_{207}$ are preferably a linear or branched alkyl group having a carbon number of 1 to 10 (e.g., methyl, ethyl, propyl, butyl, pentyl) and a cycloalkyl group having a carbon number of 3 to 10 (e.g., cyclopentyl, cyclohexyl, norbornyl).

The aryl group, alkyl group and cycloalkyl group of $R_{204}$ to $R_{207}$ may have a substituent. Examples of the substituent which the aryl group, alkyl group and cycloalkyl group of $R_{204}$ to $R_{207}$ may have include an alkyl group (for example, an alkyl group having a carbon number of 1 to 15), a cycloalkyl group (for example, a cycloalkyl group having a carbon number of 3 to 15), an aryl group (for example, an aryl group having a carbon number of 6 to 15), an alkoxy group (for example, an alkoxy group having a carbon number of 1 to 15), a halogen atom, a hydroxyl group and a phenylthio group.

$Z^-$ represents a non-nucleophilic anion, and examples thereof are the same as those of the non-nucleophilic anion of $Z^-$ in formula (ZI).

Other examples of the acid generator include compounds represented by the following formulae (ZIV), (ZV) and (ZVI):

$$Ar_3\text{-}SO_2\text{-}SO_2\text{-}Ar_4 \qquad \text{ZIV}$$

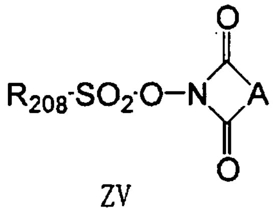

ZV

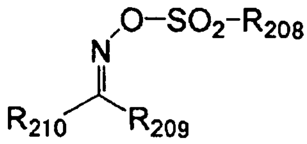

ZVI

In formulae (ZIV) to (ZVI), each of $Ar_3$ and $Ar_4$ independently represents an aryl group.

Each of $R_{208}$, $R_{209}$ and $R_{210}$ independently represents an alkyl group, a cycloalkyl group or an aryl group.

A represents an alkylene group, an alkenylene group or an arylene group.

Among the acid generators, more preferred are the compounds represented by formulae (ZI) to (ZIII).

The acid generator is preferably a compound capable of generating an acid having one sulfonic acid group or imide group, more preferably a compound capable of generating a monovalent perfluoroalkanesulfonic acid, a compound capable of generating a monovalent aromatic sulfonic acid substituted by a fluorine atom or a fluorine atom-containing group, or a compound capable of generating a monovalent imide acid substituted by a fluorine atom or a fluorine atom-containing group, still more preferably a sulfonium salt of fluoro-substituted alkanesulfonic acid, fluorine-substituted benzenesulfonic acid, fluorine-substituted imide acid or fluorine-substituted methide acid. In the acid generator which can be used, the acid generated is preferably a fluoro-substituted alkanesulfonic acid, fluoro-substituted benzenesulfonic acid or fluoro-substituted imide acid having a pKa of -1 or less, and in this case, the sensitivity can be enhanced.

Out of the acid generators, particularly preferred examples are set forth below, but the present invention is not limited thereto.

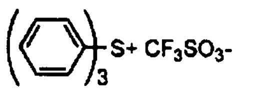

(z1)

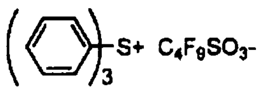

(z2)

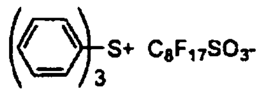

(z3)

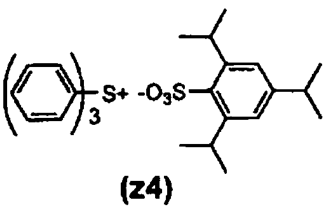

(z4)

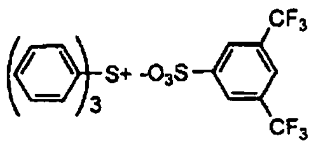

(z5)

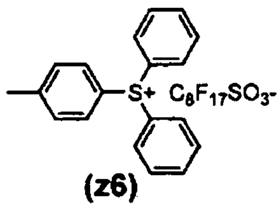

(z6)

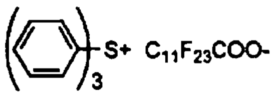

(z7)

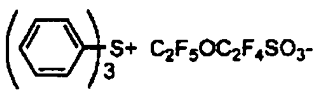

(z8)

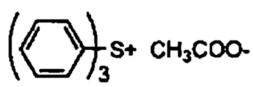

(z9)

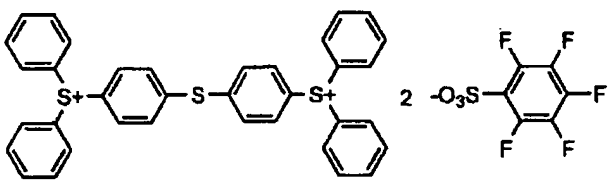

(z10)

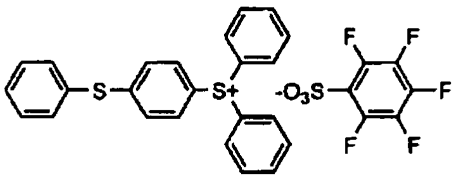

(z11)

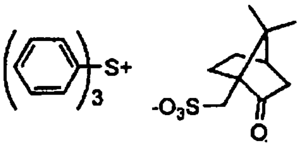

(z12)

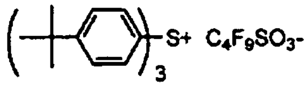

(z13)

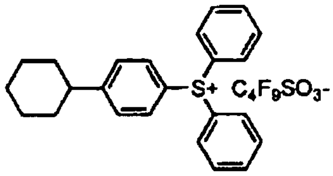

(z14)

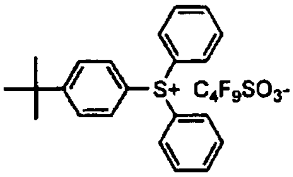

(z15)

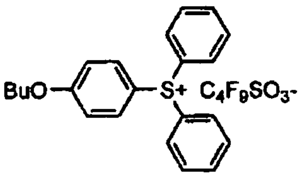

(z16)

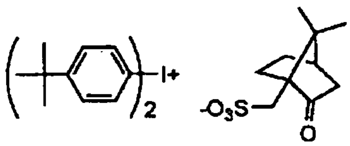

(z17)

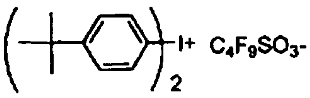

(z18)

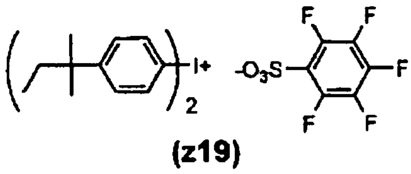

(z19)

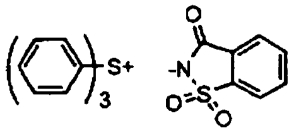

(z20)

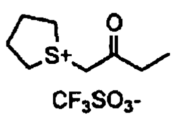

(z21)

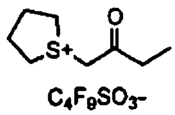

(z22)

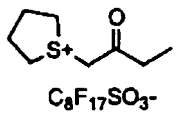

(z23)

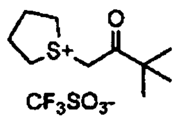

(z24)

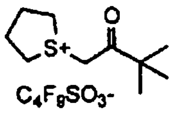

(z25)

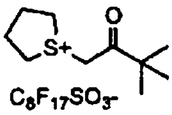

(z26)

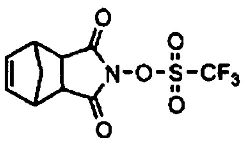

(z27)

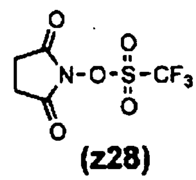

(z28)

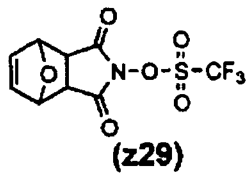

(z29)

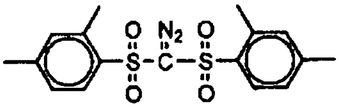
(z30)

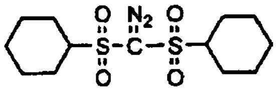
(z31)

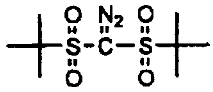
(z32)

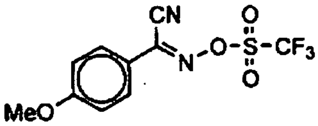
(z33)

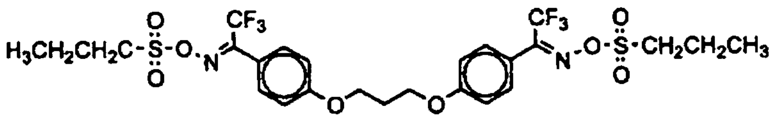
(z34)

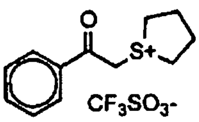
(z35)

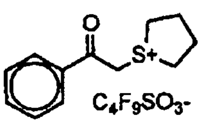
(z36)

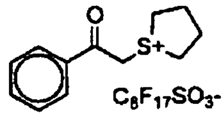
(z37)

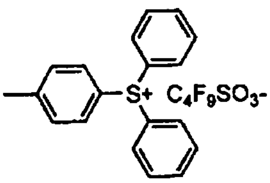
(z38)

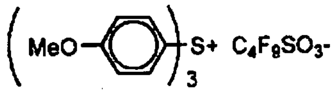
(z39)

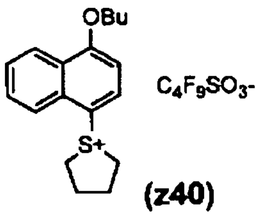
(z40)

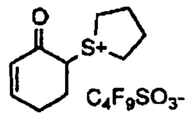
(z41)

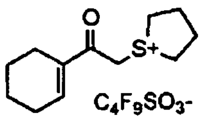
(z42)

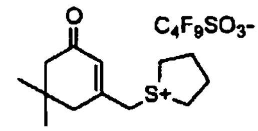
(z43)

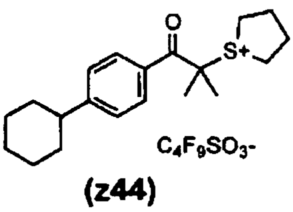
(z44)

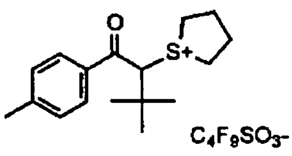
(z45)

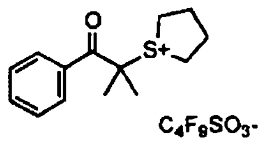
(z46)

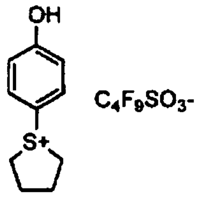
(z47)

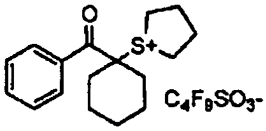
(z48)

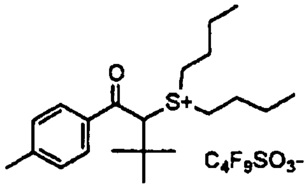
(z49)

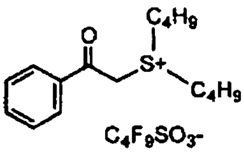
(z50)

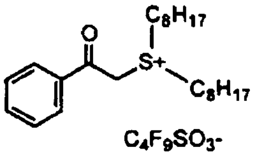
(z51)

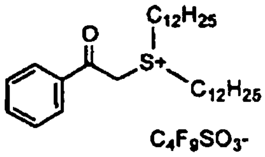
(z52)

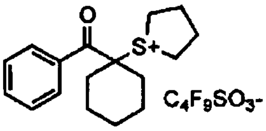
(z53)

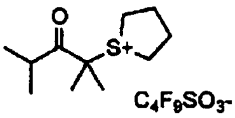
(z54)

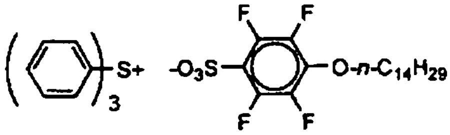
(z55)

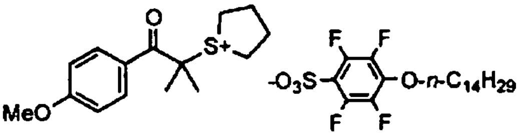
(z56)

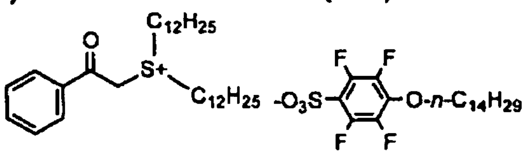
(z57)

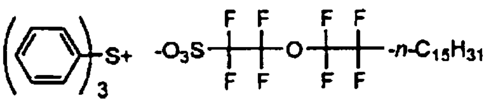
(z58)

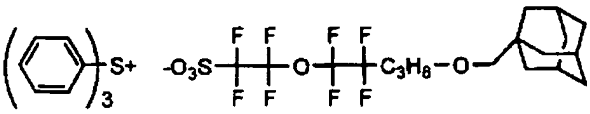
(z59)

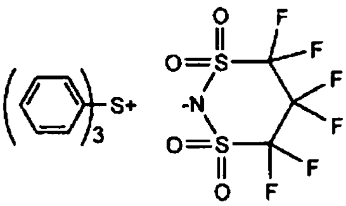
(z60)

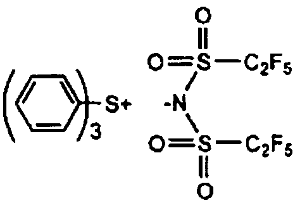
(z61)

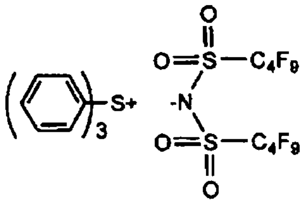
(z62)

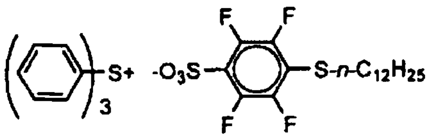

(z63)

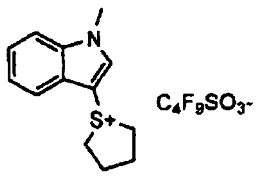

(z64)

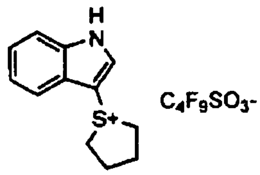

(z65)

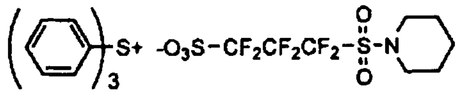

(z66)

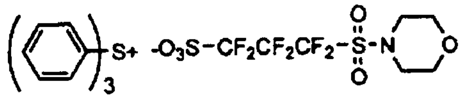

(z67)

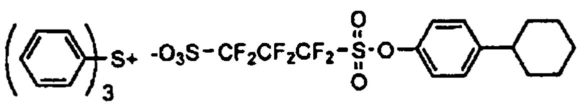

(z68)

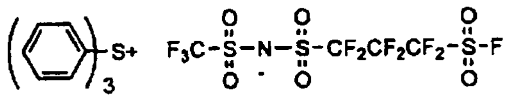

(z69)

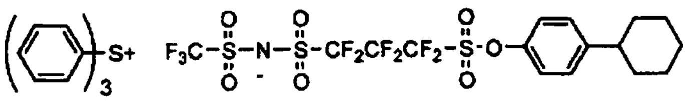

(z70)

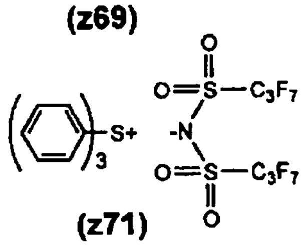

(z71)

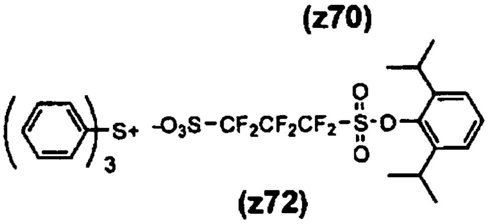

(z72)

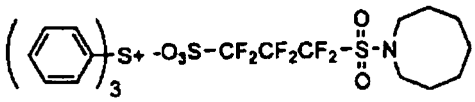

(z73)

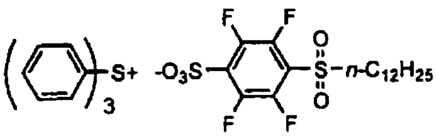

(z74)

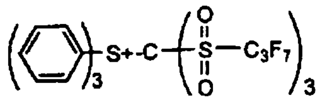

(z75)

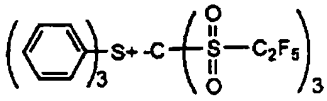

(z76)

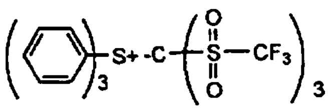

(z77)

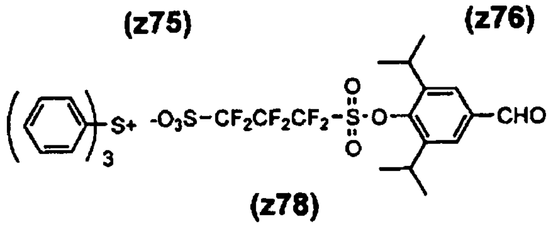

(z78)

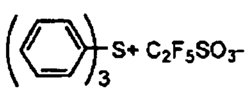

(z79)

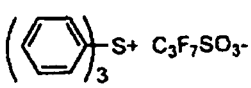

(z80)

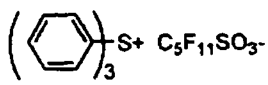

(z81)

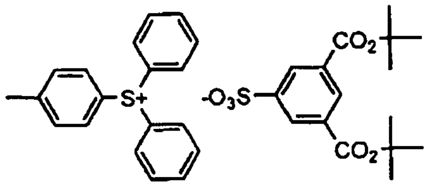

(z82)

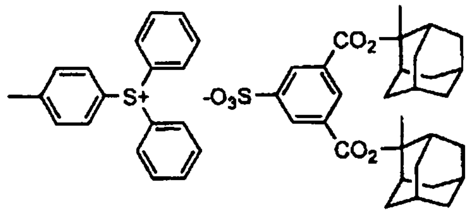

(z83)

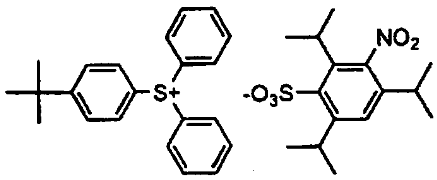

(z84)

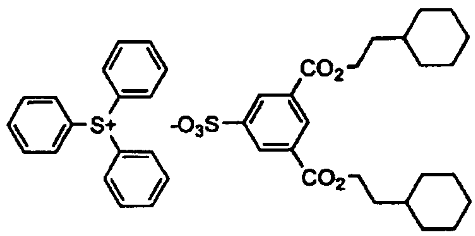

(z85)

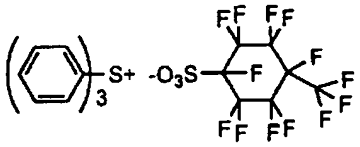

(z86)

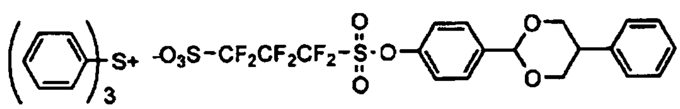

(z87)

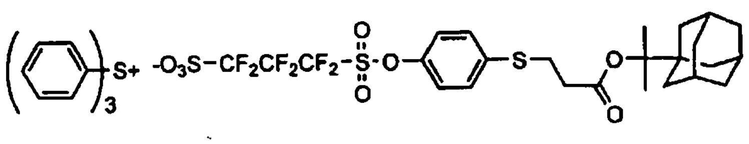

(z88)

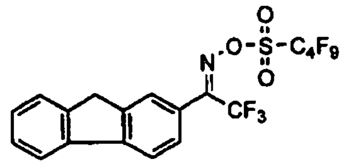

(z89)

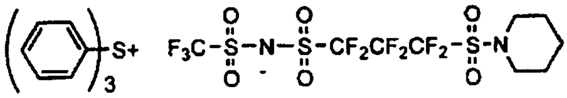

(z90)

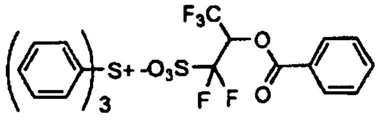

(z91)

One kind of an acid generator may be used alone, or two or more kinds of acid generators may be used in combination.

The content of the acid generator in the positive tone resist composition is preferably from 0.1 to 20 mass%, more preferably from 0.5 to 10 mass%, still more preferably from 1 to 7 mass%, based on the entire solid content of the positive tone resist composition.

[3] Basic compound

The positive tone resist composition of the present invention preferably contains a basic compound for reducing the change of performance with aging from exposure to heating.

Preferred examples of the basic compound include compounds having a structure represented by any one of the following formulae (A) to (E):

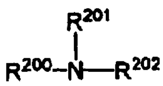

(A)

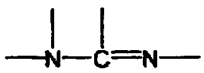

(B)

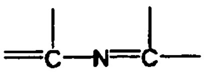

(C)

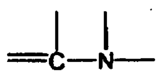

(D)

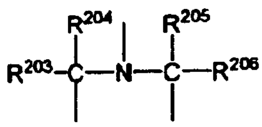

(E)

In formulae (A) and (E), each of $R^{200}$, $R^{201}$ and $R^{202}$, which may be the same or different, represents a hydrogen atom, an alkyl group (preferably having a carbon number of 1 to 20), a cycloalkyl group (preferably having a carbon number of 3 to 20) or an aryl group (having a carbon number of 6 to 20), and $R^{201}$ and $R^{202}$ may combine with each other to form a ring.

As for the alkyl group, the alkyl group having a substituent is preferably an aminoalkyl group having a carbon number of 1 to 20, a hydroxyalkyl group having a carbon number of 1 to 20, or a cyanoalkyl group having a carbon number of 1 to 20.

Each of $R^{203}$, $R^{204}$, $R^{205}$ and $R^{206}$, which may be the same or different, represents an alkyl group having a carbon number of 1 to 20.

The alkyl group in these formulae (A) and (E) is more preferably unsubstituted.

Preferred examples of the compound include guanidine, aminopyrrolidine, pyrazole, pyrazoline, piperazine, aminomorpholine, aminoalkylmorpholine and piperidine. More preferred examples of the compound include a compound having an imidazole structure, a diazabicyclo structure, an onium hydroxide structure, an onium carboxylate structure, a trialkylamine structure, an aniline structure or a pyridine structure; an alkylamine derivative having a hydroxyl group and/or an ether bond; and an aniline derivative having a hydroxyl group and/or an ether bond.

Examples of the compound having an imidazole structure include imidazole, 2,4,5-triphenylimidazole, benzimidazole and 2-phenylbenzimidazole. Examples of the compound having a diazabicyclo structure include 1,4-diazabicyclo[2,2,2]octane, 1,5-diazabicyclo[4,3,0]non-5-ene and 1,8-diazabicyclo[5,4,0]undec-7-ene. Examples of the compound having an onium hydroxide structure include tetrabutylammonium hydroxide, triarylsulfonium hydroxide, phenacylsulfonium hydroxide and sulfonium hydroxide having a 2-oxoalkyl group, specifically, triphenylsulfonium hydroxide, tris(tert-butylphenyl)sulfonium hydroxide, bis(tert-butylphenyl)iodonium hydroxide, phenacylthiophenium hydroxide and 2-oxopropylthiophenium hydroxide. Examples of the compound having an onium carboxylate structure include a compound where the anion moiety of the compound having an onium hydroxide structure becomes a carboxylate, such as acetate, adamantane-1-carboxylate and perfluoroalkyl carboxylate. Examples of the compound having a trialkylamine structure include tri(n-butyl)amine and tri(n-octyl)amine. Examples of the aniline compound include 2,6-diisopropylaniline, N,N-dimethylaniline, N,N-dibutylaniline and N,N-dihexylaniline. Examples of the alkylamine derivative having a hydroxyl group and/or an ether bond include ethanolamine, diethanolamine, triethanolamine, N-phenyldiethanolamine and tris(methoxyethoxyethyl)amine. Examples of the aniline derivative having a hydroxyl group and/or an ether bond include

N,N-bis(hydroxyethyl)aniline.

Other preferred basic compounds include a phenoxy group-containing amine compound, a phenoxy group-containing ammonium salt compound, a sulfonic acid ester group-containing amine compound and a sulfonic acid ester group-containing ammonium salt compound.

As for the amine compound, a primary, secondary or tertiary amine compound can be used, and an amine compound where at least one alkyl group is bonded to the nitrogen atom is preferred. The amine compound is more preferably a tertiary amine compound. In the amine compound, as long as at least one alkyl group (preferably having a carbon number of 1 to 20) is bonded to the nitrogen atom, a cycloalkyl group (preferably having a carbon number of 3 to 20) or an aryl group (preferably having a carbon number of 6 to 12) may be bonded to the nitrogen atom, in addition to the alkyl group. The amine compound preferably has an oxygen atom in the alkyl chain to form an oxyalkylene group. The number of oxyalkylene groups within the molecule is 1 or more, preferably from 3 to 9, more preferably from 4 to 6. Among oxyalkylene groups, an oxyethylene group ($-CH_2CH_2O-$) and an oxypropylene group ($-CH(CH_3)CH_2O-$ or $-CH_2CH_2CH_2O-$) are preferred, and an oxyethylene group is more preferred.

As for the ammonium salt compound, a primary, secondary, tertiary or quaternary ammonium salt compound can be used, and an ammonium salt compound where at least one alkyl group is bonded to the nitrogen atom is preferred. In the ammonium salt compound, as long as at least one alkyl group (preferably having a carbon number of 1 to 20) is bonded to the nitrogen atom, a cycloalkyl group (preferably having a carbon number of 3 to 20) or an aryl group (preferably having a carbon number of 6 to 12) may be bonded to the nitrogen atom, in addition to the alkyl group. The ammonium salt compound preferably has an oxygen atom in the alkyl chain to form an oxyalkylene group. The number of oxyalkylene groups within the molecule is 1 or more, preferably from 3 to 9, more preferably from 4 to 6. Among oxyalkylene groups, an oxyethylene group ($-CH_2CH_2O-$) and an oxypropylene group ($-CH(CH_3)CH_2O-$ or $-CH_2CH_2CH_2O-$) are preferred, and an oxyethylene group is more preferred.

Examples of the anion of the ammonium salt compound include a halogen atom, a sulfonate, a borate and a phosphate, with a halogen atom and a sulfonate being preferred. The halogen atom is preferably chloride, bromide or iodide, and the sulfonate is preferably an organic sulfonate having a carbon number of 1 to 20. The organic sulfonate includes an alkylsulfonate having a carbon number of 1 to 20 and an arylsulfonate. The alkyl group of the alkylsulfonate may have a substituent, and examples of the substituent include fluorine, chlorine, bromine, an alkoxy group, an acyl group and an aryl group. Specific examples of the alkylsulfonate include methanesulfonate, ethanesulfonate, butanesulfonate, hexanesulfonate, octanesulfonate, benzylsulfonate, trifluoromethanesulfonate, pentafluoroethanesulfonate and nonafluorobutanesulfonate. The aryl group of the arylsulfonate includes a benzene ring, a naphthalene ring and an anthracene ring. The benzene ring, naphthalene ring and anthracene ring may have a substituent, and the substituent is preferably a linear or branched alkyl group having a carbon number of 1 to 6, or a cycloalkyl group having a carbon number of 3 to 6. Specific examples of the linear or branched alkyl group and cycloalkyl group include methyl, ethyl, n-propyl, isopropyl, n-butyl, i-butyl, tert-butyl, n-hexyl and cyclohexyl. Other examples of the substituent include an alkoxy group having a carbon number of 1 to 6, a halogen atom, cyano, nitro, an acyl group and an acyloxy group.

The phenoxy group-containing amine compound and the phenoxy group-containing ammonium salt compound are a compound where the alkyl group of an amine compound or ammonium salt compound has a phenoxy group at the terminal opposite the nitrogen atom. The phenoxy group may have a substituent. Examples of the substituent of the phenoxy group include an alkyl group, an alkoxy group, a halogen atom, a cyano group, a nitro group, a carboxyl group, a carboxylic acid ester group, a sulfonic acid ester group, an aryl group, an aralkyl group, an acyloxy group and an aryloxy group. The substitution site of the substituent may be any of 2- to 6-positions, and the number of substituents may be any in the range from 1 to 5.

The compound preferably has at least one oxyalkylene group between the phenoxy group and the nitrogen atom. The number of oxyalkylene groups within the molecule is 1 or more, preferably from 3 to 9, more preferably from 4 to 6. Among oxyalkylene groups, an oxyethylene group ($-CH_2CH_2O-$) and an oxypropylene group ($-CH(CH_3)CH_2O-$ or $-CH_2CH_2CH_2O-$) are preferred, and an oxyethylene group is more preferred.

The sulfonic acid ester group in the sulfonic acid ester group-containing amine compound and sulfonic acid ester group-containing ammonium salt compound may be any of an alkylsulfonic acid ester, a cycloalkylsulfonic acid ester and an arylsulfonic acid ester. In the case of an alkylsulfonic acid ester, the alkyl group preferably has a carbon number of 1 to 20; in the case of a cycloalkylsulfonic acid ester, the cycloalkyl group preferably has a carbon number of 3 to 20; and in the case of an arylsulfonic acid ester, the aryl group preferably has a carbon number of 6 to 12. The alkylsulfonic acid ester, cycloalkylsulfonic acid ester and arylsulfonic acid ester may have a substituent, and the substituent is preferably a halogen atom, a cyano group, a nitro group, a carboxyl group, a carboxylic acid ester group or a sulfonic acid ester group.

The compound preferably has at least one oxyalkylene group between the sulfonic acid ester group and the nitrogen atom. The number of oxyalkylene groups within the molecule is 1 or more, preferably from 3 to 9, more preferably from 4 to 6. Among oxyalkylene groups, an oxyethylene group ($-CH_2CH_2O-$) and an oxypropylene group ($-CH(CH_3)CH_2O-$ or $-CH_2CH_2CH_2O-$) are preferred, and an oxyethylene group is more preferred.

One of these basic compounds may be used alone, or two or more thereof may be used in combination.

The amount used of the basic compound is usually from 0.001 to 10 mass%, preferably from 0.01 to 5 mass%, based on the entire solid content of the positive tone resist composition.

The ratio of acid generator and basic compound blended in the composition is preferably acid generator/basic compound (by mol) = from 2.5 to 300. That is, the molar ratio is preferably 2.5 or more in view of sensitivity and resolution and preferably 300 or less from the standpoint of suppressing the reduction in resolution due to thickening of the resist pattern with aging after exposure to heat treatment. The acid generator/basic compound (by mol) is more preferably from 5.0 to 200, still more preferably from 7.0 to 150.

[4] Surfactant

The positive tone resist composition of the present invention preferably further contains a surfactant, more preferably any one of fluorine-containing and/or silicon-containing surfactants (a fluorine-containing surfactant, a silicon-containing surfactant and a surfactant containing both a fluorine atom and a silicon atom), or two or more kinds thereof.

By virtue of incorporating the above-described surfactant into the positive tone resist composition of the present invention, a resist pattern with good performance in terms of sensitivity, resolution and adherence as well as less development defects can be provided when using an exposure light source of 250 nm or less, particularly 220 nm or less.

Examples of the fluorine-containing and/or silicon-containing surfactant include surfactants described in JP-A-62-36663, JP-A-61-226746, JP-A-61-226745, JP-A-62-170950, JP-A-63-34540, JP-A-7-230165, JP-A-8-62834, JP-A-9-54432, JP-A-9-5988, JP-A-2002-277862 and U.S. Patents 5,405,720, 5,360,692, 5,529,881, 5,296,330, 5,436,098, 5,576,143, 5,294,511 and 5,824,451. The following commercially available surfactants each may also be used as it is.

Examples of the commercially available surfactant which can be used include a fluorine-containing surfactant and a silicon-containing surfactant, such as EFtop EF301 and EF303 (produced by Shin-Akita Kasei K.K.); Florad FC430, 431 and 4430 (produced by Sumitomo 3M Inc.); Megaface F171, F173, F176, F189, F113, F110, F177, F120 and R08 (produced by Dainippon Ink & Chemicals, Inc.); Surflon S-382, SC101, 102, 103, 104, 105 and 106 (produced by Asahi Glass Co., Ltd.); Troysol S-366 (produced by Troy Chemical); GF-300 and GF-150 (produced by Toagosei Chemical Industry Co., Ltd.); Surflon S-393 (produced by Seimi Chemical Co., Ltd.); EFtop EF121, EF122A, EF122B, RF122C, EF125M, EF135M, EF351, 352, EF801, EF802 and EF601 (produced by JEMCO Inc.); PF636, PF656, PF6320 and PF6520 (produced by OMNOVA); and FTX-204G, 208G, 218G, 230G, 204D, 208D, 212D, 218D and 222D (produced by NEOS Co., Ltd.). In addition, polysiloxane polymer KP-341 (produced by Shin-Etsu Chemical Co., Ltd.) may also be used as a silicon-containing surfactant.

Other than these known surfactants, a surfactant using a polymer having a fluoro-aliphatic group derived from a fluoro-aliphatic compound that is produced by a telomerization process (also called a telomer process) or an oligomerization process (also called an oligomer process), may be used. The fluoro-aliphatic compound can be synthesized by the method described in JP-A-2002-90991.

The polymer having a fluoro-aliphatic group is preferably a copolymer of a fluoro-aliphatic group-containing monomer with a (poly(oxyalkylene)) acrylate and/or a (poly(oxyalkylene)) methacrylate, and the polymer may have an irregular distribution or may be a block copolymer. Examples of the poly(oxyalkylene) group include a poly(oxyethylene) group, a poly(oxypropylene) group and a poly(oxybutylene) group. This group may also be a unit having alkylenes differing in the chain length within the same chain, such as block-linked poly(oxyethylene, oxypropylene and oxyethylene) and block-linked poly(oxyethylene and oxypropylene). Furthermore, the copolymer of a fluoro-aliphatic group-containing monomer and a (poly(oxyalkylene)) acrylate (or methacrylate) is not limited only to a binary copolymer but may also be a ternary or greater copolymer obtained by simultaneously copolymerizing two or more different fluoro-aliphatic group-containing monomers or two or more different (poly(oxyalkylene)) acrylates (or methacrylates).

Examples thereof include, as the commercially available surfactant, Megaface F178, F-470, F-473, F-475, F-476 and F-472 (produced by Dainippon Ink & Chemicals, Inc.) and further include a copolymer of a $C_6F_{13}$ group-containing acrylate (or methacrylate) with a (poly(oxyalkylene)) acrylate (or methacrylate), and a copolymer of a $C_3F_7$ group-containing acrylate (or methacrylate) with a (poly(oxyethylene)) acrylate (or methacrylate) and a (poly(oxypropylene)) acrylate (or methacrylate).

In the present invention, a surfactant other than the fluorine-containing and/or silicon-containing surfactant may also be used. Specific examples thereof include a nonionic surfactant such as polyoxyethylene alkyl ethers (e.g., polyoxyethylene lauryl ether, polyoxyethylene stearyl ether, polyoxyethylene cetyl ether, polyoxyethylene oleyl ether), polyoxyethylene alkylaryl ethers (e.g., polyoxyethylene octylphenol ether, polyoxyethylene nonylphenol ether), polyoxyethylene•polyoxypropylene block copolymers, sorbitan fatty acid esters (e.g., sorbitan monolaurate, sorbitan monopalmitate, sorbitan monostearate, sorbitan monooleate, sorbitan trioleate, sorbitan tristearate), and polyoxyethylene sorbitan fatty acid esters (e.g., polyoxyethylene sorbitan monolaurate, polyoxyethylene sorbitan monopalmitate, polyoxyethylene sorbitan monostearate, polyoxyethylene sorbitan trioleate, polyoxyethylene sorbitan tristearate).

One of such surfactants may be used alone, or some of them may be used in combination.

The amount used of the surfactant is preferably from 0.0001 to 2 mass%, more preferably from 0.001 to 1 mass%, based on the entire solid content of the positive tone resist composition.

[5] Solvent

Examples of the solvent which can be used at the time of preparing the positive tone resist composition by dissolving the above-described components include an organic solvent such as alkylene glycol monoalkyl ether carboxylate, alkylene glycol monoalkyl ether, alkyl lactate, alkyl alkoxypropionate, cyclic lactone (preferably having a carbon number of 4 to 10), monoketone compound (preferably having a carbon number of 4 to 10) which may contain a ring, alkylene carbonate, alkyl alkoxyacetate and alkyl pyruvate.

Preferred examples of the alkylene glycol monoalkyl ether carboxylate include propylene glycol monomethyl ether acetate, propylene glycol monoethyl ether acetate, propylene glycol monopropyl ether acetate, propylene glycol monobutyl ether acetate, propylene glycol monomethyl ether propionate, propylene glycol monoethyl ether propionate, ethylene glycol monomethyl ether acetate and ethylene glycol monoethyl ether acetate.

Preferred examples of the alkylene glycol monoalkyl ether include propylene glycol monomethyl ether, propylene glycol monoethyl ether, propylene glycol monopropyl ether, propylene glycol monobutyl ether, ethylene glycol monomethyl ether and ethylene glycol monoethyl ether.

Preferred examples of the alkyl lactate include methyl lactate, ethyl lactate, propyl lactate and butyl lactate.

Preferred examples of the alkyl alkoxypropionate include ethyl 3-ethoxypropionate, methyl 3-methoxypropionate, methyl 3-ethoxypropionate and ethyl 3-methoxypropionate.

Preferred examples of the cyclic lactone include β-propiolactone, β-butyrolactone, γ-butyrolactone, α-methyl-γ-butyrolactone, β-methyl-γ-butyrolactone, γ-valerolactone, γ-caprolactone, γ-octanoic lactone and α-hydroxy-y-butyrolactone.

Preferred examples of the monoketone compound which may contain a ring include 2-butanone, 3-methylbutanone, pinacolone, 2-pentanone, 3-pentanone, 3-methyl-2-pentanone, 4-methyl-2-pentanone, 2-methyl-3-pentanone, 4,4-dimethyl-2-pentanone, 2,4-dimethyl-3-pentanone, 2,2,4,4-tetramethyl-3-pentanone, 2-hexanone, 3-hexanone, 5-methyl-3-hexanone, 2-heptanone, 3-heptanone, 4-heptanone, 2-methyl-3-heptanone, 5-methyl-3-heptanone, 2,6-dimethyl-4-heptanone, 2-octanone, 3-octanone, 2-nonanone, 3-nonanone, 5-nonanone, 2-decanone, 3-decanone, 4-decanone, 5-hexen-2-one, 3-penten-2-one, cyclopentanone, 2-methylcyclopentanone, 3-methylcyclopentanone, 2,2-dimethylcyclopentanone, 2,4,4-trimethylcyclopentanone, cyclohexanone, 3-methylcyclohexanone, 4-methylcyclohexanone, 4-ethylcyclohexanone, 2,2-dimethylcyclohexanone, 2,6-dimethylcyclohexanone, 2,2,6-trimethylcyclohexanone, cycloheptanone, 2-methylcycloheptanone and 3-methylcycloheptanone.

Preferred examples of the alkylene carbonate include propylene carbonate, vinylene carbonate, ethylene carbonate and butylene carbonate.

Preferred examples of the alkyl alkoxyacetate include 2-methoxyethyl acetate, 2-ethoxyethyl acetate, 2-(2-ethoxyethoxy)ethyl acetate, 3-methoxy-3-methylbutyl acetate and 1-methoxy-2-propyl acetate.

Preferred examples of the alkyl pyruvate include methyl pyruvate, ethyl pyruvate and propyl pyruvate.

The solvent which can be preferably used includes a solvent having a boiling point of 130°C or more at ordinary temperature under atmospheric pressure, and specific examples thereof include cyclopentanone, γ-butyrolactone, cyclohexanone, ethyl lactate, ethylene glycol monoethyl ether acetate, propylene glycol monomethyl ether acetate, ethyl 3-ethoxypropionate, ethyl pyruvate, 2-ethoxyethyl acetate, 2-(2-ethoxyethoxy)ethyl acetate and propylene carbonate.

In the present invention, one of these solvents may be used alone, or two or more kinds thereof may be used in combination.

In the present invention, a mixed solvent prepared by mixing a solvent containing a hydroxyl group in the structure and a solvent not containing a hydroxyl group may be used as the organic solvent.

Examples of the solvent containing a hydroxyl group include ethylene glycol, ethylene glycol monomethyl ether, ethylene glycol monoethyl ether, propylene glycol, propylene glycol monomethyl ether, propylene glycol monoethyl ether and ethyl lactate. Among these, propylene glycol monomethyl ether and ethyl lactate are preferred.

Examples of the solvent not containing a hydroxyl group include propylene glycol monomethyl ether acetate, ethyl ethoxypropionate, 2-heptanone, γ-butyrolactone, cyclohexanone, butyl acetate, N-methylpyrrolidone, N,N-dimethylacetamide and dimethylsulfoxide. Among these, propylene glycol monomethyl ether acetate, ethyl ethoxypropionate, 2-heptanone, γ-butyrolactone, cyclohexanone and butyl acetate are preferred, and propylene glycol monomethyl ether acetate, ethyl ethoxypropionate and 2-heptanone are most preferred.

The mixing ratio (by mass) of the solvent containing a hydroxyl group to the solvent not containing a hydroxyl group is usually from 1/99 to 99/1, preferably from 10/90 to 90/10, more preferably from 20/80 to 60/40. A mixed solvent in which the solvent not containing a hydroxyl group is contained in an amount of 50 mass% or more is particularly preferred in view of coating uniformity.

The solvent is preferably a mixed solvent of two or more kinds of solvents containing propylene glycol monomethyl ether acetate.

<Second Resist>

As for the second resist used in forming a second resist pattern, those described as the first resist may be appropriately used, but from the standpoint of making the same the dry etching resistance between the first resist pattern and the second resist pattern, the resin used for the second resist is preferably a resin substantially the same as the resin used for the first resist. Furthermore, in order to allow the first resist and the second resist to form patterns having substantially the same quality for an actual semiconductor device mask in which patterns of various dimensions or shapes are present, it is most preferred that the first resist and the second resist are composed of utterly the same resist.
The esterification reaction of the treating agent containing the compound represented by formula (1) with the first resist can be controlled also by changing the processing conditions when causing the treating agent to act on the resist.
The process used in the formation of first resist pattern, the freezing of first resist pattern by a chemical treatment, and the formation of second resist pattern are described below.

<Formation of First Resist Pattern>

In the present invention, a first resist composition is filtered through a filter and then used by applying it on a predetermined support as follows. The filter used for filtration is preferably a polytetrafluoroethylene-, polyethylene- or nylon-made filter having a pore size of 0.1 μm or less, more preferably 0.05 μm or less, still more preferably 0.03 μm or less.
The resist composition filtered through a filter is applied on such a substrate (e.g., silicon/silicon dioxide-coated substrate) as used in the production of a precision integrated circuit device by an appropriate coating method such as spinner or coater and dried to form a resist film. In the drying stage, heating (pre-baking) is preferably performed. The film thickness is preferably adjusted to a range from 50 to 200 nm, more preferably from 70 to 180 nm.
In the case of applying the resist composition by a spinner, the spinning speed is usually from 500 to 3,000 rpm, preferably from 800 to 2,000 rpm, more preferably from 1,000 to 1,500 rpm.
Before forming the resist film, an antireflection film may be previously provided by coating on the substrate.
The antireflection film used may be either an inorganic film type such as titanium, titanium dioxide, titanium nitride, chromium oxide, carbon and amorphous silicon, or an organic film type comprising a light absorber and a polymer material. Also, the organic antireflection film may be a commercially available organic antireflection film such as DUV30 Series and DUV-40 Series produced by Brewer Science, Inc., and AR-2, AR-3 and AR-5 produced by Shipley Co., Ltd.

[Dry Exposure System]

The resist film is irradiated with an actinic ray or radiation through a predetermined mask, preferably baked (heated) and then subjected to development and rinsing, whereby a good pattern can be obtained.
Examples of the actinic ray or radiation include infrared light, visible light, ultraviolet light, far ultraviolet light, X-ray and electron beam, but the radiation is preferably far ultraviolet light at a wavelength of 250 nm or less, more preferably 220 nm or less, still more preferably from 1 to 200 nm. Specifically, ArF excimer laser light, $F_2$ excimer laser light, EUV (13 nm) and electron beam are preferred, and ArF excimer laser light is more preferred.

[Immersion Exposure]

In the case of performing immersion exposure, the resist film is subjected to exposure (immersion exposure) via an immersion liquid through a mask or the like for forming a pattern. For example, exposure is performed in the state of filling the immersion liquid between the resist film and an optical lens. After exposure, the resist film is washed, if desired. Subsequently, the immersion liquid is removed preferably by spinning. Examples of the actinic ray or radiation include infrared ray, visible light, ultraviolet ray, far ultraviolet ray and X-ray, but the radiation is preferably far ultraviolet ray at a wavelength of 250 nm or less, more preferably 220 nm or less, still more preferably from 1 to 200 nm. Specifically, ArF excimer laser light, $F_2$ excimer laser, light and EUV (13 nm) are preferred, and ArF excimer laser light is more preferred.
The immersion liquid used in performing immersion exposure is described below.
The immersion liquid is preferably a liquid being transparent to light at the exposure wavelength and causing as small a change of refractive index by temperature as possible, but in particular, when the exposure light source is an ArF excimer laser (wavelength: 193 nm), water is preferably used in view of easy availability and easy handleability in addition to the above-described aspects.
In the case of using water as the immersion liquid, for the purpose of decreasing the surface tension of water and increasing the surface activity, an additive (liquid) which does not dissolve the resist layer on a wafer and at the same time, gives only a negligible effect on the optical coat at the undersurface of the lens element, may be added in

a small ratio. The additive is preferably an aliphatic alcohol having a refractive index nearly equal to that of water, and specific examples thereof include methanol, ethanol and isopropanol. Addition of such an additive is advantageous in that even when the additive component in water is evaporated and its content concentration is changed, the change in the refractive index of the entire liquid can be advantageously made very small. On the other hand, if a substance opaque to light at 193 nm or an impurity greatly differing in the refractive index from water is intermixed, this incurs distortion of the optical image projected on the resist film. Therefore, the water used is preferably distilled water. Pure water obtained by further filtering the distilled water through an ion exchange filter or the like may also be used.

The electrical resistance of the immersion liquid such as water is preferably 18.3 MQcm or more, and TOC (total organic carbon) is preferably 20 ppb or less. The water is preferably subjected to a deaeration treatment. Also, the lithography performance can be enhanced by raising the refractive index of the immersion liquid. From such a standpoint, an additive for raising the refractive index may be added to water, or deuterium water ($D_2O$) may be used in place of water.

In order to prevent the resist film from directly contacting with the immersion liquid, a film sparingly soluble in the immersion liquid (hereinafter, sometimes referred to as a "topcoat") may be provided between the resist film and the immersion liquid. The functions required of the topcoat are suitability for coating on the top of the resist layer (capability of being uniformly coated), transparency to radiation, particularly light at a wavelength of 193 nm, and difficult solubility in the immersion liquid.

In view of transparency to light at 193 nm, the topcoat is preferably an aromatic-free polymer, and specific examples thereof include a hydrocarbon polymer, an acrylic acid ester polymer, a polymethacrylic acid, a polyacrylic acid, a polyvinyl ether, a silicon-containing polymer and a fluorine-containing polymer.

On peeling off the topcoat, a developer may be used or a releasing agent may be separately used. The releasing agent is preferably a solvent less permeating the resist. From the standpoint that the peeling step can be performed simultaneously with the development step of the resist, the topcoat is preferably peelable with an alkali developer and for peeling the topcoat with an alkali developer, the topcoat is preferably acidic, but in view of non-intermixing with the resist, the topcoat may be neutral or alkaline.

At the immersion exposure, in place of or in combination with the topcoat, a hydrophobic resin (HR) described later may be added to the resist composition and after forming a resist film, the immersion exposure may be performed.

The hydrophobic resin (HR) added is unevenly distributed to the surface layer of the resist film and in the case of using water as the immersion medium, the resist film formed can be enhanced in the receding contact angle on the resist film surface for water as well as in the followability of the immersion liquid. The hydrophobic resin (HR) is a resin yielding an enhanced receding contact angle on the surface by its addition and is preferably a resin having at least either a fluorine atom or a silicon atom. The receding contact angle of the resist film is preferably from 60 to 90°, more preferably 70° or more. The amount of the hydrophobic resin added may be appropriately adjusted to give a resist film having a receding contact angle in the range above but is preferably from 0.1 to 10 mass%, more preferably from 0.1 to 5 mass%, based on the entire solid content of the resist composition. The hydrophobic resin (HR) is unevenly distributed to the interface but unlike a surfactant, need not have necessarily a hydrophilic group in the molecule and may not contribute to uniform mixing of polar/nonpolar substances.

In the case where the hydrophobic resin (HR) is a resin having at least either a fluorine atom or a silicon atom, the resin is preferably a resin having a fluorine atom-containing alkyl group, a fluorine atom-containing cycloalkyl group or a fluorine atom-containing aryl group.

The fluorine atom-containing alkyl group (preferably having a carbon number of 1 to 10, more preferably from 1 to 4) is a linear or branched alkyl group with at least one hydrogen atom being replaced by a fluorine atom and may further have other substituents.

The fluorine atom-containing cycloalkyl group is a monocyclic or polycyclic cycloalkyl group with at least one hydrogen atom being replaced by a fluorine atom and may further have other substituents.

The fluorine atom-containing aryl group is an aryl group (e.g., phenyl, naphthyl) with at least one hydrogen atom being replaced by a fluorine atom and may further have other substituents.

Preferred examples of the fluorine atom-containing alkyl group, fluorine atom-containing cycloalkyl group and fluorine atom-containing aryl group include the groups represented by the following formulae (F2) to (F4), but the present invention is not limited thereto.

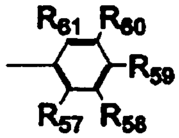 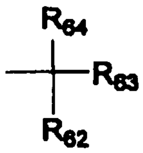 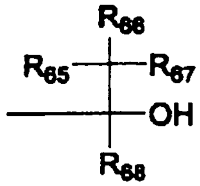

(F2) (F3) (F4)

In formulae (F2) to (F4), each of $R_{57}$ to $R_{68}$ independently represents a hydrogen atom, a fluorine atom or an alkyl group, provided that at least one of $R_{57}$ to $R_{61}$, at least one of $R_{62}$ to $R_{64}$ and at least one of $R_{65}$ to $R_{68}$ are a fluorine atom or an alkyl group (preferably having a carbon number of 1 to 4) with at least one hydrogen atom being replaced by a fluorine atom. It is preferred that all of $R_{57}$ to $R_{61}$ and $R_{65}$ to $R_{67}$ are a fluorine atom. Each of $R_{62}$, $R_{63}$ and $R_{68}$ is preferably an alkyl group (preferably having a carbon number of 1 to 4) with at least one hydrogen atom being replaced by a fluorine atom, more preferably a perfluoroalkyl group having a carbon number of 1 to 4. $R_{62}$ and $R_{63}$ may combine with each other to form a ring.

Specific examples of the group represented by formula (F2) include p-fluorophenyl group, pentafluorophenyl group and 3,5-di(trifluoromethyl)phenyl group.

Specific examples of the group represented by formula (F3) include trifluoromethyl group, pentafluoropropyl group, pentafluoroethyl group, heptafluorobutyl group, hexafluoroisopropyl group, heptafluoroisopropyl group, hexafluoro (2-methyl)isopropyl group, nonafluorobutyl group, octafluoroisobutyl group, nonafluorohexyl group, nonafluoro-tert-butyl group, perfluoroisopentyl group, perfluorooctyl group, perfluoro(trimethyl)hexyl group, 2,2,3,3-tetrafluorocyclobutyl group and perfluorocyclohexyl group. Among these, hexafluoroisopropyl group, heptafluoroisopropyl group, hexafluoro(2-methyl)isopropyl group, octafluoroisobutyl group, nonafluoro-tert-butyl group and perfluoroisopentyl group are preferred, and hexafluoroisopropyl group and heptafluoroisopropyl group are more preferred.

Specific examples of the group represented by formula (F4) include $-C(CF_3)_2OH$, $-C(C_2F_5)_2OH$, $-C(CF_3)(CH_3)OH$ and $-CH(CF_3)OH$, with $-C(CF_3)_2OH$ being preferred.

The hydrophobic resin (HR) is preferably a resin having an alkylsilyl structure (preferably a trialkylsilyl group) or a cyclic siloxane structure, as a silicon atom-containing partial structure.

Specific examples of the alkylsilyl structure and cyclic siloxane structure include groups represented by the following formulae (CS-1) to (CS-3):

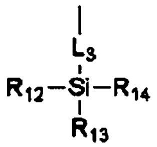 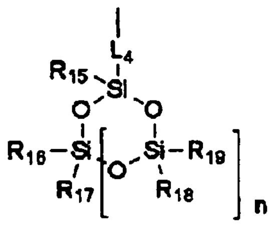 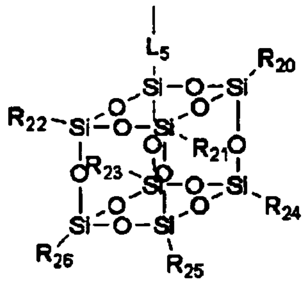

(CS-1) (CS-2) (CS-3)

In formulae (CS-1) to (CS-3), each of $R_{12}$ to $R_{26}$ independently represents a linear or branched alkyl group (preferably having a carbon number of 1 to 20) or a cycloalkyl group (preferably having a carbon number of 3 to 20).

Each of $L_3$ to $L_5$ represents a single bond or a divalent linking group. The divalent linking group is a sole group or a combination of two or more groups selected from the group consisting of an alkylene group, a phenylene group, an ether group, a thioether group, a carbonyl group, an ester group, an amide group, a urethane group and a urea group.

n represents an integer of 1 to 5.

Furthermore, the hydrophobic resin (HR) may contain at least one group selected from the group consisting of the following (x) to (z):

(x) an alkali-soluble group,
(y) a group capable of decomposing by the action of an alkali developer to increase the solubility in an alkali developer, and
(z) a group capable of decomposing by the action of an acid.

Examples of the (x) alkali-soluble group include groups having a phenolic hydroxyl group, a carboxylic acid group, a fluorinated alcohol group, a sulfonic acid group, a sulfonamide group, a sulfonylimide group, an (alkylsulfonyl)(alkylcarbonyl)methylene group, an (alkylsulfonyl)(alkylcarbonyl)imide group, a bis(alkylcarbonyl)methylene group, a bis(alkylcarbonyl)imide group, a bis(alkylsulfonyl)methylene group, a bis(alkylsulfonyl)imide group, a tris(alkylcarbonyl)methylene group or a tris(alkylsulfonyl)methylene group.
Preferred alkali-soluble groups include a fluorinated alcohol group (preferably hexafluoroisopropanol), a sulfonimide group and a bis(carbonyl)methylene group.
As for the repeating unit having (x) an alkali-soluble group, all of a repeating unit where an alkali-soluble group is directly bonded to the resin main chain, such as repeating unit by an acrylic acid or a methacrylic acid, a repeating unit where an alkali-soluble group is bonded to the resin main chain through a linking group, and a repeating unit where an alkali-soluble group is introduced into the polymer chain terminal by using an alkali-soluble group-containing polymerization initiator or chain transfer agent at the polymerization, are preferred.
The content of the repeating unit having (x) an alkali-soluble group is preferably from 1 to 50 mol%, more preferably from 3 to 35 mol%, still more preferably from 5 to 20 mol%, based on all repeating units in the hydrophobic resin (HR).
Examples of the (y) group capable of decomposing by the action of an alkali developer to increase the solubility in an alkali developer include a lactone structure-containing group, an acid anhydride and an acid imide group, with a lactone group being preferred.
As for the repeating unit having (y) a group capable of decomposing by the action of an alkali developer to increase the solubility in an alkali developer, both a repeating unit where (y) a group capable of decomposing by the action of an alkali developer to increase the solubility in an alkali developer is bonded to the main chain of the resin, such as repeating unit by an acrylic acid ester or a methacrylic acid ester, and a repeating unit where (y) a group capable of increasing the solubility in an alkali developer is introduced into the polymer chain terminal by using a polymerization initiator or chain transfer agent containing the group at the polymerization, are preferred.
The content of the repeating unit having (y) a group capable of increasing the solubility in an alkali developer is preferably from 1 to 40 mol%, more preferably from 3 to 30 mol%, still more preferably from 5 to 15 mol%, based on all repeating units in the hydrophobic resin (HR).
Specific examples of the repeating unit having (y) a group capable of increasing the solubility in an alkali developer are the same as those of the repeating unit having a lactone structure described above for the first resist.
Examples of the repeating unit having (z) a group capable of decomposing by the action of an acid, contained in the hydrophobic resin (HR), are the same as those of the repeating unit having an acid-decomposable group described above for the first resist. In the hydrophobic resin (HR), the content of the repeating unit having (z) a group capable of decomposing by the action of an acid is preferably from 1 to 80 mol%, more preferably from 10 to 80 mol%, still more preferably from 20 to 60 mol%, based on all repeating units in the hydrophobic resin (HR).
The hydrophobic resin (HR) may further contain a repeating unit represented by the following formula (IV):

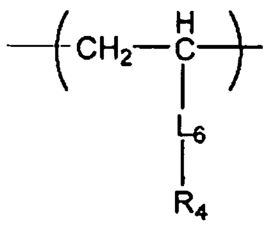

(IV)

In formula (IV), $R_4$ represents a group having an alkyl group, a cycloalkyl group, an alkenyl group or a cycloalkenyl group.
$L_6$ represents a single bond or a divalent linking group.
In formula (IV), the alkyl group of $R_4$ is preferably a linear or branched alkyl group having a carbon number of 3 to 20.

The cycloalkyl group is preferably a cycloalkyl group having a carbon number of 3 to 20.

The alkenyl group is preferably an alkenyl group having a carbon number of 3 to 20.

The cycloalkenyl group is preferably a cycloalkenyl group having a carbon number of 3 to 20.

The divalent linking group of $L_6$ is preferably an alkylene group (preferably having a carbon number of 1 to 5) or an oxy group.

In the case where the hydrophobic resin (HR) contains a fluorine atom, the fluorine atom content is preferably from 5 to 80 mass%, more preferably from 10 to 80 mass%, based on the molecular weight of the hydrophobic resin (HR). Also, the fluorine atom-containing repeating unit preferably occupies from 10 to 100 mass%, more preferably from 30 to 100 mass%, in the hydrophobic resin (HR).

In the case where the hydrophobic resin (HR) contains a silicon atom, the silicon atom content is preferably from 2 to 50 mass%, more preferably from 2 to 30 mass%, based on the molecular weight of the hydrophobic resin (HR). Also, the silicon atom-containing repeating unit preferably occupies from 10 to 100 mass%, more preferably from 20 to 100 mass%, in the hydrophobic resin (HR).

The standard polystyrene-reduced weight average molecular of the hydrophobic resin (HR) is preferably from 1,000 to 100,000, more preferably from 1,000 to 50,000, still more preferably from 2,000 to 15,000.

Similarly to the resin (A), in the hydrophobic resin (HR), it is of course preferred that the amount of impurities such as metal is small, and furthermore, the content of residual monomers or oligomer components is preferably from 0 to 10 mass%, more preferably from 0 to 5 mass%, still more preferably from 0 to 1 mass%. By satisfying these conditions, a resist free of extraneous substances in the liquid or change with aging in the sensitivity and the like can be obtained. Also, in view of resolution, resist profile, side wall of resist pattern, roughness and the like, the molecular weight distribution (Mw/Mn, also called polydispersity) is preferably from 1 to 5, more preferably from 1 to 3, still more preferably from 1 to 2.

As for the hydrophobic resin (HR), various commercially available products may be used or the resin may be synthesized by an ordinary method. Examples of the synthesis method and purification method of this resin are the same as those of the method for the (A) resin capable of decomposing by the action of an acid to increase the solubility in an alkali developer, which is used as the first resist and the second resist.

Specific examples of the hydrophobic resin (HR) are set forth below. Also, the molar ratio of repeating units (corresponding to repeating units from the left), weight average molecular weight and polydispersity of each resin are shown in Table 1 below.

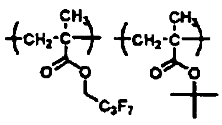
(HR-1)

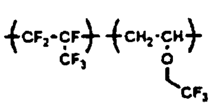
(HR-2)

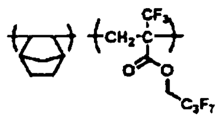
(HR-3)

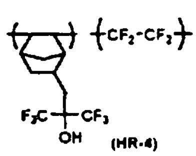
(HR-4)

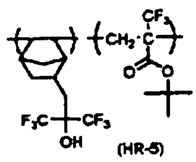
(HR-5)

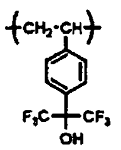
(HR-6)

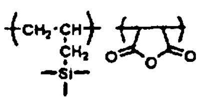
(HR-7)

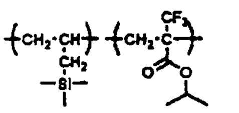
(HR-8)

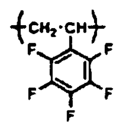
(HR-9)

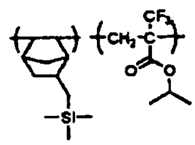
(HR-10)

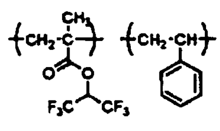
(HR-11)

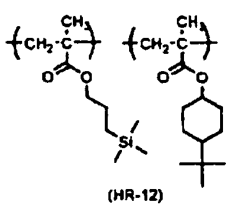
(HR-12)

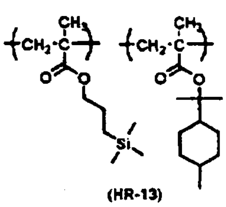
(HR-13)

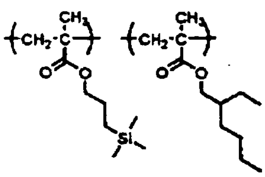
(HR-14)

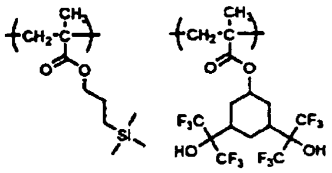
(HR-15)

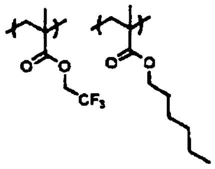
(HR-16)

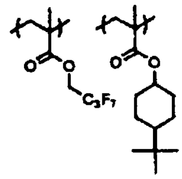
(HR-17)

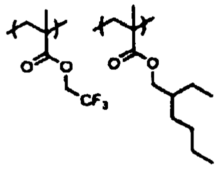
(HR-18)

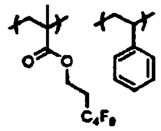
(HR-19)

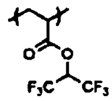
(HR-20)

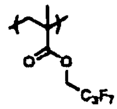
(HR-21)

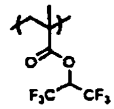
(HR-22)

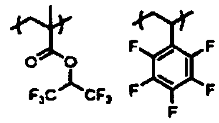
(HR-23)

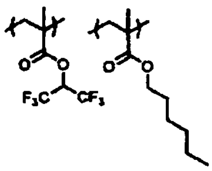
(HR-24)

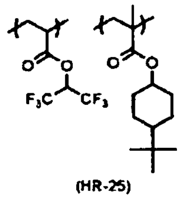
(HR-25)

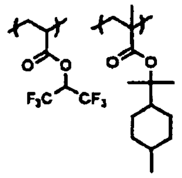
(HR-26)

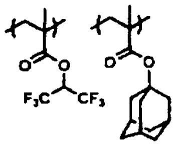
(HR-27)

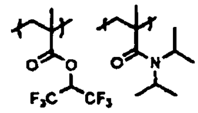
(HR-28)

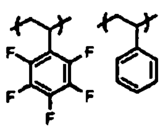
(HR-29)

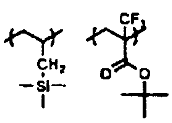
(HR-30)

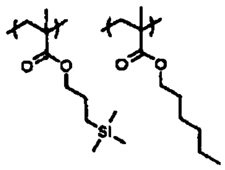
(HR-31)

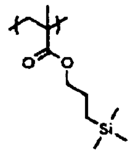
(HR-32)

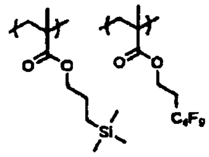
(HR-33)

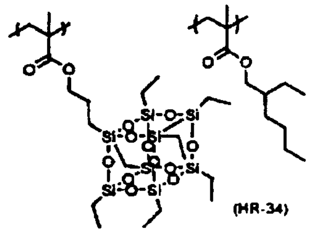
(HR-34)

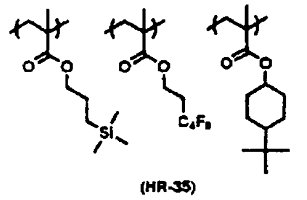
(HR-35)

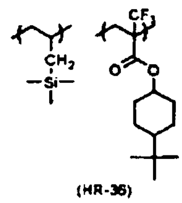
(HR-36)

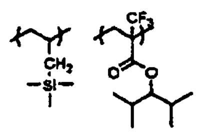
(HR-37)

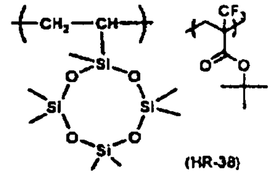
(HR-38)

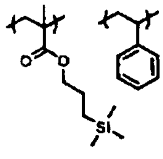
(HR-39)

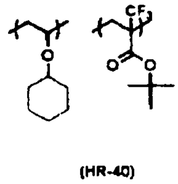
(HR-40)

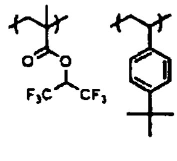
(HR-41)

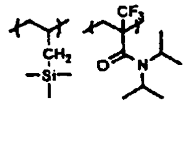
(HR-42)

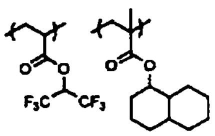

(HR-43)

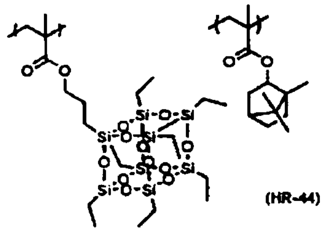

(HR-44)

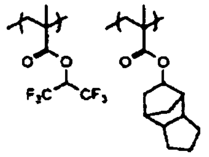

(HR-45)

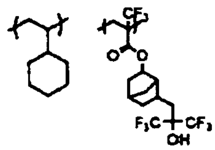

(HR-46)

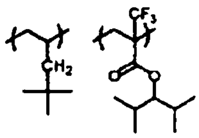

(HR-47)

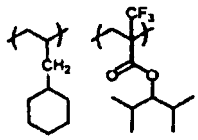

(HR-48)

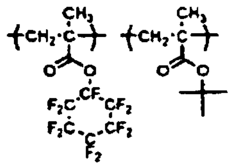

(HR-49)

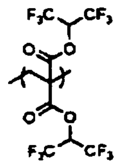

(HR-50)

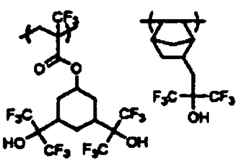

(HR-51)

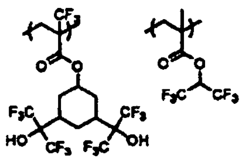

(HR-52)

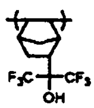

(HR-53)

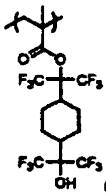

(HR-54)

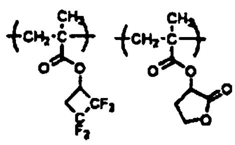

(HR-55)

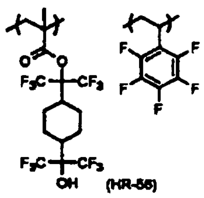

(HR-56)

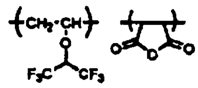

(HR-57)

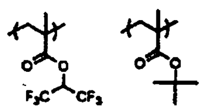

(HR-58)

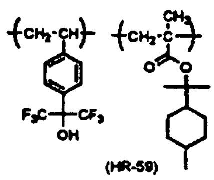

(HR-59)

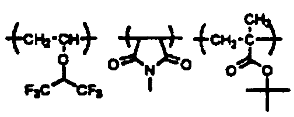

(HR-60)

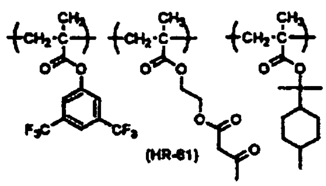

(HR-61)

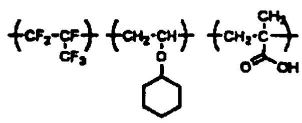

(HR-62)

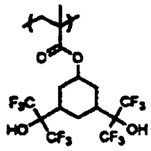

(HR-63)

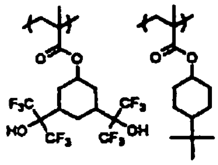

(HR-64)

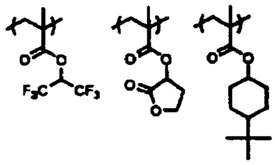

(HR-65)

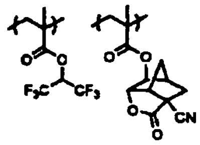

(HR-66)

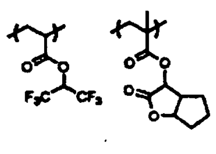
(HR-67)

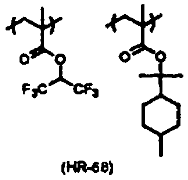
(HR-68)

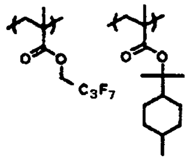
(HR-69)

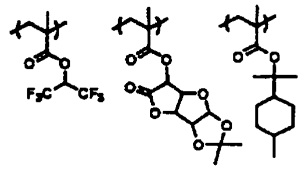
(HR-70)

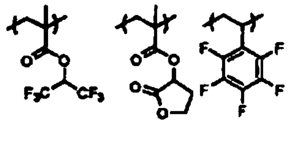
(HR-71)

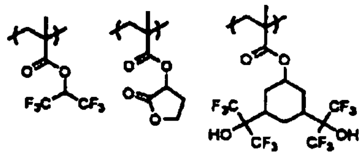
(HR-72)

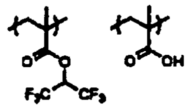
(HR-73)

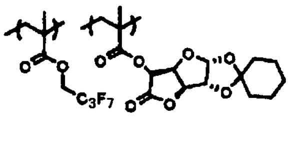
(HR-74)

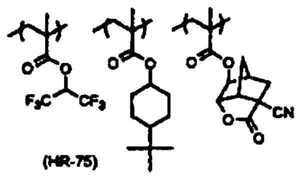
(HR-75)

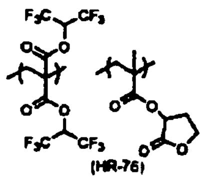
(HR-76)

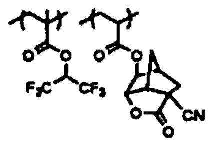
(HR-77)

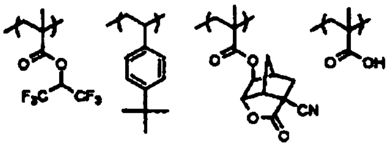
(HR-78)

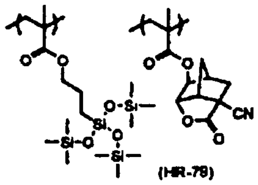
(HR-79)

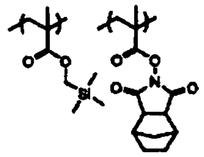
(HR-80)

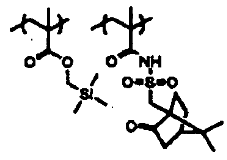
(HR-81)

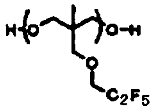
(HR-82)

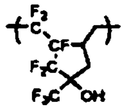
(HR-83)

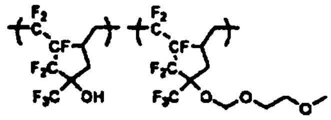
(HR-84)

| Resin | Composition | Mw | Mw/Mn | | Resin | Composition | Mw | Mw/Mn |
|---|---|---|---|---|---|---|---|---|
| HR-1 | 50/50 | 8800 | 2.1 | | HR-51 | 60/40 | 8800 | 1.5 |
| HR-2 | 50/50 | 5200 | 1.8 | | HR-52 | 68/32 | 11000 | 1.7 |
| HR-3 | 50/50 | 4800 | 1.9 | | HR-53 | 100 | 8000 | 1.4 |
| HR-4 | 50/50 | 5300 | 1.9 | | HR-54 | 100 | 8500 | 1.4 |
| HR-5 | 50/50 | 6200 | 1.9 | | HR-55 | 80/20 | 13000 | 2.1 |

(continued)

| Resin | Composition | Mw | Mw/Mn | Resin | Composition | Mw | Mw/Mn |
|---|---|---|---|---|---|---|---|
| HR-6 | 100 | 12000 | 2.0 | HR-56 | 70/30 | 18000 | 2.3 |
| HR-7 | 50/50 | 5800 | 1.9 | HR-57 | 50/50 | 5200 | 1.9 |
| HR-8 | 50/50 | 6300 | 1.9 | HR-58 | 50/50 | 10200 | 2.2 |
| HR-9 | 100 | 5500 | 2.0 | HR-59 | 60/40 | 7200 | 2.2 |
| HR-10 | 50/50 | 7500 | 1.9 | HR-60 | 32/32/36 | 5600 | 2.0 |
| HR-11 | 70/30 | 10200 | 2.2 | HR-61 | 30/30/40 | 9600 | 1.6 |
| HR-12 | 40/60 | 15000 | 2.2 | HR-62 | 40/40/20 | 12000 | 2.0 |
| HR-13 | 40/60 | 13000 | 2.2 | HR-63 | 100 | 6800 | 1.6 |
| HR-14 | 80/20 | 11000 | 2.2 | HR-64 | 50/50 | 7900 | 1.9 |
| HR-15 | 60/40 | 9800 | 2.2 | HR-65 | 40/30/30 | 5600 | 2.1 |
| HR-16 | 50/50 | 8000 | 2.2 | HR-66 | 50/50 | 6800 | 1.7 |
| HR-17 | 50/50 | 7600 | 2.0 | HR-67 | 50/50 | 5900 | 1.6 |
| HR-18 | 50/50 | 12000 | 2.0 | HR-68 | 49/51 | 6200 | 1.8 |
| HR-19 | 20/80 | 6500 | 1.8 | HR-69 | 50/50 | 8000 | 1.9 |
| HR-20 | 100 | 6500 | 1.2 | HR-70 | 30/40/30 | 9600 | 2.3 |
| HR-21 | 100 | 6000 | 1.6 | HR-71 | 30/40/30 | 9200 | 2.0 |
| HR-22 | 100 | 2000 | 1.6 | HR-72 | 40/29/31 | 3200 | 2.1 |
| HR-23 | 50/50 | 6000 | 1.7 | HR-73 | 90/10 | 6500 | 2.2 |
| HR-24 | 50/50 | 8800 | 1.9 | HR-74 | 50/50 | 7900 | 1.9 |
| HR-25 | 50/50 | 7800 | 2.0 | HR-75 | 20/30/50 | 10800 | 1.6 |
| HR-26 | 50/50 | 8000 | 2.0 | HR-76 | 50/50 | 2200 | 1.9 |
| HR-27 | 80/20 | 8000 | 1.8 | HR-77 | 50/50 | 5900 | 2.1 |
| HR-28 | 30/70 | 7000 | 1.7 | HR-78 | 40/20/30/10 | 14000 | 2.2 |
| HR-29 | 50/50 | 6500 | 1.6 | HR-79 | 50/50 | 5500 | 1.8 |
| HR-30 | 50/50 | 6500 | 1.6 | HR-80 | 50/50 | 10600 | 1.9 |
| HR-31 | 50/50 | 9000 | 1.8 | HR-81 | 50/50 | 8600 | 2.3 |
| HR-32 | 100 | 10000 | 1.6 | HR-82 | 100 | 15000 | 2.1 |
| HR-33 | 70/30 | 8000 | 2.0 | HR-83 | 100 | 6900 | 2.5 |
| HR-34 | 10/90 | 8000 | 1.8 | HR-84 | 50/50 | 9900 | 2.3 |
| HR-35 | 30/30/40 | 9000 | 2.0 | | | | |
| HR-36 | 50/50 | 6000 | 1.4 | | | | |
| HR-37 | 50/50 | 5500 | 1.5 | | | | |
| HR-38 | 50/50 | 4800 | 1.8 | | | | |
| HR-39 | 60/40 | 5200 | 1.8 | | | | |
| HR-40 | 50/50 | 8000 | 1.5 | | | | |
| HR-41 | 20/80 | 7500 | 1.8 | | | | |
| HR-42 | 50/50 | 6200 | 1.6 | | | | |
| HR-43 | 60/40 | 16000 | 1.8 | | | | |

(continued)

| Resin | Composition | Mw | Mw/Mn | Resin | Composition | Mw | Mw/Mn |
|---|---|---|---|---|---|---|---|
| HR-44 | 80/20 | 10200 | 1.8 | | | | |
| HR-45 | 50/50 | 12000 | 2.6 | | | | |
| HR-46 | 50/50 | 10900 | 1.9 | | | | |
| HR-47 | 50/50 | 6000 | 1.4 | | | | |
| HR-48 | 50/50 | 4500 | 1.4 | | | | |
| HR-49 | 50/50 | 6900 | 1.9 | | | | |
| HR-50 | 100 | 2300 | 2.6 | | | | |

After dry exposure or immersion exposure, post-baking (post-heating) is preferably performed, and the resist film is then developed and rinsed, whereby a good pattern can be obtained.

In the development step, an alkali developer is usually used. The alkali developer which can be used for the resist composition is an alkaline aqueous solution of, for example, inorganic alkalis such as sodium hydroxide, potassium hydroxide, sodium carbonate, sodium silicate, sodium metasilicate and aqueous ammonia, primary amines such as ethylamine and n-propylamine, secondary amines such as diethylamine and di-n-butylamine, tertiary amines such as triethylamine and methyldiethylamine, alcohol amines such as dimethylethanolamine and triethanolamine, quaternary ammonium salts such as tetramethylammonium hydroxide and tetraethylammonium hydroxide, or cyclic amines such as pyrrole and piperidine.

Furthermore, this alkali developer may be used after adding thereto alcohols and a surfactant each in an appropriate amount.

The alkali concentration of the alkali developer is usually from 0.1 to 20 mass%.

The pH of the alkali developer is usually from 10.0 to 15.0.

As for the rinsing solution, pure water is usually used, and the pure water may be used after adding thereto a surfactant in an appropriate amount.

After the development or rinsing, a treatment of removing the developer or rinsing solution adhering on the pattern by a supercritical fluid may be performed.

Furthermore, after the rinsing or treatment with a supercritical fluid, a heat treatment may also be performed for removing water remaining in the pattern.

<Chemical Treatment of First Resist Pattern>

After forming a first resist pattern by using the method above, a chemical treatment (freezing treatment) of the first resist pattern is performed using the treating agent of the present invention.

[Washing with Acid]

First, the first resist pattern is preferably washed with an acid-containing solution different from the treating agent of the present invention. The acid includes an inorganic acid such as hydrochloric acid, sulfuric acid, nitric acid and phosphoric acid, and an organic acid such as carboxylic acid, sulfonic acid, sulfonylimide acid and methide acid. Of these, an organic acid such as carboxylic acid, sulfonic acid, imide acid and methide acid is preferred.

Examples of the carboxylic acid include an alkylsulfonic acid such as acetic acid and propionic acid, a fluoroalkylcarboxylic acid such as perfluoroalkylcarboxylic acid having a carbon number of 1 to 8, and an aromatic carboxylic acid such as benzoic acid and pentafluorobenzoic acid.

Examples of the sulfonic acid include an alkylsulfonic acid such as butanesulfonic acid, hexanesulfonic acid and perfluoroalkylsulfonic acid having a carbon number of 1 to 8, and an aromatic sulfonic acid such as p-toluenesulfonic acid and pentafluorobenzenesulfonic acid.

Examples of the imide acid include a disulfonylimide acid such as bis(alkylsulfenyl)imide acid having a carbon number of 1 to 8, bis(perfluoroalkylsulfonyl)imide acid having a carbon number of 1 to 8, 5- to 8-membered cyclic disulfonylimide acid and 5- to 8-membered cyclic disulfonylimide acid having an alkylene fluoride chain.

Examples of the methide acid include a trisulfonylmethide acid such as tris(alkylsulfonyl)methide acid having a carbon number of 1 to 8 and tris(fluoroalkylsulfonyl)methide acid having a carbon number of 1 to 8.

Among these, perfluoroalkylcarboxylic acids, sulfonic acids, imide acids and methide acids are preferred, and

perfluoroalkylsulfonic acids, aromatic sulfonic acids, imide acids and methide acids are more preferred.

The solvent of the solution may be sufficient if it is a solvent that does not dissolve the resist pattern and dissolves acids, and examples thereof include water and the solvent used in the treating agent of the present invention. Preferably, the solvent used in the treating agent of the present invention is used.

The acid concentration is generally from 0.1 to 10 mol%, preferably from 0.5 to 5 mol%, more preferably from 0.5 to 3 mol%.

As for the preferred treating method, the acid solution is puddled on the substrate where a first resist pattern is formed, and after a while, the substrate is spun to shake off the solution and then washed with a solvent. The time for which the solution is kept in contact with the resist pattern by puddling the solution is 5 seconds or more, and a longer time is better, but considering the throughput, the time is preferably 3 minutes or less, more preferably 2 minutes or less, and most preferably 1 minute or less.

As regards the solvent in washing the substrate with a solvent for removing excess acid from the substrate, the solvent used in the acid solution is preferably used.

The washing method is preferably a method of ejecting the solvent onto the center of the substrate at a flow rate of 0.5 to 5 ml/sec for 5 to 30 seconds while spinning the substrate at 50 to 500 rpm, and then spinning the substrate at 500 to 3,000 rpm for 10 to 60 seconds to shake off the solvent, but the washing method is not limited thereto.

[Chemical Treatment]

The method for chemically treating the first resist pattern by using the treating agent of the present invention is described below. The method for bringing the treating agent into contact with the resist pattern includes a method of dipping the resist pattern in the treating agent and a method of applying the treating agent on the resist pattern.

As for the method of dipping the substrate, a method of puddling the treating agent on the substrate having formed thereon a first resist pattern is preferred.

The time for which the treating agent is kept in contact with the resist pattern by puddling the treating agent on the substrate is 5 seconds or more, and a longer time is better, but considering the throughput, the time is preferably 3 minutes or less, more preferably 2 minutes or less, and most preferably 1 minute or less.

Also, the temperature in the treatment apparatus or the temperature of the treating agent may be made higher than room temperature for allowing the reaction to proceed, but in view of safety, the temperature is preferably 50°C or less.

After contacting with the treating agent, the substrate is preferably washed with a solvent for removing excess chemical species from the substrate. In this case, the solvent is preferably the solvent used in the treating agent. The washing method is preferably a method of ejecting the solvent onto the center of the substrate at a flow rate of 0.5 to 5 ml/sec for 5 to 30 seconds while spinning the substrate at 50 to 500 rpm, and then spinning the substrate at 500 to 3,000 rpm for 10 to 60 seconds to shake off the solvent, but the washing method is not limited thereto.

As for the method of applying the treating agent on the resist pattern, spin coating is also preferred.

In the case of spin coating, the treating agent is preferably applied by ejecting the solvent onto the center of the substrate at a flow rate of 0.5 to 5 ml/sec for 0.5 to 5 seconds while spinning the substrate at 50 to 500 rpm, and then spinning the substrate at 500 to 3,000 rpm for 10 to 60 seconds to shake off the solvent.

Also in this case, the substrate is preferably washed with a solvent for removing excess chemical species from the substrate, and the solvent here is preferably the solvent used in the treating agent. The washing method is preferably a method of ejecting the solvent onto the center of the substrate at a flow rate of 0.5 to 5 ml/sec for 5 to 30 seconds while spinning the substrate at 50 to 500 rpm, and then spinning the substrate at 500 to 3,000 rpm for 10 to 60 seconds to shake off the solvent, but the washing method is not limited thereto.

In the present invention, the substrate is preferably heated so that the reaction of the treating agent with the resist pattern can proceed.

Usually; the heating temperature is preferably from 60 to 200°C, more preferably from 80 to 180°C, and most preferably from 90 to 150°C. The heating time is preferably from 10 to 300 seconds, more preferably from 30 to 150 seconds.

After heating, the substrate is cooled and furthermore, the substrate is preferably washed with a solvent for removing excess treating agent or by-products of the reaction. In this case, the solvent is preferably the solvent used in the treating agent or the solvent of the first resist.

The washing method is preferably a method of ejecting the solvent onto the center of the substrate at a flow rate of 0.5 to 5 ml/sec for 5 to 30 seconds while spinning the substrate at 50 to 500 rpm, and then spinning the substrate at 500 to 3,000 rpm for 10 to 60 seconds to shake off the solvent, but the washing method is not limited thereto. Furthermore, a heating step is preferably added so as to remove the washing solvent. The heating temperature is preferably from 60 to 200°C, more preferably from 70 to 170°C, and most preferably from 80 to 150°C. The heating time is preferably from 30 to 120 seconds, more preferably from 40 to 100 seconds.

<Formation of Second Resist Pattern>

In the present invention, a second resist composition is filtered through a filter and then used by applying it on a substrate having formed thereon a first resist pattern that is already chemically treated. The filtration through a filter is the same as in the case of first resist pattern.

On the first resist pattern subjected to the chemical treatment (freezing treatment), the second resist composition is applied by the same method as in the formation of the first resist pattern to form a resist film. As regards the subsequent steps for forming a second resist pattern, such as drying (pre-baking), exposure, post-baking, development and rinsing, the same methods as the methods described with respect to the method for forming a first resist pattern can be applied. In this way, a second resist pattern different from the first resist pattern can be formed.

EXAMPLES

The present invention is described in greater detail below by referring to Examples, but the present invention should not be construed as being limited to these Examples.

[Synthesis of Resin 1]

Under nitrogen flow, 20 g of a 6/4 (by mass) mixed solvent of propylene glycol monomethyl ether acetate (PGMEA) and propylene glycol monomethyl ether (PGME) was charged into a three-neck flask and heated at 80°C (Solvent 1). Also, butyrolactone methacrylate, hydroxyadamantane methacrylate and 2-methyl-2-adamantyl methacrylate were dissolved in a molar ratio of 50/10/40 in a 6/4 (by mass) mixed solvent of propylene glycol monomethyl ether acetate and propylene glycol monomethyl ether to prepare a 22 mass% monomer solution (200 g). Thereto, an initiator V-601 (produced by Wako Pure Chemical Industries, Ltd.) was added and dissolved in an amount of 8 mol% based on the monomers. The resulting solution was added dropwise to (Solvent 1) over 6 hours and after the completion of dropwise addition, the reaction was further allowed to proceed at 80°C for 2 hours. The reaction solution was left standing to cool and then poured in 1,800 ml of hexane/200 ml of ethyl acetate, and the powder precipitated was collected by filtration and dried, as a result, 37 g of Resin (1) was obtained. The weight average molecular weight of the obtained Resin (1) was 8,800 and the polydispersity (Mw/Mn) was 1.8.

Resins (2) to (6) and (PO-A) were synthesized in the same manner.

Structures of Resins (1) to (6) and (PO-A) are shown below, and their composition, mass average molecular weight and polydispersity are shown in Table 1.

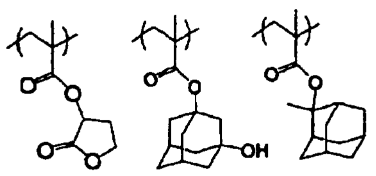

(1)

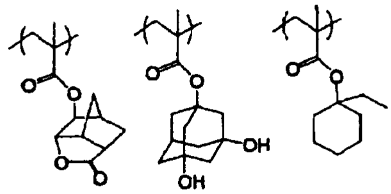

(2)

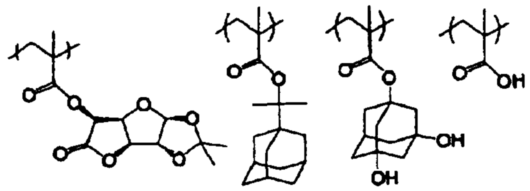

(3)

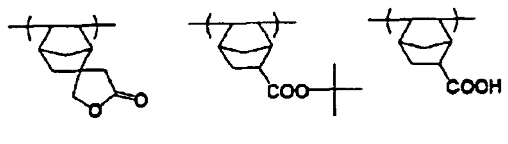

(4)

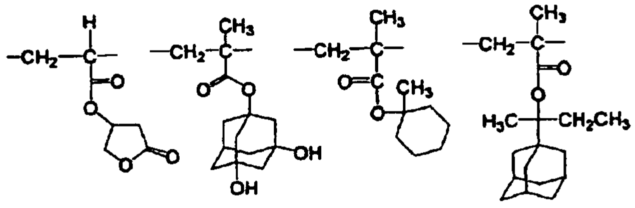

(5)

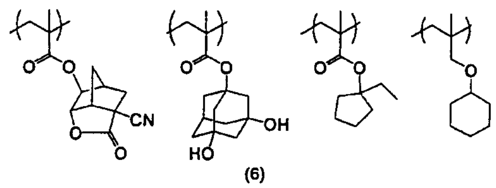

(6)

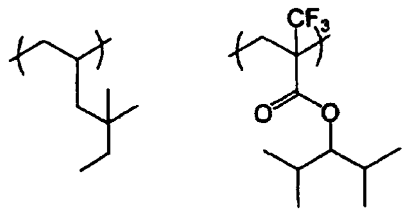

(PO-A)

Table 1

| Resin | Composition (molar ratio) | Mw | Mw/Mn |
|---|---|---|---|
| 1 | 50/10/40 | 8800 | 1.8 |
| 2 | 40/22/38 | 12000 | 2.3 |
| 3 | 46/32/12/10 | 6500 | 2.1 |
| 4 | 18/69/13 | 11000 | 1.8 |
| 5 | 39/21/11/29 | 9600 | 1.7 |
| 6 | 40/10/40/10 | 10000 | 1.8 |
| PO-A | 50/50 | 5000 | 1.4 |

[Preparation of Resist]

The components shown in Table 2 below were dissolved in the solvent to prepare a solution having a solid content concentration of 5.8 mass%, and each solution was filtered through a polyethylene filter having a pore size of 0.1 μm to prepare a positive tone resist solution. As for each component in Table 2, the ratio in the case of using a plurality of kinds is a mass ratio.

Table 2

| | Composition | | | | | |
|---|---|---|---|---|---|---|
| Resist No. | (a) Resin (10 g) | (b) Acid Generator (g) | (c) Basic Compound (g) | (d) Surfactant (g) | (e) Resin B (g) | Solvent (mass ratio) |
| Ar-01 | 1 | P01 (0.3) | TPI (0.03) | W-3 (0.01) | PO-A (0.01) | A1/B1= 70/30 |
| Ar-02 | 2 | P02 (0.2) | PEA (0.03) | W-2 (0.02) | PO-A (0.50) | A1/A2= 40/60 |
| Ar-03 | 3 | P03 (0.4) | PBI (0.02) | W-1 (0.01) | PO-A (1.00) | A1/B2= 50/50 |
| Ar-04 | 4 | P01(0.2) | TPI (0.03) | W-2 (0.02) | PO-A (5.00) | A1/A3= 60/40 |

(continued)

| | Composition | | | | | |
|---|---|---|---|---|---|---|
| Resist No. | (a) Resin (10 g) | (b) Acid Generator (g) | (c) Basic Compound (g) | (d) Surfactant (g) | (e) Resin B (g) | Solvent (mass ratio) |
| Ar-05 | 5 | P02 (0.3) | PEA (0.03) | W-1 (0.01) | PO-A (10.00) | B1/B2= 70/30 |
| Ar-06 | 6 | P01 (0.5) | DPA (0.05) | W-1 (0.03) | PO-A (0.2) | A1/B1= 60/40 |

Abbreviations in each table are as follows.

[Acid Generator]

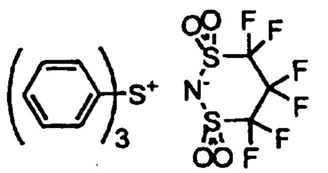

(P01)

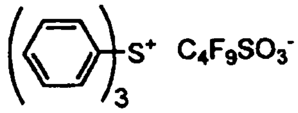

(P02)

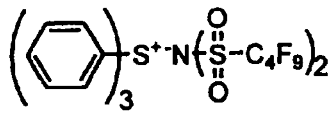

(P03)

[Basic Compound]

TPI: 2,4,5-Triphenylimidazole
PEA: N-Phenyldiethanolamine
DPA: 2,6-Diisopropylphenyl alcohol
PBI: 2-Phenylbenzimidazole

[Surfactant]

W-1: Megaface F176 (produced by Dainippon Ink & Chemicals, Inc.) (fluorine-containing)
W-2: Megaface R08 (produced by Dainippon Ink & Chemicals, Inc.) (fluorine- and silicon-containing)
W-3: Polysiloxane Polymer KP-341 (produced by Shin-Etsu Chemical Co., Ltd.) (silicon-containing)

[Solvent]

A1: Propylene glycol monomethyl ether acetate
A2: γ-Butyrolactone
A3: Cyclohexanone
B1: Propylene glycol monomethyl ether
B2: Ethyl lactate
C1: Octanol

C2: 2,3-Dimethyl-2-pentanol
C3: Perfluoro-2-butyltetrahydrofuran
C4: Decane
C5: Undecane

[Preparation of Freezing Treating Agent]

A freezing treating agent was prepared by dissolving the components shown in Table 3 below in the solvent and filtering the obtained freezing treating agent through a polyethylene filter having a pore size of 0.1 μm.

Table 3

| | Composition | | | |
|---|---|---|---|---|
| No. of Treating Agent | (h) Compound (g) | (i) Additive (g) | (j) Surfactant (g) | Solvent (g) |
| F-01 | FG-01 (5) | none | W-3 (0.01) | C1 (95) |
| F-02 | FG-02 (10) | none | none | C1/C5(30/60) |
| F-03 | FG-03 (10) | none | W-1 (0.01) | C2 (90) |
| F-04 | FG-04 (20) | none | W-2 (0.01) | C1 (80) |
| F-05 | FG-05 (5) | none | W-1 (0.01) | C2 (95) |
| F-06 | FG-06 (10) | none | W-3 (0.02) | C1 (90) |
| F-07 | FG-07 (10) | none | W-3 (0.02) | C1 (90) |
| F-08 | FG-08 (10) | none | W-3 (0.02) | C1/C4 (50/40) |
| F-09 | FG-09 (5) | none | W-1 (0.01) | C1 (95) |
| F-10 | FG-10 (5) | none | W-1 (0.01) | C2 (95) |
| F-11 | FG-11 (10) | none | W-1 (0.01) | C1 (90) |
| F-12 | FG-12 (10) | none | W-1 (0.01) | C1 (90) |
| F-13 | FG-13 (10) | none | W-1 (0.01) | C1 (90) |
| F-14 | FG-14 (10) | none | W-1 (0.01) | C3 (90) |
| F-15 | FG-15 (10) | none | W-1 (0.01) | C1 (90) |
| F-16 | FG-16 (10) | none | W-1 (0.01) | C1 (90) |
| F-17 | FG-13 (5) | X-01 (0.01) | W-1 (0.01) | C1 (95) |
| F-18 | FG-13 (5) | Y-01 (0.01) | W-1 (0.01) | C1 (95) |
| F-A | FG-A (5) | none | W-1 (0.01) | C1 (95) |

[Treating Agent]

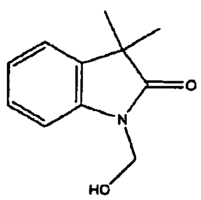
Mol. Wt.: 191.23
(FG-01)

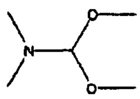
Mol. Wt.: 119.16
(FG-02)

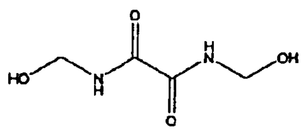
Mol. Wt.: 148.12
(FG-03)

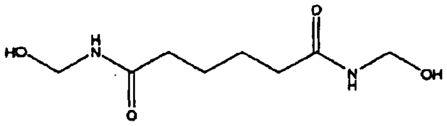

Mol. Wt.: 204.22

(FG-04)

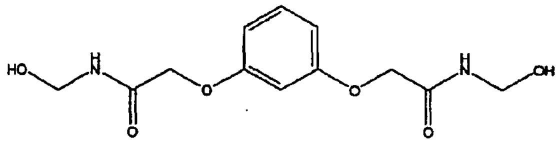

Mol. Wt.: 284.27

(FG-05)

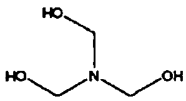

Mol. Wt.: 107.11

(FG-06)

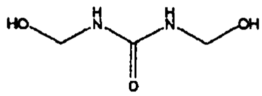

Mol. Wt.: 120.11

(FG-07)

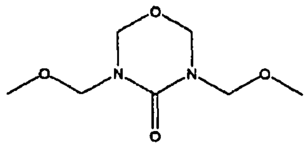

Mol. Wt.: 190.2

(FG-08)

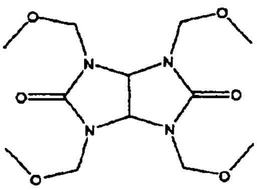

Mol. Wt.: 318.33

(FG-09)

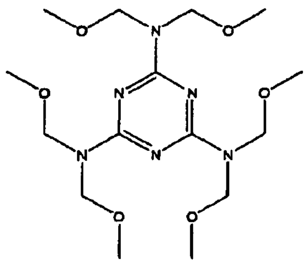

Mol. Wt.: 390.44

(FG-10)

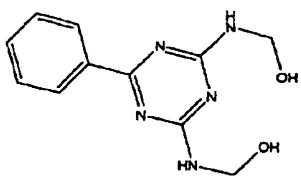

Mol. Wt.: 247.25

(FG-11)

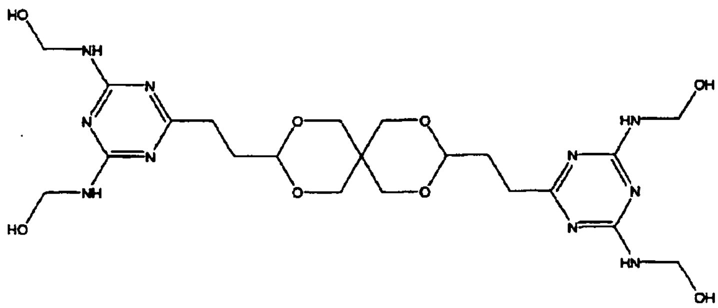

Mol. Wt.: 554.56

(FG-12)

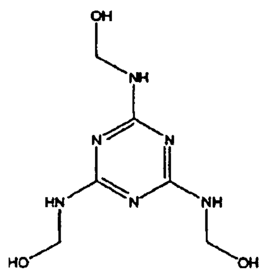

Mol. Wt.: 216.2

(FG-13)

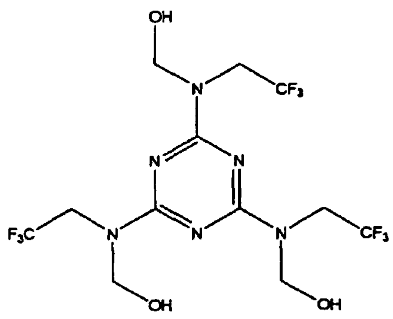

Mol. Wt.: 462.27

(FG-14)

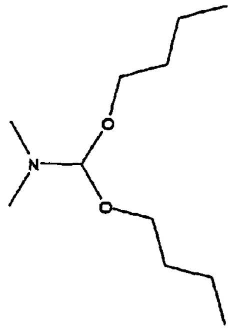

Mol. Wt.: 203.32

(FG-15)

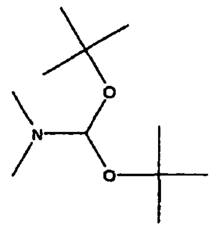

Mol. Wt.: 203.32

(FG-16)

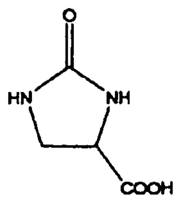

(FG-A)

Mol. Wt.: 130.1

FG-01 was synthesized by the method described in Chem. Ber., 112, 1979, 3950 and 3954.

FG-03 was synthesized by the method described in J. Heterocycl. Chem., EN, 8, 1971, 327-328.

FG-04 was synthesized by the method described in Chem. Abstr., 1948, 6335.

FG-05 was synthesized by the method described in Justus Liebigs Ann. Chem., 361, 1908, 149.

FG-06 was synthesized by the method described in Bull. Cl. Sci. Acad. R. Belg., 1902,721.

FG-08 was synthesized by the method described in Monatsh. Chem., 1955, 57, 66.

FG-11, 12 and 13 were synthesized by the method described in J. Am. Chem. Soc., 69, 1947, 599, 600.

FG-14 was synthesized by the method described in J. Med. Chem., EN, 36, 26, 1933, 4195-4200.

Commercially available products (commercially available products from Tokyo Chemical Industry Co., Ltd. and Sigma-Aldrich Corporation) were used for others.

[Additive]

(X-01) $C_3F_7SO_3H$

(Y-01)

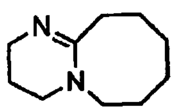

The prepared treating agent solution and positive tone resist solution were used for evaluation by the following methods.

<Evaluation Method>

<ArF Dry Exposure>

The pattern forming method including applying a freezing treatment is described below by referring to Fig. 1.

Fig. 1(a):

An organic antireflection film ARC29A (produced by Nissan Chemical Industries, Ltd.) was applied on a silicone wafer and baked at 205°C for 60 seconds to form a 78 nm-thick antireflection film 4. The prepared first positive tone resist composition was applied thereon and baked at 115°C for 60 seconds to form a 160 nm-thick first resist film 1.

Figs. 1(b) and (c):

The wafer having coated thereon a first resist film 1 was subjected to pattern exposure using an ArF excimer laser scanner (PAS 5500/1100, manufactured by ASML, NA: 0.75) through an exposure mask ml. The exposure dose was adjusted to give a desired line width. Thereafter, the wafer was heated at 115°C for 60 seconds and then subjected to development with an aqueous tetramethylammonium hydroxide solution (2.38 mass%) for 30 seconds, rinsing with pure water and spin drying to obtain a first resist pattern (1a and 1a') having a pitch of 180 nm and a line width of 90 nm.

Figs. 1(d) and (e):

Subsequently, the wafer was exposed by the ArF excimer laser scanner above with an exposure dose of 30 $mJ/cm^2$ through an exposure mask m2 so as to entirely expose the 1a' portion out of the first resist pattern. The resulting wafer was heated at 115°C for 60 seconds and then subjected to development with an aqueous tetramethylammonium hydroxide solution (2.38 mass%) for 30 seconds, rinsing with pure water and spin drying, whereby the resist film in the resist pattern 1a' portion was completely removed and only the first resist pattern 1a was allowed to remain on the wafer coated with the organic antireflection film.

Figs. 1(f) to (h):

Thereafter, the treating agent 3 was ejected from a nozzle n at a flow rate of 2 cc/sec for 60 seconds while spinning the wafer with the first resist pattern 1a at 500 rpm, and the wafer was then spun at 2,000 rpm for 60 seconds to completely shake off excess treating agent. Next, the reaction was allowed to proceed by baking the wafer at 130°C for 90 seconds, and the resulting wafer was cooled to room temperature and rinsed with 2-heptanol for 20 seconds to form a first pattern 1b subjected to a freezing treatment with the treating agent.

Fig. 1(j):

The prepared second positive tone resist composition was applied on the wafer where a first resist pattern 1b subjected to a freezing treatment is present, and the wafer was baked at 115°C for 60 seconds to form a 160 nm-thick second resist film 2. Out of the obtained wafer, the portion where the first resist pattern 1b is not present was subjected to pattern exposure using the ArF excimer laser scanner above through a mask m3 having a pitch of 180 nm and a line width of 90 nm. The exposure dose was adjusted to give the desired line width.

Figs. 1(k) and (l):

Subsequently, the portion where the first resist pattern 1b and the second resist film 2 are mixed was exposed by the ArF excimer laser scanner above with an exposure dose of 30 $mJ/cm^2$ through a mask m4 shading the portion composed of only the second resist film. After heating at 115°C for 60 seconds, the wafer was subjected to development with an aqueous tetramethylammonium hydroxide solution (2.38 mass%) for 30 seconds, rinsing with pure water and spin drying. As a result, the exposed portion of the resist film 2 exposed through the mask m3 and the second resist film 2 in the portion where the first resist pattern 1b is present were completely removed to form a second resist pattern 2a and furthermore, the first resist pattern 1b (1c) was bared. In this way, a pattern where a first resist pattern 1c and a second resist pattern 2a are aligned at a pitch of 180 nm with a line width of 90 nm was formed.

<ArF Immersion Exposure>

A pattern was formed in the same manner as in the "ArF dry exposure" above except that pure water was used as the immersion liquid, PAS5500/1250i (manufactured by ASML) equipped with a lens of NA 0.85 was used as the ArF excimer laser scanner, the pattern dimension for the first resist film and the second resist film was changed to a pitch of 130 nm and a line width of 65 nm, and the film thickness was changed to 120 nm.

The results obtained by the compositions and methods above are shown in Tables 4 and 5 below.

The terms in Tables 4 and 5 are described below by referring to Fig. 1.

The dimensional fluctuation ratio between before and after treatment is a ratio of the dimension (width) of the first resist pattern after surface treatment (in Fig. 1(h), the pattern 1b) to that of the first resist pattern (in Fig. 1(e), the pattern 1a) (1b/1a×100 (%)). No dimensional fluctuation of the resist pattern preferably occurs between before and after surface treatment and therefore, a ratio closer to 100% is preferred..

The finished dimension ratio is a ratio of the finished dimension (width) of the second resist pattern (2a) to that of the first resist pattern (1c) (2a/1c×100(%)). The first resist pattern and the second resist pattern are preferably equal in the dimension and therefore, a ratio closer to 100% is preferred.

The pattern height ratio is a ratio of the height of the second resist pattern (2a) to that of the first resist pattern (1c) (2a/1c×100 (%)). The first resist pattern and the second resist pattern are preferably equal in the height and therefore, a ratio closer to 100% is preferred.

The etching speed ratio is a ratio of the etching speed of the second resist pattern (2a) to that of the first resist pattern (1c) (2a/1c×100 (%)). The first resist pattern and the second resist pattern are preferably equal in the etching speed and therefore, a ratio closer to 100% is preferred.

The results of evaluation by the dry exposure system are shown in Table 4 and the results of evaluation by the immersion exposure system are shown in Table 5. Incidentally, in Tables 4 and 5, * indicates that the pattern 1a completely disappeared after the treatment with the treating agent.

Table 4

| | | First Resist | Second Resist | Treating Agent | Dimensional Fluctuation Ratio Between Before and After Treatment | Finished Dimension Ratio | Pattern Height Ratio | Etching Speed Ratio |
|---|---|---|---|---|---|---|---|---|
| | | | | | 1b/1a×100 (%) | 2a/1c×100 (%) | 2a/1c×100 (%) | 2a/1c×100 (%) |
| Example | 1 | Ar-01 | Ar-01 | F-13 | 100 | 99 | 99 | 100 |
| Example | 2 | Ar-02 | Ar-02 | F-13 | 100 | 100 | 100 | 99 |
| Example | 3 | Ar-03 | Ar-03 | F-13 | 101 | 99 | 99 | 99 |
| Example | 4 | Ar-04 | Ar-04 | F-13 | 101 | 100 | 100 | 98 |
| Example | 5 | Ar-05 | Ar-05 | F-13 | 100 | 100 | 99 | 99 |
| Example | 6 | Ar-01 | Ar-01 | F-01 | 100 | 96 | 95 | 95 |
| Example | 7 | Ar-01 | Ar-01 | F-02 | 100 | 97 | 96 | 97 |
| Example | 8 | Ar-01 | Ar-01 | F-03 | 101 | 97 | 98 | 98 |
| Example | 9 | Ar-01 | Ar-01 | F-04 | 101 | 98 | 98 | 98 |
| Example | 10 | Ar-01 | Ar-01 | F-05 | 102 | 99 | 99 | 98 |
| Example | 11 | Ar-01 | Ar-01 | F-06 | 100 | 98 | 98 | 97 |
| Example | 12 | Ar-01 | Ar-01 | F-07 | 101 | 97 | 98 | 97 |
| Example | 13 | Ar-01 | Ar-01 | F-08 | 100 | 98 | 99 | 98 |
| Example | 14 | Ar-01 | Ar-01 | F-09 | 102 | 101 | 101 | 102 |

(continued)

| | | First Resist | Second Resist | Treating Agent | Dimensional Fluctuation Ratio Between Before and After Treatment | Finished Dimension Ratio | Pattern Height Ratio | Etching Speed Ratio |
|---|---|---|---|---|---|---|---|---|
| | | | | | 1b/1a×100 (%) | 2a/ 1c×100 (%) | 2a/ 1c×100 (%) | 2a/ 1c×100 (%) |
| Example | 15 | Ar-01 | Ar-01 | F-10 | 102 | 102 | 101 | 101 |
| Example | 16 | Ar-01 | Ar-01 | F-11 | 102 | 101 | 101 | 101 |
| Example | 17 | Ar-01 | Ar-01 | F-12 | 103 | 103 | 103 | 104 |
| Example | 18 | Ar-01 | Ar-01 | F-14 | 102 | 101 | 102 | 102 |
| Example | 19 | Ar-01 | Ar-01 | F-15 | 101 | 97 | 97 | 97 |
| Example | 20 | Ar-01 | Ar-01 | F-16 | 101 | 95 | 95 | 96 |
| Example | 21 | Ar-01 | Ar-01 | F-17 | 100 | 99 | 99 | 100 |
| Example | 22 | Ar-01 | Ar-01 | F-18 | 100 | 100 | 100 | 100 |
| Example | 23 | Ar-06 | Ar-06 | F-05 | 101 | 99 | 100 | 100 |
| Example | 24 | Ar-06 | Ar-06 | F-09 | 101 | 99 | 100 | 99 |
| Example | 25 | Ar-06 | Ar-06 | F-17 | 101 | 100 | 100 | 100 |
| | | | | | | | | |
| Comparative Example | 1 | Ar-01 | Ar-01 | none | 0* | - | - | - |
| Comparative Example | 2 | Ar-01 | Ar-01 | F-A | 113 | 89 | 90 | 93 |

Table 5

| | | First Resist | Second Resist | Treating Agent | Dimensional Fluctuation Ratio Between Before and After Treatment | Finished Dimension Ratio | Pattern Height Ratio | Etching Speed Ratio |
|---|---|---|---|---|---|---|---|---|
| | | | | | 1b/1a×100 (%) | 2a/ 1c×100 (%) | 2a/ 1c×100 (%) | 2a/ 1c×100 (%) |
| Example | 1 | Ar-01 | Ar-01 | F-13 | 100 | 100 | 99 | 100 |
| Example | 2 | Ar-02 | Ar-02 | F-13 | 100 | 99 | 100 | 100 |
| Example | 3 | Ar-03 | Ar-03 | F-13 | 101 | 99 | 100 | 99 |
| Example | 4 | Ar-04 | Ar-04 | F-13 | 100 | 100 | 100 | 98 |
| Example | 5 | Ar-05 | Ar-05 | F-13 | 100 | 99 | 99 | 99 |
| Example | 6 | Ar-01 | Ar-01 | F-01 | 100 | 96 | 95 | 95 |

(continued)

| | | First Resist | Second Resist | Treating Agent | Dimensional Fluctuation Ratio Between Before and After Treatment | Finished Dimension Ratio | Pattern Height Ratio | Etching Speed Ratio |
|---|---|---|---|---|---|---|---|---|
| | | | | | 1b/1a×100 (%) | 2a/ 1c×100 (%) | 2a/ 1c×100 (%) | 2a/ 1c×100 (%) |
| Example | 7 | Ar-01 | Ar-01 | F-02 | 100 | 97 | 97 | 97 |
| Example | 8 | Ar-01 | Ar-01 | F-03 | 100 | 97 | 98 | 98 |
| Example | 9 | Ar-01 | Ar-01 | F-04 | 101 | 98 | 98 | 98 |
| Example | 10 | Ar-01 | Ar-01 | F-05 | 102 | 99 | 99 | 98 |
| Example | 11 | Ar-01 | Ar-01 | F-06 | 101 | 98 | 97 | 97 |
| Example | 12 | Ar-01 | Ar-01 | F-07 | 101 | 97 | 98 | 97 |
| Example | 13 | Ar-01 | Ar-01 | F-08 | 100 | 98 | 98 | 98 |
| Example | 14 | Ar-01 | Ar-01 | F-09 | 102 | 101 | 101 | 102 |
| Example | 15 | Ar-01 | Ar-01 | F-10 | 102 | 102 | 101 | 101 |
| Example | 16 | Ar-01 | Ar-01 | F-11 | 102 | 101 | 100 | 101 |
| Example | 17 | Ar-01 | Ar-01 | F-12 | 104 | 103 | 103 | 104 |
| Example | 18 | Ar-01 | Ar-01 | F-14 | 102 | 101 | 102 | 102 |
| Example | 19 | Ar-01 | Ar-01 | F-15 | 101 | 97 | 98 | 97 |
| Example | 20 | Ar-01 | Ar-01 | F-16 | 100 | 96 | 95 | 96 |
| Example | 21 | Ar-01 | Ar-01 | F-17 | 100 | 99 | 99 | 100 |
| Example | 22 | Ar-01 | Ar-01 | F-18 | 100 | 100 | 99 | 100 |
| Example | 23 | Ar-06 | Ar-06 | F-05 | 100 | 100 | 100 | 100 |
| Example | 24 | Ar-06 | Ar-06 | F-09 | 100 | 100 | 100 | 101 |
| Example | 25 | Ar-06 | Ar-06 | F-17 | 100 | 100 | 100 | 100 |
| | | | | | | | | |
| Comparative Example | 1 | Ar-01 | Ar-01 | none | 0* | - | - | - |
| Comparative Example | 2 | Ar-01 | Ar-01 | F-A | 113 | 89 | 90 | 93 |

(Measurement of Pattern Dimension)

The dimension of the resist pattern formed by the method above was measured by a critical dimension scanning electron microscope (SEM, S-9380II, manufactured by Hitachi Ltd.).

(Measurement of Pattern Height)

The height of the resist pattern formed by the method above was measured by SEM (S-4800, manufactured by Hitachi Ltd.).

(Evaluation of Dry Etching Resistance)

Each resist composition prepared in the same manner as above was applied by a spin coater on a silicon wafer subjected to a hexamethyldisilazane treatment and baked at 115°C for 60 seconds to form a 200 nm-thick resist film. This resist film was subjected to an etching treatment by a parallel plate-type reactive ion etching apparatus (manufactured by ULVAC, Inc.) using oxygen as the etching gas under the conditions of a pressure of 20 milli-Torr and an application power of 100 $mW/cm^3$. The etching speed of the resist film was determined from the change in the film thickness. The etching speed of the resist film in the case of performing a freezing treatment with the treating agent and the etching speed of the resist film in the case of not performing the treatment were calculated, and the etching speed ratio (etching speed after treatment to that before treatment) was eventually calculated.

As seen from the results in Tables 4 and 5, in the characteristic evaluation by ArF dry exposure and ArF immersion exposure, when the treating agent for pattern formation of the present invention is used, as compared with Comparative Examples not using the treating agent:

(i) the first resist pattern does not dissolve in the second resist solution;
(ii) the dimensional fluctuation of the first resist pattern is greatly suppressed, as a result, the first resist pattern and the second resist pattern can be formed in the same dimension; and
(iii) the first resist coating film and the second resist coating film have the same dry etching resistance.

As revealed above, the treating agent for pattern formation of the present invention acts on a resist pattern so as to satisfy all of the characteristics required in a freezing process. Thus, it is apparent that the treating agent for pattern formation of the present invention exhibits an excellent pattern-forming property in a freezing process.

INDUSTRIAL APPLICABILITY

According to the invention, in a freezing process of chemically treating and thereby qualitatively changing the first resist pattern so as not to dissolve in a second resist solution in order to form a second resist film on the first resist pattern and form a second resist pattern after the first resist pattern is formed on a first resist film, all of the requirements that (i) the first resist pattern does not dissolve in the second resist solution, (ii) the dimension of the first resist pattern is not changed, and (iii) the first resist pattern and the second resist pattern have the same dry etching resistance, are satisfied and pattern formation by a freezing process can be effectively performed.

While the invention has been described in detail and with reference to specific embodiments thereof, it will be apparent to one skilled in the art that various changes and modifications can be made therein without departing from the spirit and scope thereof. This application is based on Japanese Patent Application (Patent Application No. 2007-158839) filed on June 15, 2007, the contents of which are incorporated herein by way of reference.

**Claims**

1. A surface-treating agent for resist pattern formation, which is used in a step before a second resist film is formed on a first resist pattern and a second resist pattern is formed and after the first resist pattern is formed on a first resist film, the surface-treating agent comprising a compound having at least one -O-C-N- bond.

2. The surface-treating agent for resist pattern formation according to claim 1, wherein the compound having at least one -O-C-N- bond is a compound represented by the following formula (1):

Formula (1):

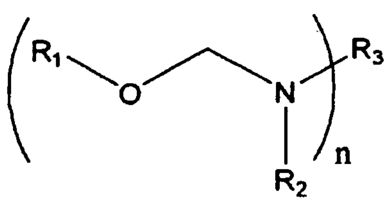

wherein $R_1$ represents a hydrogen atom or a monovalent organic group;

$R_2$ represents a hydrogen atom or a monovalent organic group;
$R_3$ represents a hydrogen atom, a single bond or an n-valent organic group, provided that $R_2$ and $R_3$ may combine with each other to form a ring; and
n represents an integer of 1 to 8, provided that when $R_3$ is a hydrogen atom, n is 1 and when $R_3$ is a single bond, n is 2.

**3.** The surface-treating agent for resist pattern formation according to claim 2, wherein the compound represented by formula (1) is a compound where n is an integer of 2 to 8.

**4.** The surface-treating agent for resist pattern formation according to any one of claims 1 to 3, which comprises:

a saturated hydrocarbon compound having a carbon number of 10 or more, a hydrocarbon compound containing at least one hydroxy group and having a carbon number of 6 or more, or an organic compound containing at least one fluorine atom and having a carbon number of 6 or more as a solvent.

**5.** A method for forming a resist pattern, comprising:

a step of forming a first resist pattern by using a first resist composition;
a step of treating the resist pattern with the treating agent claimed in any one of claims 1 to 4; and
a step of forming a second resist pattern on the first resist pattern by using a second resist composition.

FIG. 1 (a)

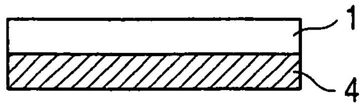


FIG. 1 (b)

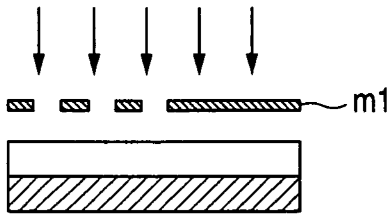


FIG. 1 (c)

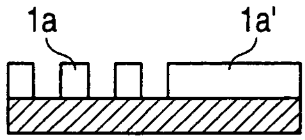


FIG. 1 (d)

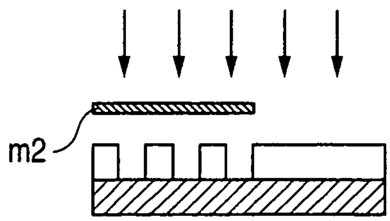


FIG. 1 (e)

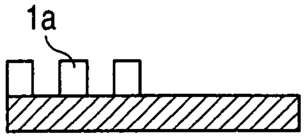


FIG. 1 ( f )

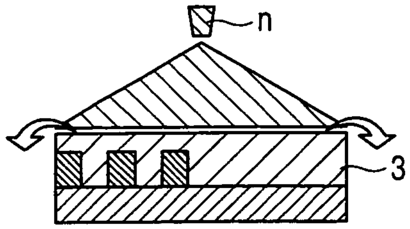

FIG. 1 (g)

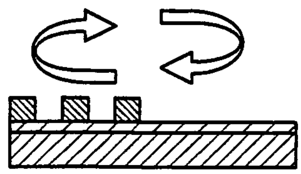

FIG. 1 (h)

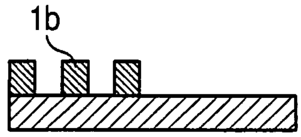


FIG. 1 ( i )

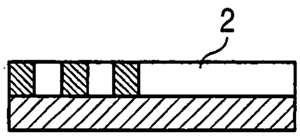


FIG. 1 ( j )

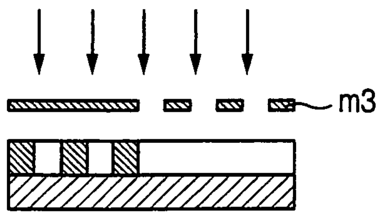


FIG. 1 (k)

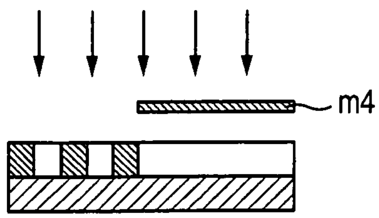


FIG. 1 ( l )

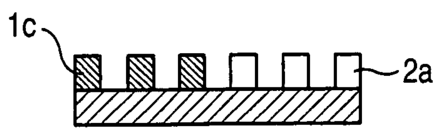

**INTERNATIONAL SEARCH REPORT**

International application No.
PCT/JP2008/060908

A. CLASSIFICATION OF SUBJECT MATTER
*G03F7/40*(2006.01)i, *G03F7/26*(2006.01)i, *H01L21/027*(2006.01)i

According to International Patent Classification (IPC) or to both national classification and IPC

B. FIELDS SEARCHED

Minimum documentation searched (classification system followed by classification symbols)
G03F7/40, G03F7/26, H01L21/027

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | WO 2005/116776 A1 (JSR Corp.),<br>08 December, 2005 (08.12.05),<br>Claims 1 to 8; Par. Nos. [0026] to [0027], [0032], [0046], [0049]<br>& US 2007/0259287 A & EP 1757990 A1 | 1-4<br>5 |
| X<br>Y | JP 2006-307179 A (JSR Corp.),<br>09 November, 2006 (09.11.06),<br>Par. Nos. [0022], [0023], [0027], [0043], [0046]<br>(Family: none) | 1-4<br>5 |
| X<br>Y | JP 2005-181379 A (Matsushita Electric Industrial Co., Ltd.),<br>07 July, 2005 (07.07.05),<br>Claims 1, 15; Par. No. [0019]<br>& US 2005/0130067 A1 | 1-3<br>5 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 21 August, 2008 (21.08.08) | 02 September, 2008 (02.09.08) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.
PCT/JP2008/060908

C (Continuation). DOCUMENTS CONSIDERED TO BE RELEVANT

| Category* | Citation of document, with indication, where appropriate, of the relevant passages | Relevant to claim No. |
|---|---|---|
| X<br>Y | WO 2006/022246 A1 (Renesas Technology Corp.), 02 March, 2006 (02.03.06), Claims 1, 2; Par. Nos. [0021], [0033] & JP 2006-64851 A & US 2008/0044759 A & EP 1791028 A1 | 1-3<br>5 |
| X<br>Y | JP 2000-89477 A (NEC Corp.), 31 March, 2000 (31.03.00), Claims 1, 4; Par. Nos. [0001], [0024] (Family: none) | 1-3<br>5 |
| X<br>Y | JP 2006-208721 A (Nippon Telegraph And Telephone Corp.), 10 August, 2006 (10.08.06), Claims 1, 3, 6; Par. Nos. [0006], [0071] to [0088] & WO 2006/080428 A1 | 1-3<br>5 |
| Y | JP 2005-197349 A (Semiconductor Leading Edge Technologies, Inc.), 21 July, 2005 (21.07.05), Claim 1; Par. No. [0040] (Family: none) | 5 |
| P,X | WO 2008/038526 A1 (Tokyo Ohka Kogyo Co., Ltd.), 03 April, 2008 (03.04.08), Claims 1, 5; Par. Nos. [0219], [0220], [0223], [0273], [0278] & JP 2008-83537 A | 1-3,5 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2005197349 A
- JP 62036663 A
- JP 61226746 A
- JP 61226745 A
- JP 62170950 A
- JP 63034540 A
- JP 7230165 A
- JP 8062834 A
- JP 9054432 A
- JP 9005988 A
- US 5405720 A
- US 5360692 A
- US 5529881 A
- US 5296330 A
- US 5436098 A
- US 5576143 A
- US 5294511 A
- US 5824451 A
- JP 2002090991 A
- US 3849137 A
- DE 3914407
- JP 63026653 A
- JP 55164824 A
- JP 62069263 A
- JP 63146038 A
- JP 63163452 A
- JP 62153853 A
- JP 63146029 A
- US 3779778 A
- EP 126712 A
- JP 2002277862 A
- JP 2007158839 A


### Non-patent literature cited in the description


- *J. Vac. Sci. Technol. B,* 1986, vol. 4, 426
- *Chem. Ber.,* 1979, vol. 112, 3950, 3954
- *J. Heterocycl. Chem.,* 1971, vol. 8, 327-328
- *Chem. Abstr.,* 1948, 6335
- *Justus Liebigs Ann. Chem.,* 1908, vol. 361, 149
- *Bull. Cl. Sci. Acad. R. Belg.,* 1902, 721
- *Monatsh. Chem.,* 1955, vol. 57, 66
- *J. Am. Chem. Soc.,* 1947, vol. 69, 599, 600
- *J. Med. Chem.,* 1933, vol. 36 (26), 4195-4200